(19) Europäisches Patentamt
European Patent Office
Office européen des brevets

(11) **EP 4 206 821 A1**

(12) **EUROPEAN PATENT APPLICATION**
published in accordance with Art. 153(4) EPC

(43) Date of publication:
**05.07.2023 Bulletin 2023/27**

(21) Application number: **21861000.4**

(22) Date of filing: **09.07.2021**

(51) International Patent Classification (IPC):
**G03F 7/00** (2006.01)     **G03F 7/30** (2006.01)

(52) Cooperative Patent Classification (CPC):
**G03F 7/00; G03F 7/30**

(86) International application number:
**PCT/JP2021/026000**

(87) International publication number:
**WO 2022/044570 (03.03.2022 Gazette 2022/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.08.2020   JP 2020144586**

(71) Applicant: **FUJIFILM Corporation
Tokyo 106-8620 (JP)**

(72) Inventor: **SHIRAKAWA, Masato
Haibara-gun, Shizuoka 421-0396 (JP)**

(74) Representative: **HGF
HGF Limited
1 City Walk
Leeds LS11 9DX (GB)**

(54) **DEVELOPER MANAGEMENT METHOD, PLATEMAKING METHOD, DEVELOPER MANAGEMENT DEVICE, AND PLATEMAKING DEVICE**

(57)     There are provided a developer management method, a developer management device, a plate-making method, and a plate-making apparatus that can prevent development residues from being adhered, can perform appropriate development, and decrease the replacement frequency of a developer. A plate-making method has a developing step of removing and developing a non-exposed portion of an imagewise exposed flexographic printing plate precursor using a developer, a step of measuring a conductivity of the developer used in removing the non-exposed portion of the imagewise exposed flexographic printing plate precursor, and a replenishing step of replenishing at least one liquid of a development replenishing liquid or water to the developer based on the conductivity measured in the measuring step such that the conductivity becomes a conductivity in a determined range.

FIG. 1

**Description**

**BACKGROUND OF THE INVENTION**

1. Field of the Invention

The present invention relates to a developer management method, a developer management device, a plate-making method, and a plate-making apparatus that are used in developing an imag1ewise exposed flexographic printing plate precursor and relates particularly to a developer management method, a developer management device, a plate-making method, and a plate-making apparatus that control the sensitizer concentration of a developer.

2. Description of the Related Art

Various methods are known as developing methods for a printing plate formed of a photosensitive resin plate. For example, in a developing method of performing development using an aqueous developer of which a main component is water, development is performed by applying the aqueous developer to an imagewise exposed photosensitive resin plate with a brush or the like and washing out an uncured resin or the like, which is a non-exposed portion. Rinsing treatment is performed in order to remove the developer on the plate after development, the uncured resin adhered to the plate, or the like. The rinsing treatment is a step of washing away the developer, the uncured resin, and the like on the developed plate using washing water that does not contain solid contents or surfactants, such as tap water, as a rinsing liquid.

Regarding development, for example, a method of using a developer for a flexographic printing member is described in JP2019-537063A. In JP2019-537063A, a flexographic printing development aqueous solution is replenished with a replenishing developer composition having a high concentration. In addition, keeping the pH (hydrogen ion index) of the flexographic printing development aqueous solution within ±0.5 of pH at the start of use is described.

**SUMMARY OF THE INVENTION**

Herein, in development of the flexographic printing plate precursor using the aqueous developer described above, an unhardened portion, which is a non-exposed portion, is removed by a brush. In a case where the concentration of the developer changes during development, the development speed changes, and development cannot be performed at an appropriate development speed.

In addition, in a case where the concentration of sensitizers generated by removing the non-exposed portion during development, the removed unhardened portion adheres to the plate surface of a development-treated flexographic printing plate as development residues in some cases in a rinsing step after a developing step, and a good printing plate cannot be obtained in some cases. For this reason, in a case where the sensitizer concentration reaches a determined concentration, it is necessary to replace the developer. There is, for example, a method of replenishing a developer which has not been used in development according to a developed treatment area of the flexographic printing plate precursor in order to perform control such that the sensitizer concentration does not become high, but a development treatment amount, a developer evaporation amount, or the like differs, and it is difficult to control the sensitizer concentration.

In JP2019-537063A described above, replenishing the replenishing developer composition having a high concentration and keeping the pH of the flexographic printing development aqueous solution within ±0.5 of pH at the start of use are performed, but the concentration of the developer is not sufficiently maintained, and appropriate development cannot be performed.

An object of the present invention is to provide a developer management method, a developer management device, a plate-making method, and a plate-making apparatus that can prevent development residues from being adhered, can perform appropriate development, and decrease the replacement frequency of a developer.

In order to achieve the object described above, according to an aspect of the present invention, there is provided a developer management method including a measuring step of measuring a conductivity of a developer used in removing a non-exposed portion of an imagewise exposed flexographic printing plate precursor and a replenishing step of replenishing at least one liquid of a development replenishing liquid or water to the developer based on the conductivity measured in the measuring step such that the conductivity becomes a conductivity in a determined range.

It is preferable to include a calculating step of calculating a replenishment amount of the at least one liquid to be replenished to the developer in the replenishing step.

It is preferable that the development replenishing liquid is a new developer solution, a developer concentrated stock solution, or a regenerated developer.

It is preferable that the developer and the development replenishing liquid contain an alkaline agent.

An object of the present invention is to provide a plate-making method including a developing step of removing and developing a non-exposed portion of an imagewise exposed flexographic printing plate precursor using a developer, a step of measuring a conductivity of the developer used in removing the non-exposed portion of the imagewise exposed flexographic printing plate precursor, and a replenishing step of replenishing at least one liquid of a development replenishing liquid or water to the developer based on the conductivity measured in the measuring step such that the conductivity becomes a conductivity in a determined range.

It is preferable to include a calculating step of calculating a replenishment amount of the at least one liquid to be replenished to the developer in the replenishing step.

It is preferable that the development replenishing liquid is a new developer solution, a developer concentrated stock solution, or a regenerated developer.

It is preferable that the developer and the development replenishing liquid contain an alkaline agent.

An object of the present invention is to provide a developer management device including a measuring unit that measures a conductivity of a developer used in removing a non-exposed portion of an imagewise exposed flexographic printing plate precursor, a calculation unit that calculates, from the conductivity of the developer measured by the measuring unit, a replenishment amount of at least one liquid of a development replenishing liquid or water such that the conductivity of the developer becomes a conductivity in a determined range, and a supply unit that supplies at least one liquid of the development replenishing liquid or the water to the developer such that the conductivity of the developer becomes a conductivity in the determined range.

It is preferable that the supply unit has at least one of a development replenishing liquid storage tank that stores the development replenishing liquid or a water storage tank that stores the water. It is preferable that the supply unit supplies the liquid from at least one of the development replenishing liquid storage tank or the water storage tank to the developer.

It is preferable that the development replenishing liquid is a new developer solution, a developer concentrated stock solution, or a regenerated developer.

It is preferable that the developer and the development replenishing liquid contain an alkaline agent.

An object of the present invention is to provide a plate-making apparatus that develops an imagewise exposed flexographic printing plate precursor using a developer, the plate-making apparatus including a developing portion that removes and develops a non-exposed portion of the imagewise exposed flexographic printing plate precursor using the developer, a measuring unit that measures a conductivity of the developer used in removing the non-exposed portion of the imagewise exposed flexographic printing plate precursor, a calculation unit that calculates, from the conductivity of the developer measured by the measuring unit, a replenishment amount of at least one liquid of a development replenishing liquid or water such that the conductivity of the developer becomes a conductivity in a determined range, and a supply unit that supplies at least one liquid of the development replenishing liquid or the water such that the conductivity of the developer becomes a conductivity in the determined range.

It is preferable that the supply unit has at least one of a development replenishing liquid storage tank that stores the development replenishing liquid or a water storage tank that stores the water. It is preferable that the supply unit supplies the liquid from at least one of the development replenishing liquid storage tank or the water storage tank to the developer.

It is preferable that the development replenishing liquid is a new developer solution, a developer concentrated stock solution, or a regenerated developer.

It is preferable that the developer and the development replenishing liquid contain an alkaline agent.

With the present invention, development residues can be prevented from being adhered, appropriate development can be performed, and the replacement frequency of the developer can be decreased.

## BRIEF DESCRIPTION OF THE DRAWINGS

Fig. 1 is a schematic view showing an example of a plate-making apparatus having a developer management device according to an embodiment of the present invention.
Fig. 2 is a graph showing a relationship between a conductivity of a developer and a concentration of the developer used in a developer management method according to the embodiment of the present invention.
Fig. 3 is a flowchart showing an example of the developer management method according to the embodiment of the present invention.
Fig. 4 is a schematic cross-sectional view showing a state after exposure of a flexographic printing plate precursor used in a plate-making method according to the embodiment of the present invention.
Fig. 5 is a schematic cross-sectional view showing an example after development of the flexographic printing plate precursor used in the plate-making method according to the embodiment of the present invention.

Fig. 6 is a schematic cross-sectional view showing an example after development in a case where a development speed of the flexographic printing plate precursor is slow used in the plate-making method according to the embodiment of the present invention.

Fig. 7 is a schematic cross-sectional view showing an example after development in a case where the development speed of the flexographic printing plate precursor is fast used in the plate-making method according to the embodiment of the present invention.

Fig. 8 is a schematic view showing a first example of the plate-making apparatus having the developer management device according to the embodiment of the present invention.

Fig. 9 is a schematic view showing a usage form of the first example of the plate-making apparatus having the developer management device according to the embodiment of the present invention.

Fig. 10 is a schematic view showing a rinsing step of the first example of the plate-making apparatus having the developer management device according to the embodiment of the present invention.

Fig. 11 is a schematic view showing a second example of the plate-making apparatus having the developer management device according to the embodiment of the present invention.

Fig. 12 is a schematic perspective view showing an example of a heater used in the second example of the plate-making apparatus having the developer management device according to the embodiment of the present invention.

Fig. 13 is a schematic side view showing a third example of the plate-making apparatus according to the embodiment of the present invention.

Fig. 14 is a schematic perspective view showing main portions of the third example of the plate-making apparatus according to the embodiment of the present invention.

Fig. 15 is a schematic plan view showing the main portions of the third example of the plate-making apparatus according to the embodiment of the present invention.

Fig. 16 is a schematic plan view showing a transporting form of the flexographic printing plate precursor according to the embodiment of the present invention.

Fig. 17 is a schematic view showing an example of a leading end leader used in transporting the flexographic printing plate precursor according to the embodiment of the present invention.

Fig. 18 is a schematic view showing an example of a trailing end of a leader mechanism portion used in transporting the flexographic printing plate precursor according to the embodiment of the present invention.

Fig. 19 is a schematic plan view showing another example of the transporting form of the flexographic printing plate precursor according to the embodiment of the present invention.

Fig. 20 is a schematic view showing an example of attachment of the flexographic printing plate precursor by a detachment and attachment unit of the third example of the plate-making apparatus according to the embodiment of the present invention.

Fig. 21 is a schematic view showing an example of removal of the flexographic printing plate precursor by the detachment and attachment unit of the third example of the plate-making apparatus according to the embodiment of the present invention.

Fig. 22 is a schematic view showing another example of removal of the flexographic printing plate precursor by the detachment and attachment unit of the third example of the plate-making apparatus according to the embodiment of the present invention.

Fig. 23 is a schematic view showing still another example of removal of the flexographic printing plate precursor by the detachment and attachment unit of the third example of the plate-making apparatus according to the embodiment of the present invention.

Fig. 24 is a schematic view showing an example of a back plate portion of the plate-making apparatus according to the embodiment of the present invention.

Fig. 25 is a schematic plan view showing an example of a developing portion of the plate-making apparatus according to the embodiment of the present invention.

Fig. 26 is a schematic side view showing an example of the developing portion of the plate-making apparatus according to the embodiment of the present invention.

Fig. 27 is a schematic side view showing a fourth example of the plate-making apparatus according to the embodiment of the present invention.

Fig. 28 is a schematic view showing a first example of a rinsing unit of the third example of the plate-making apparatus according to the embodiment of the present invention.

Fig. 29 is a schematic view showing a second example of the rinsing unit of the third example of the plate-making apparatus according to the embodiment of the present invention.

Fig. 30 is a schematic view showing a third example of the rinsing unit of the third example of the plate-making apparatus according to the embodiment of the present invention.

**DESCRIPTION OF THE PREFERRED EMBODIMENTS**

Hereinafter, a developer management method, a plate-making method, a developer management device, and a plate-making apparatus according to an embodiment of the present invention will be described in detail based on suitable embodiments shown in accompanying drawings.

The drawings to be described below are exemplary for describing the present invention, and the present invention is not limited to the drawings shown below.

In the following, "to" indicating a numerical range includes numerical values described on both sides. For example, in a case where $\varepsilon$ is a numerical value $\alpha$ to a numerical value $\beta$, the range of $\varepsilon$ is a range including the numerical value $\alpha$ and the numerical value $\beta$ and is $\alpha \leq \varepsilon \leq \beta$ in mathematical symbols.

Angles such as "perpendicular" and "parallel" include a range of errors generally acceptable in the corresponding technical field unless particularly stated otherwise.

(Schematic Configuration of Plate-Making Apparatus)

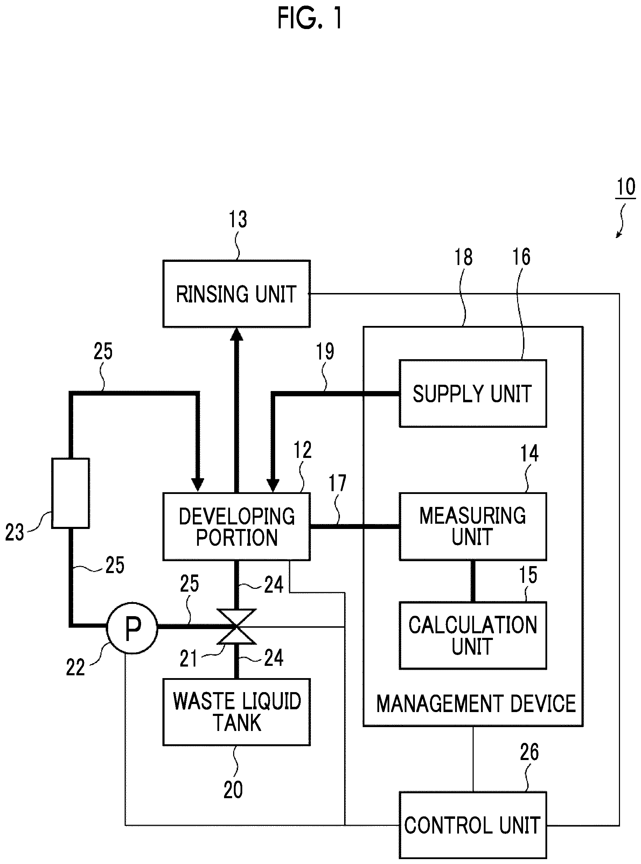

Fig. 1 is a schematic view showing an example of the plate-making apparatus having the developer management device according to the embodiment of the present invention.

A plate-making apparatus 10 shown in Fig. 1 has a developer management device 18. The plate-making apparatus 10 has a developing portion 12, a rinsing unit 13, a measuring unit 14, a calculation unit 15, a supply unit 16, a waste liquid tank 20, a switching valve 21, a pump 22, a filter 23, and a control unit 26.

An operation or the like of each configuration unit of the plate-making apparatus 10 is controlled by the control unit 26. In the plate-making apparatus 10, the management device 18 is composed of the measuring unit 14, the calculation unit 15, and the supply unit 16. The plate-making apparatus 10 may be configured to have an exposure device (not shown) that exposes a flexographic printing plate precursor.

The measuring unit 14 that measures the conductivity of a developer of the developing portion 12 is connected to the developing portion 12 via a connecting pipe 17. The calculation unit 15 is connected to the measuring unit 14.

The measuring unit 14 measures the conductivity of the developer. The measuring unit 14 acquires the developer from the developing portion 12 through the connecting pipe 17 and measures the conductivity. The measuring unit 14 may be provided in the developing portion 12.

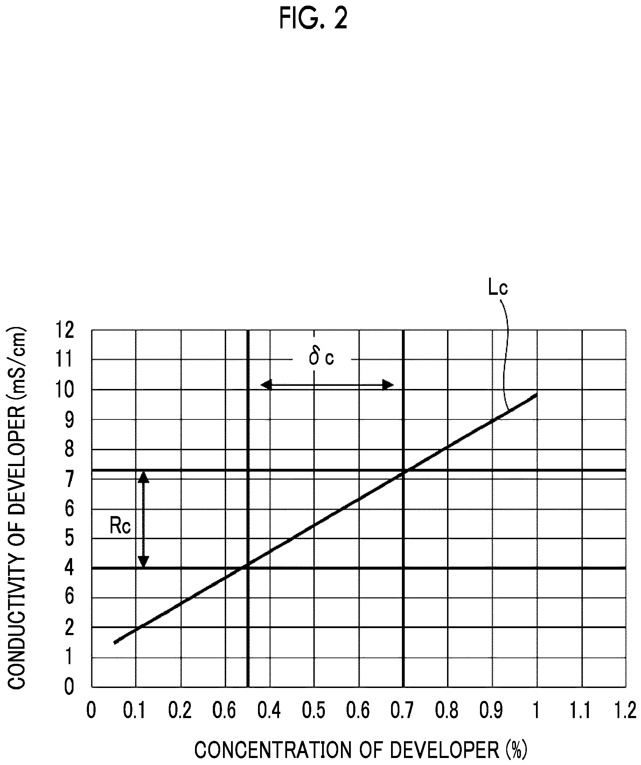

As shown in Fig. 2, there is a correlation between the conductivity of the developer and the concentration of the developer, and the concentration of the developer can be estimated from the conductivity of the developer. The concentration of the developer is the concentration of a component derived from a new developer solution. The component derived from the new developer solution includes an alkaline agent, a surfactant, and a chelating agent.

The measurement of the conductivity of the developer is not particularly limited insofar as the conductivity can be measured. For example, an electrical conductivity meter, a water quality meter, and the like can be used. Using this, the concentration of the developer is estimated from the conductivity of the developer, and the conductivity of the developer is used in controlling the concentration of the developer.

A sensitizer concentration is the concentration of sensitizer components dispersed in the developer. On the other hand, the concentration of solid contents is a total concentration of the concentration of sensitizer components dispersed in the developer (= sensitizer concentration) and the concentration of components derived from the new developer solution. The sensitizer concentration and the concentration of solid contents are different from each other by the amount of the concentration of components derived from the new developer solution.

The calculation unit 15 calculates, from the conductivity of the developer measured by the measuring unit 14, the replenishment amount of at least one liquid of a development replenishing liquid or water such that the conductivity of the developer becomes a conductivity in a determined range. For example, as shown in Fig. 2, when the conductivity of the developer and the concentration of the developer are in a relationship of a straight line Lc, in a case where the concentration of the developer is controlled such that the concentration is in a management concentration range $\delta$c, it is necessary to control the conductivity of the developer such that the conductivity is in a determined range Rc. The range Rc described above is also referred to as a control range.

In a case where the measured conductivity of the developer is within the range Rc, the calculation unit 15 determines that replenishment is unnecessary, and for example, the replenishment amount is 0. Also in a case where the conductivity of the developer is within the range Rc, for example, in a case where the amount of the developer is small, the developer may be replenished.

On the other hand, in a case where the measured conductivity of the developer is lower than the range Rc, the concentration of the developer is lower than the management concentration range $\delta$c. In this case, since the concentration of the developer is low, for example, the development replenishing liquid is replenished, and the concentration of the developer is increased to become a conductivity in the determined the range Rc. Thus, the calculation unit 15 calculates the amount of the development replenishing liquid and makes the amount of the development replenishing liquid a replenishment amount.

In addition, in a case where the measured conductivity of the developer is higher than the range Rc, the concentration of the developer is higher than the management concentration range δc. In this case, since the concentration of the developer is high, for example, water is replenished, and the concentration of the developer is decreased to become a conductivity in the determined range Rc. Thus, the calculation unit 15 calculates the amount of the water and makes the amount of the water a replenishment amount.

A liquid supplied to the developer is not limited to the water, and the calculation unit 15 may calculate the concentration of the development replenishing liquid and the amount of the development replenishing liquid and make the amount of the development replenishing liquid a replenishment amount. The concentration of the development replenishing liquid can be adjusted by adding the water to the development replenishing liquid. In this case, the amount of the development replenishing liquid and the amount of the water are calculated. For this reason, in a case of decreasing the concentration of the developer, replenishing the water is easier, which is preferable.

Further, in the adjustment of the concentration of the development replenishing liquid, for example, a relationship between the prepared concentration of the development replenishing liquid and the amount of the water is acquired in advance, and the amount of the prepared development replenishing liquid and the amount of the water are determined as appropriate according to the concentration of the necessary development replenishing liquid.

The value of the conductivity can be calculated beforehand by producing liquids having different concentrations of developers and different sensitizer concentrations, measuring a conductivity for each liquid, and performing multiple regression analysis on obtained results. For example, the concentration of the developer can be expressed by the following equation.

$$\text{Concentration of developer (\%)} = 0.1128 \times \text{conductivity} - 0.1132$$

As described above, in a case of controlling the conductivity of the developer such that the conductivity is in the determined range Rc, for example, a conductivity control target value is set within the range Rc. Th control target value is, for example, a center value of the range Rc. In any one of a case where the conductivity falls short of a lower limit value of the range Rc or a case where the conductivity exceeds an upper limit value, the development replenishing liquid or the water is added such that the conductivity becomes a control target value.

A difference in the value of the conductivity after control with respect to the conductivity control target value is ideally zero, is preferably within 20%, and is more preferably within 10%.

As shown in Fig. 1, the supply unit 16 is provided with a supply pipe 19. At least one liquid of a development replenishing liquid or water is supplied to the developing portion 12 by the supply pipe 19 of the supply unit 16.

The switching valve 21 switches a supply path for a developer. The switching valve 21 is provided at a pipe 24 that connects the developing portion 12 to the waste liquid tank 20. For example, a three-way valve is used as the switching valve 21. In addition, a pipe 25 that reaches the developing portion 12 is connected to the switching valve 21. The pump 22 and the filter 23 are provided at the pipe 25 from a switching valve 21 side.

The switching valve 21 is connected to the control unit 26, the opening and closing of the switching valve 21 is controlled by the control unit 26, and a supply destination for the developer discharged from the developing portion 12 after development can be changed.

The switching valve 21 switches between carrying the developer after development from the developing portion 12 to the waste liquid tank 20 and carrying the developer after development from the developing portion 12 to the pump 22.

The pump 22 sends a fatigued developer generated from development by the developing portion 12 to the developing portion 12 through the filter 23. The configuration of the pump 22 is not particularly limited insofar as the developer can be sent.

The filter 23 removes solid substances (not shown) in the developer after development, and the filter 23 can decrease the concentration of the solid substances. With the filter 23, a regenerated developer is obtained from the developer after development, that is, the fatigued developer. For this reason, the regenerated developer is supplied to the developing portion 12 through the filter 23.

The filter 23 is not particularly limited insofar as the solid substances (not shown) in the developer after development can be separated out and is determined as appropriate according to the size of a solid substance to be separated out. For example, a ceramic filter is used. It is preferable that the filter 23 can separate out, for example, a solid substance having a particle diameter of 1 μm or less.

In addition, in the pipe 25, there may be a heater that adjusts the temperature of a liquid supplied to the developing portion 12. Insofar as the liquid temperature can be adjusted to a temperature set in advance, a configuration thereof is not particularly limited. For example, an in-line type heater in which a heat generating body is provided inside the pipe 25 is used as the heater.

The rinsing unit 13 supplies, for example, a rinsing liquid of which an only component is substantially water to the developed flexographic printing plate precursor.

The developing portion 12 develops the exposed flexographic printing plate precursor and transports the flexographic printing plate precursor after being exposed by the exposure device (not shown).

The developing portion 12 develops, for example, the imagewise exposed flexographic printing plate precursor using a developer. The configuration of the developing portion 12 is not particularly limited insofar as the imagewise exposed flexographic printing plate precursor can be developed. A known device using an aqueous developer is usable as appropriate as the developing portion 12. The developing portion 12 may have a configuration called a clamshell type in which the flexographic printing plate precursor is developed through a batch method or may have a transport type configuration in which development is performed while the flexographic printing plate precursor is transported. In addition, a form in which the imagewise exposed flexographic printing plate precursor is immersed and developed may be adopted.

In addition to the developer, for example, a rinsing liquid, a development replenishing liquid, water, and the like are added to the developer in some cases. The rinsing liquid and the development replenishing liquid will be described later. In addition, the developer is, for example, an aqueous developer of which a main component is water.

The waste liquid tank 20 stores a developer discarded from the developing portion 12 and stores, for example, a developer in a state not suitable for development. The switching valve 21 is opened, and a developer in the developing portion 12 is discharged to the waste liquid tank 20. Whether or not the developer is suitable for development may be determined by using a measurement result from the measuring unit 14 and may be based on a development treatment area of the flexographic printing plate precursor.

A developer supply unit is composed of the switching valve 21, the pump 22, and the filter 23. Although a flow meter that measures the flow rate of the developer is preferable as the developer supply unit, for example, the flow meter is unnecessary in a case where the pump 22 has a function that can measure a sending amount.

The exposure device exposes the flexographic printing plate precursor. The flexographic printing plate precursor exposed by the exposure device is the imagewise exposed flexographic printing plate precursor. A front surface of the imagewise exposed flexographic printing plate precursor becomes a printing surface.

The configuration of the exposure device is not particularly limited insofar as the flexographic printing plate precursor can be developed. A known device that can expose the flexographic printing plate precursor is usable as appropriate as the exposure device.

Next, the developer management method will be described.

(Example of Developer Management Method)

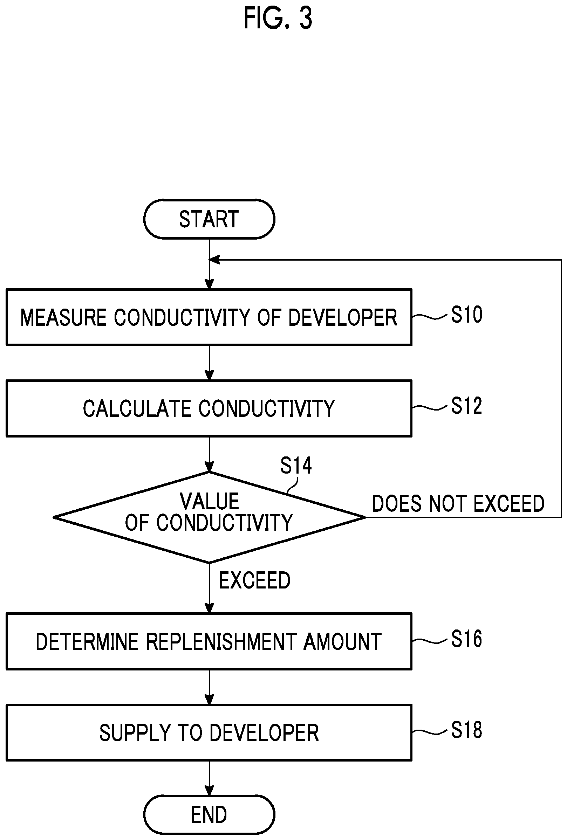

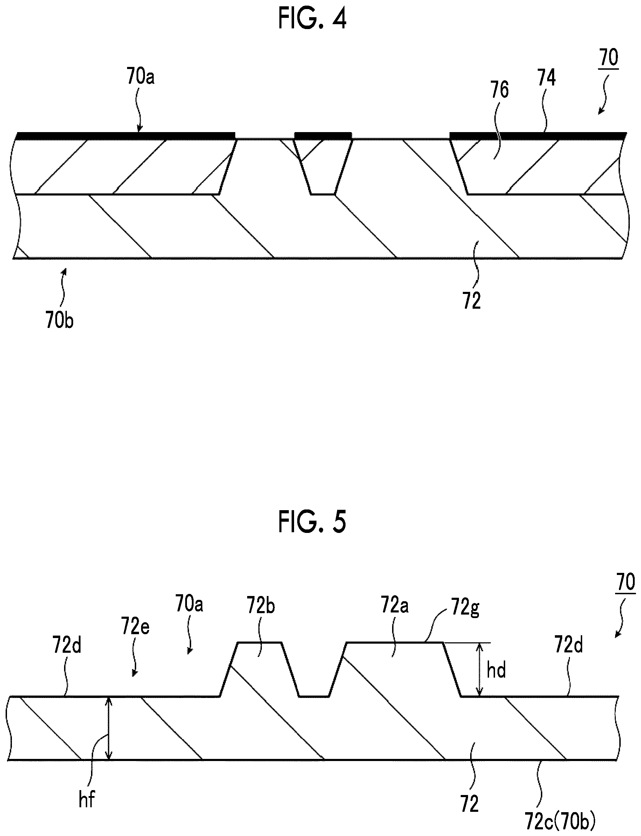

Fig. 3 is a flowchart showing an example of the developer management method according to the embodiment of the present invention, and Fig. 4 is a schematic cross-sectional view showing a state after exposure of the flexographic printing plate precursor used in the plate-making method according to the embodiment of the present invention.

A flexographic printing plate precursor 70 (see Fig. 4) is imagewise exposed by the exposure device in a specific pattern or the like and is configured to have a hardened portion 72 and an unhardened portion 73. There is a black mask 74 on the unhardened portion 73. The unhardened portion 73 is a non-exposed portion in a case of exposure.

Next, the imagewise exposed flexographic printing plate precursor 70 is transported to the developing portion 12 (see Fig. 1) of the plate-making apparatus 10 (see Fig. 1), and the unhardened portion 73 (see Fig. 4) of the flexographic printing plate precursor 70 (see Fig. 4) is removed and developed by the developing portion 12. A step of removing and developing the unhardened portion 73 (see Fig. 4) of the imagewise exposed flexographic printing plate precursor 70 (see Fig. 4) using the developer is called a developing step.

In the developing step, through development using the developer, sensitizer components (solid contents) from which the unhardened portion 73 (see Fig. 4) of the flexographic printing plate precursor 70 is removed are dispersed by a surfactant in the developer. The developer after development, that is, a fatigued developer is obtained.

Herein, in a case where the sensitizer concentration of the developer exceeds, for example, 5% by mass, it is necessary to replace the developer before the sensitizer concentration of the developer becomes 5% by mass since on-plate residues are generated and cause damage to a printed material in a rinsing step after the developing step. In addition, there is a method of maintaining a sensitizer concentration in the developer by replenishing and overflowing a developer which has not been used in development according to a treatment area such that the sensitizer concentration of the developer does not exceed 5% by mass. However, through the method of maintaining the sensitizer concentration in the developer by replenishing and overflowing the developer described above, it is difficult to accurately maintain the sensitizer concentration and the developer concentration as a developer amount or a rinse amount per square meter differs depending on a user or a job and the evaporation amount of the developer is large.

Next, the developer after development is moved to the measuring unit 14 (see Fig. 1) via the connecting pipe 17 (see Fig. 1).

Next, the measuring unit 14 measures the conductivity of the developer (Step S10). Then, the conductivity of the developer is obtained (Step S12). A step of measuring the conductivity of the developer described above (Step S10) is a measuring step.

It is determined that whether or not the conductivity of the developer obtained in Step S12 is within the range Rc of Fig. 2 described above (Step S14).

In a case where the conductivity is within the range Rc, the developer is continued to be used.

On the other hand, in a case where the measured conductivity of the developer is out of the range Rc, when the conductivity is lower than the range Rc, the amount of the development replenishing liquid is calculated, and the amount of the development replenishing liquid is used as a replenishment amount (Step S16). Calculating the amount of the development replenishing liquid in Step S16 described above is a calculating step.

In addition, in a case where the measured conductivity of the developer is out of the range Rc, when the conductivity is higher than the range Rc, the amount of the water is calculated, and the amount of the water is used as a replenishment amount (Step S16).

Regarding whether to replenish any one of a developer replenishing liquid or water, replenishing the water is set in advance in the calculation unit 15, for example, in a case where the measured conductivity of the developer is higher than the range Rc. Then, a correction amount of the water is acquired such that the conductivity becomes a control target value.

On the other hand, in a case where the measured conductivity of the developer is lower than the range Rc, replenishing the development replenishing liquid is set in advance in the calculation unit 15. Then, the replenishment amount of the development replenishing liquid may be acquired such that the conductivity becomes the control target value.

Next, at least one liquid of the development replenishing liquid or the water is supplied to the developer based on the replenishment amount calculated by the calculation unit 15 (Step S18). A step of supplying the at least one liquid described above to the developer (Step S18) is a replenishing step.

As described above, the conductivity of the developer is measured, the conductivity of the developer is managed by replenishing at least one liquid of the development replenishing liquid or the water to become a conductivity in a determined range based on the measured conductivity. Accordingly, the concentration of the developer can be maintained in the management concentration range $\delta c$. For this reason, development can be performed at an appropriate development speed. In addition, also a rise in the sensitizer concentration in the developer is prevented by replenishing as described above. Accordingly, development residues are prevented from being adhered to the flexographic printing plate precursor. Further, the replacement frequency of the developer can be decreased. That is, the bus life of the developer can be extended, that is, the life of the developer can be extended.

In Step S18, after the developer is supplied, the conductivity of the developer may be measured again. However, as represented by the straight line Lc shown in Fig. 2, in a case where a relationship between the conductivity of the developer and the concentration of the developer is acquired in advance, after supplying a liquid to the developer as described above, a probability that the conductivity of the developer is within the range Rc is high, and the conductivity of the developer may not be measured again.

Next, development of the flexographic printing plate precursor will be described.

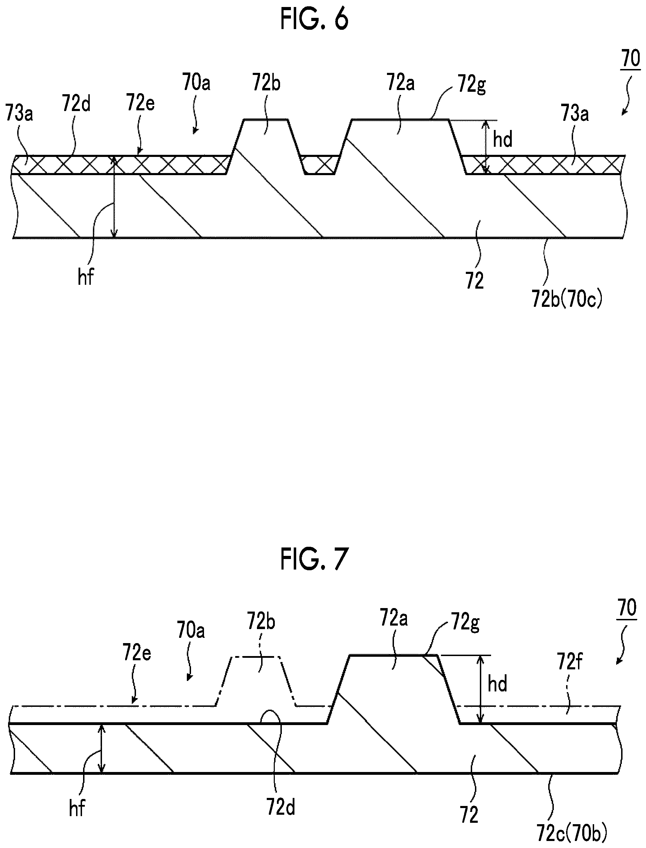

Fig. 5 is a schematic cross-sectional view showing an example of post-development of the flexographic printing plate precursor used in the plate-making method according to the embodiment of the present invention, Fig. 6 is a schematic cross-sectional view showing an example of post-development in a case where the development speed of the flexographic printing plate precursor used in the plate-making method according to the embodiment of the present invention is slow, and Fig. 7 is a schematic cross-sectional view showing an example of post-development in a case where the development speed of the flexographic printing plate precursor used in the plate-making method according to the embodiment of the present invention is fast.

The flexographic printing plate precursor is configured to have the hardened portion 72 and the unhardened portion 73 in a case of being imagewise exposed as shown in Fig. 4 described above. There is the black mask 74 at the unhardened portion 73. The unhardened portion 73 and the black mask 74 are removed due to development. In a case where development is appropriately performed, as shown in Fig. 5, as the flexographic printing plate precursor 70, the hardened portion 72 remains, for example, an image area 72a, an image area 72b, and a non-image area 72e are present. An imagewise exposed front surface 70a of the flexographic printing plate precursor 70 becomes a printing surface.

In the hardened portion 72, a distance from a back surface 72c of the hardened portion 72, that is, a back surface 70b of the flexographic printing plate precursor 70 to a front surface 72d of the non-image area 72e is a floor area thickness hf.

In addition, the image area 72a and the image area 72b have the same height. A distance from a front surface 72g of the image area 72a, that is, the front surface 70a of the flexographic printing plate precursor 70 to the front surface 72d of the non-image area 72e is an image area height hd.

The floor area thickness hf is an average value of measurement values obtained by measuring distances described above of eight points corresponding to the floor area.

The image area height hd is an average value of measurement values obtained by measuring distances described above of eight points corresponding to the image area.

The floor area thickness hf and the image area height hd are measured using a measuring device that measures a general thickness. For example, the floor area thickness hf and the image area height hd are measured using Dial Thickness Gauge/7321 manufactured by Mitutoyo Corporation.

Herein, in a development mechanism of the flexographic printing plate precursor using an aqueous developer, a latex particle surface in the flexographic printing plate precursor dissociates due to alkali, the flexographic printing plate precursor expands due to electrostatic repulsion between latexes, and as the developer permeates, the flexographic printing plate precursor softens, and an unhardened portion is removed by a brush or the like and is developed.

On the other hand, in a case where the concentration of electrolyte in the developer increases, charges of the latex particle surface are shielded, the expansion of the flexographic printing plate precursor and the permeation of the developer are prevented, decreasing developability. Therefore, it is necessary to control a water-developed flexographic printing plate precursor by managing the concentration of ions in the developer with the conductivity.

In development, in a case where the development speed is slow, as shown in Fig. 6, a part 73a of the unhardened portion 73 remains. For this reason, the floor area thickness hf increases, and the image area height hd decreases. Accordingly, an ink during printing is likely to remain in the non-image area of the plate, and a non-image area of the printed material is likely to be contaminated. Accordingly, the image quality of the printed material decreases.

On the other hand, in development, in a case where the development speed is fast, as shown in Fig. 7, the non-image area 72e becomes deeper. For this reason, the floor area thickness hf decreases, and the image area height hd increases. Accordingly, independent small dots, which are shallower and smaller than the hardened portion 72 (see Fig. 4), for example, the image area 72b (see Fig. 5) is developed together with the unhardened portion 73 (see Fig. 4). That is, the image area 72b (see Fig. 5) is removed. More specifically, compared to Fig. 5 in which development is appropriately performed, an excessively removed portion 72f is removed. In a case where the development speed is fast, the image quality of the printed material decreases, for example, the image area 72b representing independent small dots is removed. In a case where the concentration of electrolyte in the developer increases, that is, in a case where the concentration of the developer increases, the development speed becomes slow. In addition, in a case where the developer is in a state where alkalinity and the concentration of electrolyte are low, the development speed becomes fast.

With respect to the water-development described above, in a development mechanism of an offset printing plate, an alkali-soluble resin in the offset plate is dissolved by alkali in the developer and is developed. In a case where the resin is dissolved, the pH of the developer is decreased due to the acid group of the resin, and development activity decreases.

Therefore, in continuous processing of the offset printing plate, in order to maintain the development activity, it is necessary to maintain the pH at a certain level or higher, and the concentration of OH ions in the developer is managed and controlled through conductivity measurement. As described above, the development of the offset printing plate is different from using the conductivity of the developer in replenishing the developer.

Next, the plate-making apparatus will be specifically described.

(First Example of Plate-Making Apparatus)

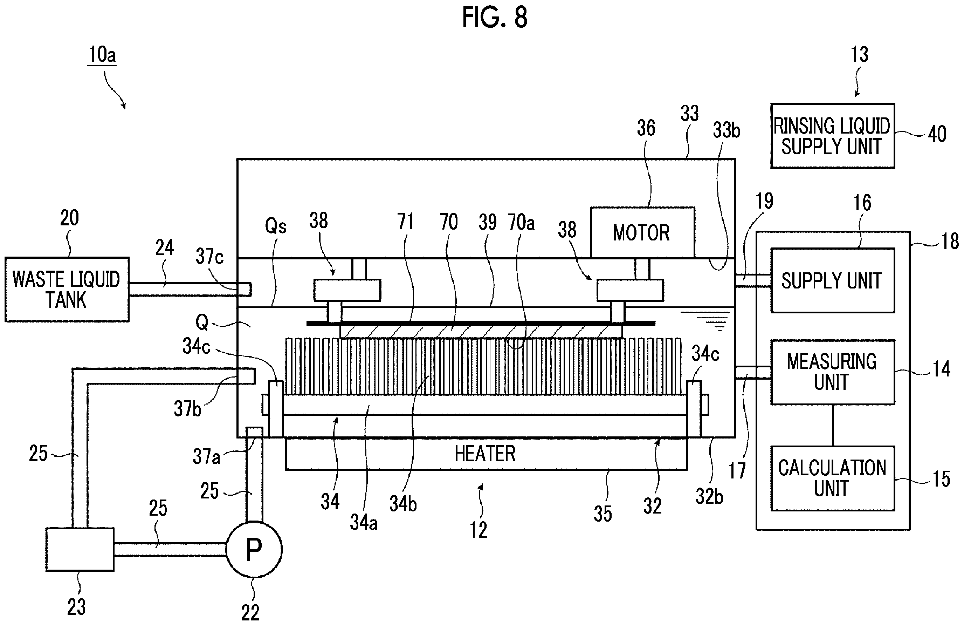

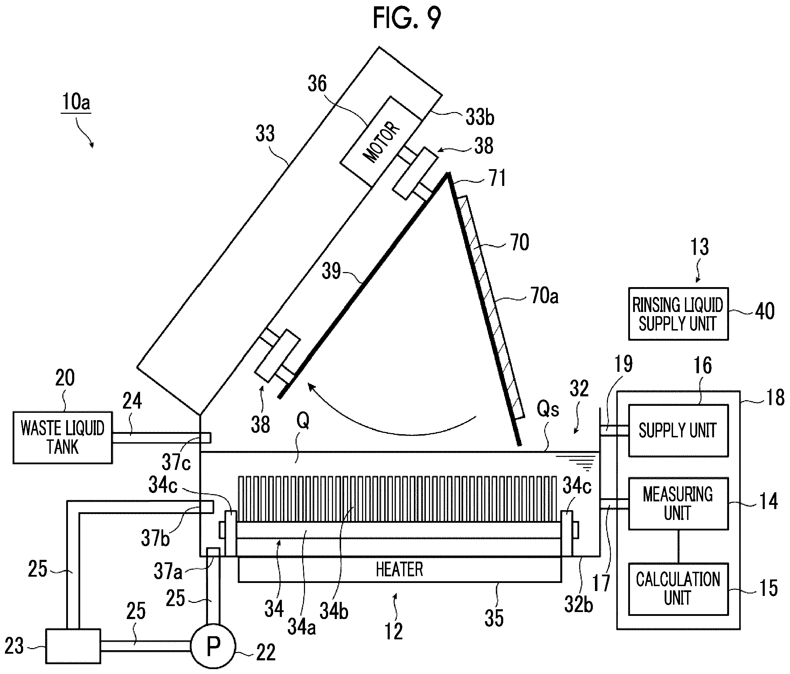

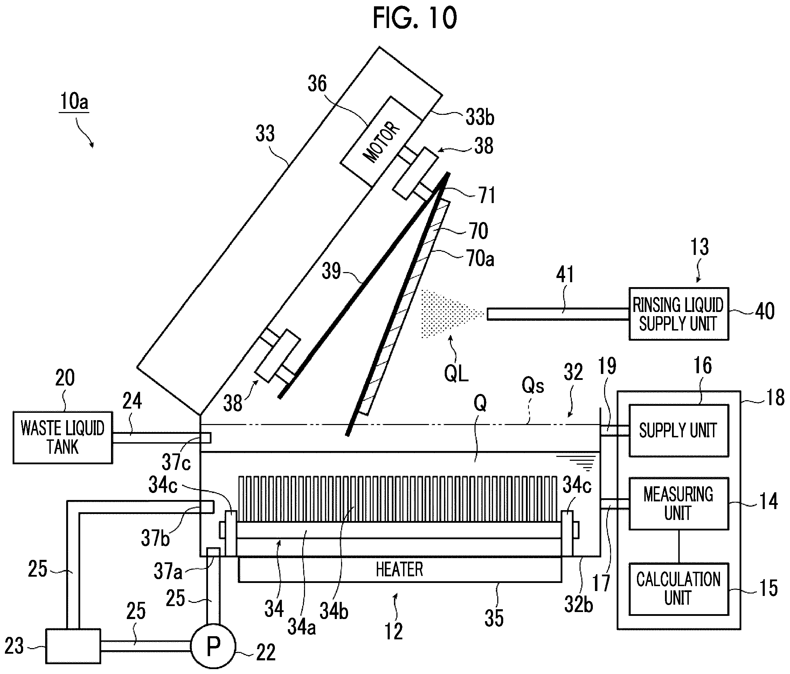

Fig. 8 is a schematic view showing a first example of the plate-making apparatus having the developer management device according to the embodiment of the present invention, Fig. 9 is a schematic view showing a usage form of the first example of the plate-making apparatus having the developer management device according to the embodiment of the present invention, and Fig. 10 is a schematic view showing the rinsing step of the first example of the plate-making apparatus having the developer management device according to the embodiment of the present invention.

Although the control unit is not shown in Figs. 8 to 10, each configuration unit is controlled by the control unit, like the plate-making apparatus 10 shown in Fig. 1. In addition, the same components shown in Figs. 1 and 4 will be assigned with the same reference numerals, and detailed description thereof will be omitted.

A plate-making apparatus 10a shown in Fig. 8 has a configuration called a clamshell type.

The plate-making apparatus 10a has a developing tank 32 and a lid 33 of the developing tank 32. The lid 33 is openable and closable with respect to the developing tank 32, and for example, the developing tank 32 and the lid 33 are connected to each other using a hinge. In a state where the lid 33 is closed, a back surface 33b of the lid 33 faces a liquid level Qs of a developer Q in the developing tank 32.

A brush 34 is disposed in the developing tank 32. The brush 34 is obtained, for example, by bundling bristles 34b perpendicular to a quadrangular substrate 34a. The substrate 34a is fixed into the developing tank 32 by the fixing unit 34c. The shape of the substrate 34a is the shape of the brush 34. The shape of the substrate 34a is not limited to a quadrangle in plan view.

In addition, a material for the bristles of the brush 34 is not particularly limited, and for example, a known material used for the development of the flexographic printing plate precursor 70, such as nylon 6,6, nylon 610, polybutylene terephthalate (PBT), and polyethylene terephthalate (PET), can be used as appropriate.

The measuring unit 14 and the supply unit 16 are provided at a side surface of the developing tank 32. The calculation unit 15 is connected to the measuring unit 14. Even in the plate-making apparatus 10a, the management device 18 for the developer Q is composed of the measuring unit 14, the calculation unit 15, and the supply unit 16.

The supply unit 16 may be configured to have a development replenishing liquid storage tank (not shown) that stores a development replenishing liquid and a water storage tank (not shown) that stores water. The development replenishing liquid storage tank is connected to the supply pipe 19 via a valve (not shown). The water storage tank is connected to the supply pipe 19 via a valve (not shown).

The supply unit 16 may be configured to have at least one of the development replenishing liquid storage tank or the water storage tank. Instead of providing the water storage tank, for example, a waterline may be directly connected, and water may be directly supplied from the waterline.

A pipe 25 that connects a drain hole 37a in a bottom surface of the developing tank 32 to a water supply hole 37b in a side surface of the developing tank 32 is provided. The pump 22 and the filter 23 are provided at the pipe 25 from a drain hole 37a side. As a regenerated developer, the developer Q which has passed through the filter 23 is supplied into the developing tank 32 via the water supply hole 37b.

A heater 35 is provided at a back surface 32b of the developing tank 32 to face the substrate 34a of the brush 34. The heater 35 keeps the developer Q in the developing tank 32 at a determined temperature. The configuration of the heater 35 is not particularly limited, and a known configuration is usable as appropriate.

In addition, an overflow hole 37c is provided in the side surface of the developing tank 32 at a position higher than the position of the liquid level Qs of the developer Q during normal development. The waste liquid tank 20 is provided at the overflow hole 37c via the pipe 24. In a case where the amount of the developer Q has increased in the developing tank 32, the developer Q is discharged from the overflow hole 37c to the waste liquid tank 20 via the pipe 24.

A motor 36 is provided inside the lid 33. For example, two cranks 38 are provided at the back surface 33b of the lid 33. Each of the cranks 38 is connected to a flat plate-shaped fixing member 39. The imagewise exposed flexographic printing plate precursor 70 is fixed to the fixing member 39 using a support plate 71. The support plate 71 is composed of, for example, an adhesive plate.

In addition, one crank 38 of the two cranks 38 is connected to the motor 36. The two cranks 38 are connected, and in a case where the one crank 38 rotates, the other crank 38 rotates in synchronization with the rotation. For this reason, in a case where the one crank 38 is rotated by the motor 36, the other crank 38 also rotates in synchronization with the rotation. Accordingly, the flexographic printing plate precursor 70 swings.

In the plate-making apparatus 10a, the brush 34 does not move, and the flexographic printing plate precursor 70 is swung such that the brush 34 reciprocates on an image forming surface of the flexographic printing plate precursor 70 in the developer Q.

In addition, in the plate-making apparatus 10a, as shown in Fig. 9, the lid 33 is opened, and the support plate 71 is fixed to the fixing member 39, for example, using a gluing agent. Accordingly, the flexographic printing plate precursor 70 can be fixed to the fixing member 39. In a case of removing the flexographic printing plate precursor 70, the lid 33 is opened, and the support plate 71 is removed from the fixing member 39.

The rinsing unit 13 has a rinsing liquid supply unit 40. The rinsing liquid supply unit 40 has a rinse nozzle 41 and further has a rinsing liquid storage unit (not shown) and a pump (not shown).

The rinsing liquid supply unit 40 supplies a rinsing liquid QL (see Fig. 10) to the developed front surface 70a of the flexographic printing plate precursor 70 using the rinse nozzle 41. Since the plate-making apparatus 10a is a clamshell type, the rinsing liquid QL supplied from the rinsing liquid supply unit 40 to the developed flexographic printing plate precursor 70 flows into the developing tank 32. In a case where the liquid level Qs of the developing tank 32 has risen due to the rinsing liquid flowed in, the rinsing liquid is discharged from the overflow hole 37c to the waste liquid tank 20 as a waste liquid.

It is preferable for the rinse nozzle 41 to be a jetting type spray nozzle. The type of jetting type spray nozzle is not particularly limited and may be, for example, one-fluid type using only a liquid or may be two-fluid type using a liquid and air.

The rinsing liquid is a liquid of which substantially only component is water, and for example, fresh water, tap water, industrial water, ground water, and the like can be used. The substantially only water means that water is 99.50% by mass or higher as a component of the rinsing liquid. Water preferably exceeds 99.99% by mass and is most preferably only water.

<Plate-Making Method>

The plate-making method of the plate-making apparatus 10a will be described.

First, the imagewise exposed flexographic printing plate precursor 70 is attached to the support plate 71, and the support plate 71 is attached to the fixing member 39. The inside of the developing tank 32 is filled with the developer Q. Then, the lid 33 is closed. The flexographic printing plate precursor 70 is immersed in the developer Q. The image forming surface, that is, the front surface 70a of the flexographic printing plate precursor 70 is brought into contact with the bristles 34b of the brush 34.

Next, the one crank 38 is rotated by the motor 36, the other crank 38 is also rotated in synchronization with the rotation, the flexographic printing plate precursor 70 is swung, and the flexographic printing plate precursor 70 is developed in a state of being immersed in the developer Q.

In this case, in the plate-making apparatus 10a, for example, a determined number of flexographic printing plate precursors 70 are sampled in the developer in the developing tank 32 after development treatment, the measuring unit 14 measures the conductivity of the developer Q, and then the conductivity of the developer is obtained. As described above, a relationship between the conductivity of the developer and the concentration of the developer is determined, for example, in advance as shown in Fig. 2.

Next, the calculation unit 15 determines whether or not the conductivity of the developer Q measured by the measuring unit 14 is within the range Rc of Fig. 2 described above. In a case where the conductivity is within the range Rc, the developer is continued to be used.

On the other hand, in a case where the measured conductivity of the developer is out of the range Rc, when the conductivity is lower than the range Rc, for example, the amount of the development replenishing liquid is calculated by the calculation unit 15, and the amount of the development replenishing liquid is used as a replenishment amount.

In addition, in a case where the measured conductivity of the developer is out of the range Rc, when the conductivity is higher than the range Rc, for example, the amount of the water is calculated by the calculation unit 15, and the amount of the water is used as a replenishment amount.

Regarding whether to replenish any one of a developer replenishing liquid or water in the plate-making apparatus 10a, as described above, for example, replenishing the water or the development replenishing liquid may be set in the calculation unit 15, and the replenishment amount of the water or the replenishment amount of the development replenishing liquid may be acquired by the calculation unit 15 such that the conductivity becomes a control target value.

After development, the lid 33 is opened, and the developed flexographic printing plate precursor 70 is taken out from the developer Q. Next, the rinsing liquid QL, for example, fresh water is supplied to the front surface 70a of the flexographic printing plate precursor 70 using the rinse nozzle 41, and residues such as latex components and rubber components remaining on the front surface 70a of the flexographic printing plate precursor 70 are removed. In this case, the rinsing liquid QL flows into the developing tank 32, and an increment in the developing tank 32 is discharged from the overflow hole 37c of the side surface of the developing tank 32 to the waste liquid tank 20 as a waste liquid.

Removing residues, such as latex components and rubber components remaining on the front surface 70a of the flexographic printing plate precursor 70, using the rinsing liquid QL is called the rinsing step.

After the rinsing step, the flexographic printing plate precursor 70 is removed from the plate-making apparatus 10a.

The configuration of the plate-making apparatus is not limited to the configuration shown in Fig. 8 and may be other configurations.

(Second Example of Plate-Making Apparatus)

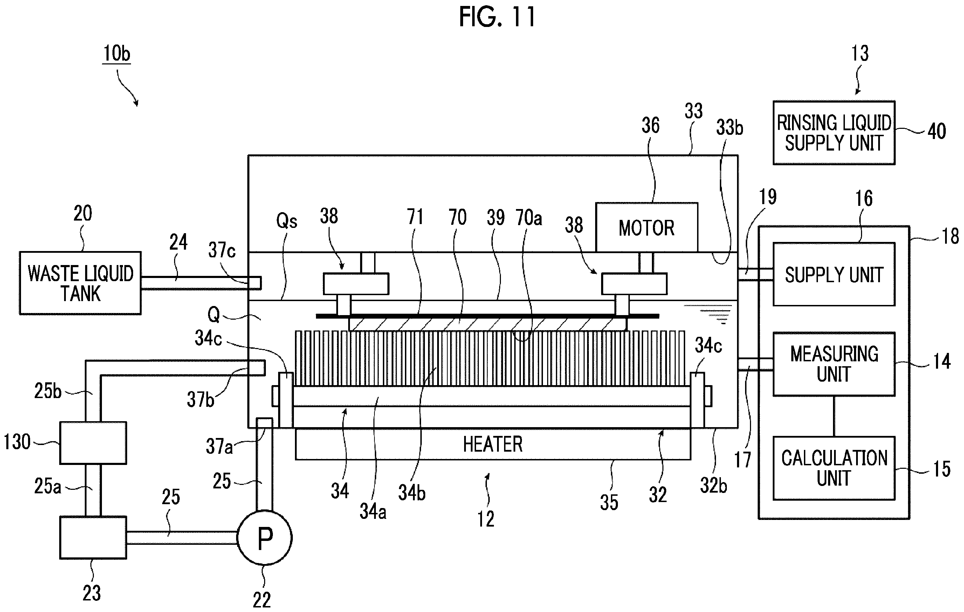

Fig. 11 is a schematic view showing a second example of the plate-making apparatus having the developer management device according to the embodiment of the present invention. In Fig. 11, the same components as the plate-making apparatus 10a shown in Fig. 8 will be assigned with the same reference numerals, and detailed description thereof will be omitted.

A plate-making apparatus 10b shown in Fig. 11 is different from the plate-making apparatus 10 shown in Fig. 8 in that the plate-making apparatus 10b has a heater 130, and the other configurations are the same as the configurations shown in Fig. 8.

The heater 130 is connected to a pipe 25a and a pipe 25b and is connected to the pump 22 and the filter 23. The heater 130 adjusts the temperature of the developer Q supplied into the developing tank 32 to a determined temperature, for example, in a range of 40°C to 50°C. The configuration of the heater 130 is not particularly limited, and a known configuration is usable as appropriate.

The temperature of the developer Q which has passed through the filter 23 is adjusted by the heater 130 to a certain temperature within the range of 40°C to 50°C, and the developer is supplied as a regenerated developer into the developing tank 32 via the water supply hole 37b.

(Example of Heater)

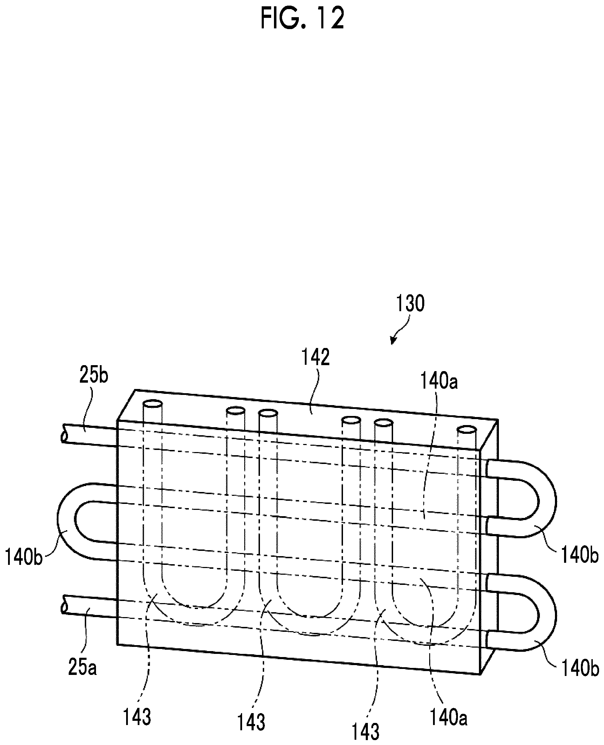

Fig. 12 is a schematic perspective view showing an example of the heater used in the second example of the plate-making apparatus having the developer management device according to the embodiment of the present invention.

As shown in Fig. 12, the heater 130 has a pipe 140, a block 142 in which a part of the pipe 140 is buried, and a heating heater 143 provided in the block 142. The block 142 is formed of a metal material. The metal material forming the block 142 is preferably a metal material excellent in castability and is, for example, copper, a copper alloy, aluminum, or an aluminum alloy.

In the pipe 140, one pipe is seamlessly disposed in the block 142. The pipe has a linear part 140a inside the block 142 and a bending part 140b connecting the linear part 140a inside. The bending part 140b is disposed outside the block 142. In addition, for example, three heating heaters 143 are disposed at intervals in a direction in which the linear part 140a of the pipe 140 extends.

The linear part 140a and the heating heater 143 of the pipe 140 are cast and integrated with the block 142.

A device used as a cast heater is usable as appropriate as the heating heater 143.

An overheat protection device such as a thermostat (not shown) is provided inside the heater 130 and cuts off power in a case where abnormal overheating occurs. In this manner, a treatment liquid including the developer can be maintained at a predetermined temperature.

It is preferable that the watt density of the heating heater 143 of the heater 130 is 5 $W/cm^2$ or less. In a case where the watt density of the heating heater 143 is set to 5 $W/cm^2$ or less, a heat generation temperature of a heat generating body can be relatively kept low, and the life of the heat generating body can be extended. In a case where the heating heater 143 is cast, it is difficult to repair the heating heater 143, so that the failure of the heater 130 can be prevented.

Having low watt density extends the life of the heater, but a heater block becomes large and costs increase in a case where the watt density is 1 $W/cm^2$ or less, which is not practical. The watt density of the heating heater 143 is more preferably 3 to 5 $W/cm^2$.

As the heater 130 has the configuration described above, the developer Q does not come into direct contact with the heating heater 143, and heat is uniformly exchanged in the linear part 140a. Thus, local burning is prevented even in the developer Q containing solid contents.

As the developer Q passes through the inside of the pipe in the block at a liquid flow rate of 100 cm/sec or higher, burning of the developer Q containing solid contents is prevented even in a case where a heating setting temperature of the heater 130 is approximately 100°C and the concentration of solid contents of the developer Q is high. For this reason, the flow rate of the developer in the heater 130 is preferably 100 cm/sec and more preferably 200 cm/sec or higher. For example, the pump causes the developer to flow in the heater 130 at the flow rate described above.

The flow rate of the developer in the heater 130 can be measured by various types of commercially available liquid flow meters. In addition, the flow rate of the developer in the heater 130 can also be acquired by calculating from a cross-sectional area in the pipe of the heater 130 and a circulation amount of the pump.

The heater 130 shown in Fig. 12 is also called a cast heater. In addition to the description above, a cast heater can be used as the heater. In addition to the cast heater, for example, a metal block heater in which a heater and a pipe through which a liquid is passed are press-fitted into a metal block, a heater in which a cartridge heater or a sheathed heater and a metal pipe are set in a mold and a metal is injected, or the like can be used.

(Third Example of Plate-Making Apparatus)

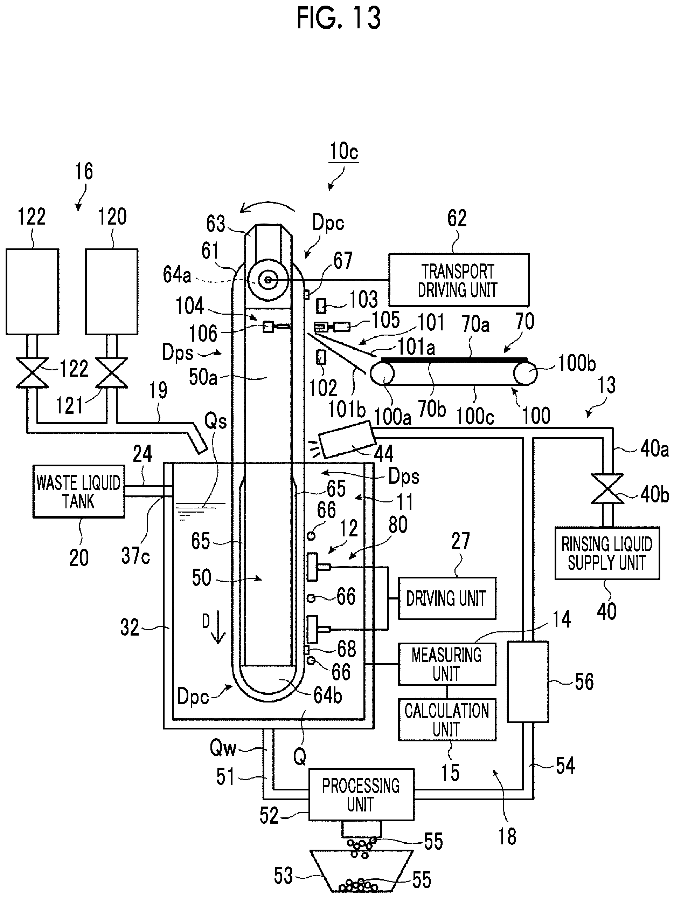

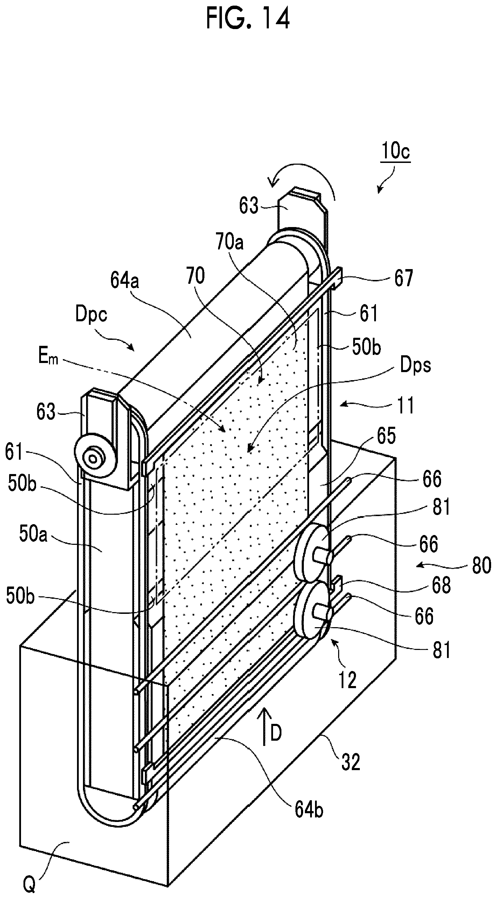

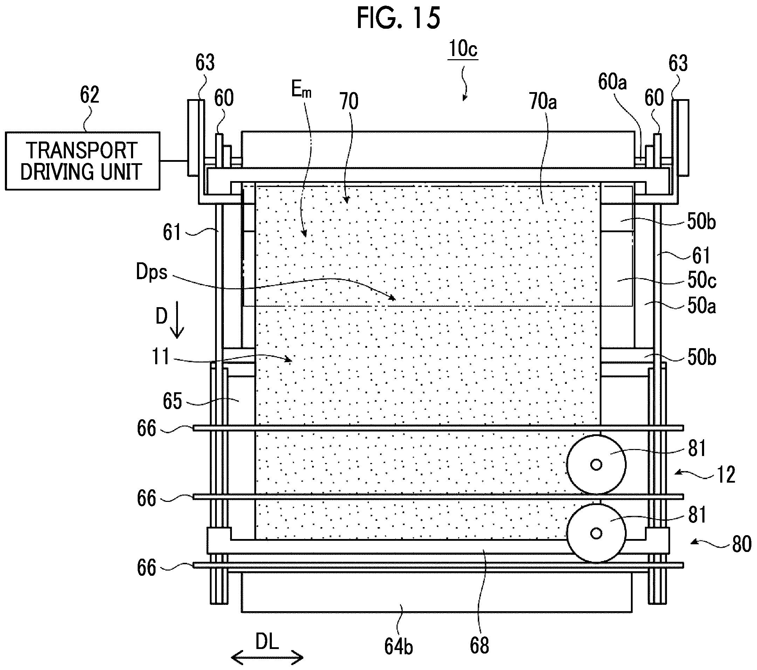

Fig. 13 is a schematic side view showing a third example of the plate-making apparatus according to the embodiment of the present invention, Fig. 14 is a schematic perspective view showing main portions of the third example of the plate-making apparatus according to the embodiment of the present invention, and Fig. 15 is a schematic plan view showing main portions of the third example of the plate-making apparatus according to the embodiment of the present invention. Figs. 14 and 15 partially omit a configuration of a plate-making apparatus 10c compared to Fig. 13.

In Figs. 13 to 15, the same components as the plate-making apparatus 10a shown in Figs. 8 to 10 will be assigned with the same reference numerals, and detailed description thereof will be omitted.

The plate-making apparatus 10c shown in Fig. 13 is a device that develops the imagewise exposed flexographic printing plate precursor 70, of which the front surface 70a is imagewise exposed, using the developer Q, while transporting the flexographic printing plate precursor and is a transporting type plate-making apparatus that develops the flexographic printing plate precursor 70 in a state of being transported along a determined transport path Dp. Performing development using the developer Q described above is called the developing step. As shown in Fig. 13, the transport path Dp for the flexographic printing plate precursor 70 has a curved transport passage Dpc and linear transport passages Dps. A transport direction D of the flexographic printing plate precursor 70 includes an upward direction and a downward direction. The upward direction is a direction from the developing tank 32 toward a turn bar 64a, and the downward direction is a direction from the turn bar 64a toward the developing tank 32. In addition, the curved transport passage Dpc is also called a turn portion.

The determined transport path Dp shown in Fig. 13 is a go-around transport path having the curved transport passage Dpc, the linear transport passage Dps, and the curved transport passage Dpc. For this reason, as will be described later, the flexographic printing plate precursor 70 can be developed by making the flexographic printing plate precursor go around a plurality of times.

As will be described later, the flexographic printing plate precursor 70 has a small thickness of approximately several millimeters and is flexible enough to be curved and transported in the developing tank 32. In addition, for example, the exposure device (not shown) imagewise exposes the front surface 70a of the flexographic printing plate precursor 70. The imagewise exposed front surface 70a of the flexographic printing plate precursor 70 becomes a printing surface.

In the plate-making apparatus 10c, the imagewise exposed flexographic printing plate precursor 70, which is in a state of being immersed in the developer Q and being transported, is developed with a non-exposed portion (not shown) of the flexographic printing plate precursor 70 removed. The plate-making apparatus 10c is a single-sheet type device that performs development while transporting the flexographic printing plate precursor 70 along a determined transport path. In the plate-making method using the plate-making apparatus 10c, the flexographic printing plate precursor 70 is developed while being transported along the determined transport path Dp. The plate-making method means a developing method.

The expression that while transporting the flexographic printing plate precursor 70 described above and a state where the flexographic printing plate precursor 70 is transported mean moving the flexographic printing plate precursor 70 along the transport path Dp.

The plate-making apparatus 10c has a transporting unit 11, the developing portion 12, the rinsing unit 13, the measuring unit 14, the calculation unit 15, and the supply unit 16. In addition, the waste liquid tank 20 is provided at the overflow hole 37c via the pipe 24. Although not shown, the plate-making apparatus 10c has a control unit that controls an operation of each unit, and the control unit controls an operation of each unit of the plate-making apparatus 10c unless stated otherwise. Even in the plate-making apparatus 10c, the management device 18 for the developer Q is composed of the measuring unit 14, the calculation unit 15, and the supply unit 16.

The supply unit 16 has a development replenishing liquid storage tank 120 that stores a development replenishing liquid and a water storage tank 122 that stores water. The development replenishing liquid storage tank 120 is connected to the supply pipe 19 via a valve 121. The water storage tank 122 is connected to the supply pipe 19 via a valve 123.

The supply unit 16 may be configured to have at least one of the development replenishing liquid storage tank 120 or the water storage tank 122. Instead of providing the water storage tank 122, for example, a waterline may be directly connected, and water may be directly supplied from the waterline.

The configuration of the development replenishing liquid storage tank 120 is not particularly limited insofar as the development replenishing liquid can be stored, and various types of containers formed of a metal, plastic, or the like can be used.

The configuration of the water storage tank 122 is not particularly limited insofar as the water can be stored, and various types of containers formed of a metal, plastic, or the like can be used.

Although the transporting unit 11 and the developing portion 12 are provided at a frame 50 in the plate-making apparatus 10c, the invention is not limited to the configuration.

The plate-making apparatus 10c has a feeding device 100 that feeds the flexographic printing plate precursor 70 to an attachment and detachment station $E_m$ and transports the flexographic printing plate precursor 70 sent from the attachment and detachment station $E_m$ to the outside of the plate-making apparatus 10c.

The attachment and detachment station $E_m$ is a region where the flexographic printing plate precursor 70 is fixed to a leading end leader 67 and a trailing end leader 68 and the fixing is released. It is preferable that the attachment and detachment station $E_m$ is set in a region of the linear transport passage Dps for easy handling.

The feeding device 100 feeds the flexographic printing plate precursor 70 to the attachment and detachment station $E_m$, and a configuration thereof is not particularly limited insofar as the flexographic printing plate precursor 70 can be transported to the outside of the plate-making apparatus 10c. As the feeding device 100, for example, a belt conveyor or a roller conveyor can be used, and a belt conveyor or a roller conveyor having a general configuration can be used.

The feeding device 100 has, for example, a drive roller 100a and a driven roller 100b, and an endless conveyor belt 100c is hung on the drive roller 100a and the driven roller 100b. Power generated by a driving unit such as a motor (not shown) is transmitted to the drive roller 100a to rotate the drive roller 100a. Accordingly, the conveyor belt 100c moves rotationally. The conveyor belt 100c sends the flexographic printing plate precursor 70 to the attachment and detachment station $E_m$, but the feeding device 100 is provided with a guide 101 that guides the flexographic printing plate precursor 70 to the leading end leader 67 or the trailing end leader 68 in the attachment and detachment station $E_m$. In the guide 101, for example, a guide plate 101a disposed on a front surface 70a side of the flexographic printing plate precursor 70 and a guide plate 101b disposed on a back surface 70b side are disposed to face each other with a gap.

The guide plate 101a and the guide plate 101b may be configured such that the guide plate 101a and the guide plate 101b themselves have good lubricity or are made of, for example, stainless steel. In addition thereto, for example, a resin layer, a glass layer, or a plating layer is provided on each of surfaces of the guide plate 101a and the guide plate 101b facing the flexographic printing plate precursor 70 in order to reduce friction with the flexographic printing plate precursor 70 and to efficiently guide to the attachment and detachment station $E_m$.

For example, although portions of the guide plates 101a and 101b which are formed of a metal such as stainless steel and come into contact with the flexographic printing plate precursor in a case where the flexographic printing plate precursor 70 is transported may be coated with a fluorine-based resin as resin layers, a plurality of high molecular weight polyethylene resins or a plurality of members made of a fluororesin such as polytetrafluoroethylene (PTFE) may be disposed along the transport direction in the portions of the guide plates 101a and 101b which are formed of a metal such as stainless steel and come into contact with the flexographic printing plate precursor in a case where the flexographic printing plate precursor 70 is transported.

In addition, the plate-making apparatus 10c has a sensor 102 that detects the trailing end leader 68 and a sensor 103 that detects the leading end leader 67. By detecting the trailing end leader 68 with the sensor 102 and detecting the leading end leader 67 with the sensor 103, positions of the leading end leader 67 and the trailing end leader 68 can be identified and positioned. For this reason, the leading end leader 67 and the trailing end leader 68 can be disposed at the attachment and detachment station $E_m$, and the flexographic printing plate precursor 70 can be fixed or released at an attachment and detachment position. In a case where the sensors 102 and 103 detect the leading end leader 67 and the trailing end leader 68, for example, a detection signal is output to a transport driving unit 62. Based on the detection signal, the transport driving unit 62 stops driving of a transport chain 61 and stops the leading end leader 67 and the trailing end leader 68 at the attachment and detachment station $E_m$. The transport driving unit 62 and the transport chain 61 will be described later.

The sensors 102 and 103 are not particularly limited insofar as the leading end leader 67 and the trailing end leader 68 can be detected, and for example, a proximity sensor, a limit switch, an area sensor, and the like can be used.

The positions where the two sensors 102 and 103 are provided are not particularly limited and, for example, may be the same positions in a direction DL (see Fig. 15) orthogonal to the transport direction D, or may be different positions. The sensor 102 may detect the leading end leader 67, the sensor 103 may detect the trailing end leader 68, and it is preferable to provide the sensors at different positions in the direction DL (see Fig. 15) in consideration of a space where the sensor 102 and the sensor 103 are disposed or the like.

Although a configuration where the two sensors 102 and 103 are provided is adopted, the number of sensors is not particularly limited, and there may be one sensor insofar as the leading end leader 67 and the trailing end leader 68 can be detected.

Further, the plate-making apparatus 10c has an attachment and detachment unit 104 that has a plate attachment portion 105 which fixes the flexographic printing plate precursor 70 to the leading end leader 67 and the trailing end leader 68 and a plate detachment portion 106 which releases the fixing of the flexographic printing plate precursor 70 by the leading end leader 67 and the trailing end leader 68. The attachment and detachment unit 104 is disposed at the attachment and detachment station $E_m$. As will be described later, a position where the attachment and detachment unit 104 fixes the flexographic printing plate precursor 70 and releases the fixing and the attachment and detachment unit 104 is disposed is called the attachment and detachment position.

The outer shape of the frame 50 is, for example, a rectangular shape. Two members 50a of the frame 50 extending in one direction as shown in Fig. 14 are disposed in parallel. In a direction orthogonal to a longitudinal direction of the members 50a, beam members 50b are disposed at both ends and the center of the members 50a in the longitudinal direction. Between the beam members 50b provided at both ends of the member 50a of the frame 50 in the longitudinal direction is the linear transport passage Dps. For example, up to the center of the members 50a of the frame 50, that is, up to the beam member 50b at the center, the linear transport passage is disposed in the developing tank 32. The developing tank 32 is a container in which the developer Q is stored. The developing portion 12 is disposed in the linear transport passage Dps in the developing tank 32.

As shown in Fig. 15, for example, gears 60 are rotatably provided at both ends of each member 50a in the longitudinal direction. The gears 60 facing each other in the longitudinal direction of the beam members 50b are connected by a shaft 60a. In each member 50a, the transport chain 61 is hung on a pair of gears 60 facing each other in the longitudinal direction. The pair of transport chains 61 are disposed to face each other in the longitudinal direction of the beam members 50b of the frame 50.

For example, the transport driving unit 62 is connected to one of the plurality of gears 60. The gears 60 are rotated by the transport driving unit 62, and the transport chains 61 move in a specific direction. A method of connecting between the gears 60 and the transport driving unit 62 is not particularly limited, the gears and the transport driving unit may be connected to each other by a shaft or the like or may be connected to each other using a chain or a belt.

The transporting unit 11 is composed of the gears 60, the transport chains 61, and the transport driving unit 62. The transporting unit 11 uses a winding transmission method using the gears 60 and the transport chains 61. The flexographic printing plate precursor 70 is transported by the transporting unit 11 in a state of being immersed in the developer Q in the developing tank 32.

The transporting unit 11 preferably has a tension adjusting unit 63 (see Fig. 13) that adjusts the tension of the flexographic printing plate precursor 70 during transporting. In a case where the tension of the transport chain 61 is low, the tension of the flexographic printing plate precursor 70 during transporting is low, the flexographic printing plate precursor 70 is loosened during transporting, and the flexographic printing plate precursor 70 is not stably transported. In addition, in a case where the tension of the transport chain 61 is low, the transport chain 61 is disengaged from the gear 60 in some cases. For this reason, the tension adjusting unit 63 that adjusts the tension of the transport chain 61 is provided at an end part of the member 50a in order to adjust the tension of the flexographic printing plate precursor 70 during transporting. The tension of the flexographic printing plate precursor 70 during transporting can be adjusted by the tension adjusting unit 63, and the flexographic printing plate precursor 70 is prevented from being loosened during transporting.

Insofar as the tension of the flexographic printing plate precursor 70 during transporting can be adjusted, a position where the tension adjusting unit 63 is disposed and a configuration thereof are not particularly limited, and a known unit can be used as appropriate. For example, it is possible to use a unit that changes a distance between the gears 60 on which the transport chains 61 are hung, a unit that applies tension by pressing the gears against the transport chain 61, or the like as appropriate.

The transporting unit 11 may have a guide mechanism that guides the transport chain 61. The guide mechanism can prevent meandering of the transport chain 61 or the like. The guide mechanism is composed of, for example, a member that is provided on an opposite side of the transport chain 61 where the flexographic printing plate precursor 70 is disposed and is inserted between rollers (not shown) of the transport chains 61. This member is formed of, for example, high molecular weight polyethylene or a fluororesin such as polytetrafluoroethylene (PTFE).

The turn bar 64a and a turn bar 64b (see Fig. 14) are provided at the beam members 50b at ends of the members 50a respectively in the longitudinal direction. The turn bars 64a and 64b are composed of a semi-cylindrical member, and the semi-cylindrical member is provided with a plane portion facing a beam member 50b side.

The semi-cylindrical turn bars 64a and 64b are provided at bending parts composed of the curved transport passages. That is, the curved transport passages Dpc are composed of the semi-cylindrical turn bars 64a and 64b, and the flexographic printing plate precursor 70 is transported along the surfaces of the turn bars 64a and 64b. In this case, the back surface 70b of the flexographic printing plate precursor 70 comes into contact with the turn bars 64a and 64b. The turn bars 64a and 64b each are composed of a semi-cylindrical member having a size corresponding to the curvature of the curved transport passage Dpc or the like.

Since the turn bars 64a and 64b are brought into contact with the flexographic printing plate precursor 70, at least, surfaces brought into contact with the flexographic printing plate precursor 70 preferably have a low frictional resistance. As the frictional resistance is low, the flexographic printing plate precursor 70 can be smoothly transported without damaging the back surface 70b. The turn bars 64a and 64b prevent tension fluctuations in the curved transport passages Dpc during transporting of the flexographic printing plate precursor 70.

The turn bar 64a and the turn bar 64b are provided at the ends of the members 50a in the longitudinal direction, and the turn bar 64b is immersed in the developing tank 32 storing the developer Q.

In addition, the flexographic printing plate precursor 70 is attached to the trailing end leader 68 in a state where the flexographic printing plate precursor 70 is hung on the turn bar 64a among the turn bar 64a and the turn bar 64b. The turn bar 64a moves forward and backward with respect to the curved transport passage Dpc. In a case where the turn bar 64a has entered the curved transport passage Dpc, the turn bar is brought into contact with the flexographic printing plate precursor 70. On the other hand, in a case where the turn bar 64a has moved backward with respect to the curved transport passage Dpc, a transport length of the flexographic printing plate precursor 70 is shortened, and a short pass state to be described later is caused. Specifically, as the turn bar 64a moves up and down with respect to the beam members 50b, the turn bar moves forward and backward with respect to the curved transport passage Dpc. For example, a linear motion mechanism using a solenoid is provided, for example, between the turn bar 64a and the beam member 50b. For example, a configuration where the turn bar 64a is lowered in a state where the solenoid is turned off and the turn bar 64a is raised in a state where the solenoid is turned on is adopted. Accordingly, in a case of fixing the flexographic printing plate precursor 70, the turn bar 64a can be lowered.

By raising and lowering the turn bar 64a, tension applied to the flexographic printing plate precursor 70 can be changed. The turn bar 64a functions as a tension applying unit. With the tension applying unit, by raising the turn bar 64a after fixing the flexographic printing plate precursor 70 to the leader, a force is applied in a direction in which the length of the flexographic printing plate precursor 70 extends in a state where the flexographic printing plate precursor 70 is fixed to the leader, and the tension of the flexographic printing plate precursor 70, that is, tension after fixing the flexographic printing plate precursor 70 to the leader can be made higher than tension in a case of fixing the flexographic printing plate precursor 70.

The tension in a case of fixing the flexographic printing plate precursor 70 is the tension of the flexographic printing plate precursor 70 in a state where the turn bar 64a is lowered. The tension after fixing the flexographic printing plate precursor is the tension of the flexographic printing plate precursor 70 in a state where the turn bar 64a is raised.

The magnitude of the tension of the flexographic printing plate precursor 70 can be identified by the tension of the flexographic printing plate precursor 70.

In a case where the tension of the flexographic printing plate precursor 70 is high, that is, the flexographic printing plate precursor 70 extends, vertical creases are generated in the flexographic printing plate precursor 70. On the other hand, in a case where the tension of the flexographic printing plate precursor 70 is low, that is, the flexographic printing plate precursor 70 loosens, horizontal creases are generated. Both of the vertical creases and the horizontal creases cause development defects. An operator visually checks the vertical creases and the horizontal creases and can start transport with a state where none of the creases are generated as appropriate tension. It is preferable to provide a device that measures the tension of the flexographic printing plate precursor 70 in the tension applying unit or the transport path and to adjust the tension of the flexographic printing plate precursor 70 such that the tension is within a certain range.

Next, the device that measures the tension of the flexographic printing plate precursor 70 or the like will be described.

In a state where the flexographic printing plate precursor 70 is fixed to the leader, a state where the turn bar 64a is raised is visually checked with the solenoid turned on, and a position where the solenoid is attached or a stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where a driving unit or an electric actuator composed of a ball screw, a linear guide, a servo motor, or the like is used, linear motion can be randomly made not only in on and off states but also in a certain range, and the tension can be finely adjusted. In a case where the linear motion mechanisms are configured to operate the tension applying unit via the load cell or the strain gauge, tension applied to the flexographic printing plate precursor 70 can be measured. By quantifying a tension range in a state where vertical creases and horizontal creases are not visually generated in the flexographic printing plate precursor 70, in a state where the flexographic printing plate precursor 70 is fixed to the leader according to various types such as a width, a length, and a thickness of the flexographic printing plate precursor 70, a state where the turn bar 64a is raised with the solenoid turned on is visually checked, and a position where the solenoid is attached or the stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where the driving unit or the electric actuator composed of the ball screw, the linear guide, the servo motor, or the like is used, linear motion can be randomly made not only in on and off states but also a certain range, and tension applied to the flexographic printing plate precursor 70 can be finely adjusted. In a case where the linear motion mechanisms are configured to operate the tension applying unit via the load cell or the strain gauge, tension applied to the flexographic printing plate precursor 70 can be measured. By quantifying a tension range in a state where vertical creases and horizontal creases are not visually generated in the flexographic printing plate precursor 70, an appropriate tension state according to various types such as the width, the length, and the thickness of the flexographic printing plate precursor 70 is easily set.

As a tension measurer, a tension controller is preferable.

The tension applying unit is not limited to the turn bar 64a described above, and a roller (not shown) can also be used instead of the turn bar 64a. In a case where the roller is provided, as in the turn bar 64a described above, the roller is configured to move forward and backward with respect to the curved transport passage Dpc, and tension can be applied to the flexographic printing plate precursor 70 in a case where the roller has entered the curved transport passage Dpc.

The surfaces of the turn bars 64a and 64b, which are brought into contact with the flexographic printing plate precursor 70, are composed of, for example, resin layers, plating layers, or diamond-like carbon layers (DLC layers). The resin layer can be formed of a fluororesin, such as polytetrafluoroethylene (PTFE) and high-density polyethylene. The plating layer is, for example, hard chrome plating. In addition thereto, a titanium nitride (TiN) layer or the like can be used. Further, a nonwoven fabric can also be used as the turn bars 64a and 64b. In a case of using the nonwoven fabric, an attachment on the back surface 70b of the flexographic printing plate precursor 70 can be removed.

In addition, a plurality of uneven portions may be formed in the surfaces of the turn bars 64a and 64b, which are brought into contact with the flexographic printing plate precursor 70. As the plurality of uneven portions are formed, a contact area reduces, and a frictional resistance decreases. An example in which the plurality of uneven portions are formed includes a metal plate such as an embossed stainless steel plate.

The turn bars 64a and 64b may be entirely formed of a material forming the surfaces brought into contact with the flexographic printing plate precursor 70.

Since the turn bar 64b is used in a state of being immersed in the developer Q in some cases, a unit that does not dissolve in the developer Q, a unit that does not deteriorate due to the developer Q, or a unit that does not deform, such as swelling, due to the developer Q is preferable.

In addition, a back plate portion 65 with which the flexographic printing plate precursor is brought into contact is provided between the beam member 50b at the center of the member 50a of the frame 50 and the beam member 50b at the end.

Since the back plate portion 65 is brought into contact with the flexographic printing plate precursor 70, a plane surface brought into contact with the flexographic printing plate precursor 70 is preferably a plane. As the plane surface brought into contact with the flexographic printing plate precursor 70 is a plane, the flexographic printing plate precursor 70 can be efficiently washed.

The back plate portion 65 is formed of, for example, a metal. The metal is preferably stainless steel, titanium, or the like, the surface of the back plate portion 65 brought into contact with the flexographic printing plate precursor 70 may be plated, the plating is preferably hard chrome plating and is more preferably diamond-like carbon (DLC) processing. In addition thereto, surface treatment with titanium nitride (TiN) or the like may be performed on the surface brought into contact with the flexographic printing plate precursor 70.

In addition, it is preferable that the back plate portion 65 is disposed also in a region where the attachment and detachment unit 104 is disposed. By providing the back plate portion 65 also in the region where the attachment and detachment unit 104 is disposed, in a case of fixing the flexographic printing plate precursor 70 to the leading end leader 67 and the trailing end leader 68, the back plate portion 65 becomes a support of the flexographic printing plate precursor 70, and the flexographic printing plate precursor 70 can be more reliably fixed to a pin 67d and a pin 68d. The back plate portion 65 may not be the plane surface brought into contact with the flexographic printing plate precursor 70, and at least one of convex portions or uneven portions may be in the contact surface. The convex portions or the uneven portions of the contact surface are formed by, for example, embossing.

In a case where the tension of the flexographic printing plate precursor 70 is high, that is, the flexographic printing plate precursor 70 extends, vertical creases are generated in the flexographic printing plate precursor 70. On the other hand, in a case where the tension of the flexographic printing plate precursor 70 is low, that is, the flexographic printing plate precursor 70 loosens, horizontal creases are generated. Both of the vertical creases and the horizontal creases cause development defects. The operator visually checks the vertical creases and the horizontal creases and checks the tension of the flexographic printing plate precursor 70. A state where none of the vertical creases and the horizontal creases are generated in the flexographic printing plate precursor 70 is defined as appropriate tension.

In addition, for example, three nip rollers 66 are provided to face the back plate portion 65 at intervals in the longitudinal direction of the members 50a. Two of the nip rollers are provided near a brush 81 of the developing portion 12. Although the flexographic printing plate precursor 70 has flexibility as described above, the nip rollers 66 prevent deflection or the like during transporting so that the flexographic printing plate precursor 70 can be stably transported, and even in a case where the brush 81 rotates or moves particularly during development, the flexographic printing plate precursor 70 can be stably transported. The nip rollers 66 are not limited to three. In a case where there is one brush 81, the nip rollers 66 are disposed as a pair around the brush 81 such that the brush 81 is sandwiched therebetween in the longitudinal direction of the members 50a. In a case where two brushes 81 are disposed in the longitudinal direction of the members 50a as in Fig. 14, the brushes 81 are disposed to be sandwiched between the nip rollers 66 around each brush in the longitudinal direction of the members 50a. In a case where the two brushes 81 are disposed at a distance apart from each other, since the nip rollers 66 are disposed around each brush, there are four brushes.

In order to make the nip rollers 66 do not damage a printing surface, that is, the front surface 70a of the flexographic printing plate precursor 70, surface roughness is made lower than 6.3, is preferably 3.2, and is more preferably 1.6 or lower in terms of arithmetic average roughness Ra in a case where the nip rollers 66 are hard rollers made of a metal or the like. In a case where soft rollers such as rubber rollers are used as the nip rollers 66, it is preferable to use a relatively hard material having rubber hardness of 50 degrees or higher.

Since the flexographic printing plate precursor 70 has flexibility as described above, there is a possibility that the non-exposed portion cannot be efficiently removed by the brush 81 due to deflection or the like in a case of being rubbed against the brush 81. As the back plate portion 65 described above is provided, the back surface 70b of the flexographic printing plate precursor 70 is supported by the back plate portion 65 in a case of removing the non-exposed portion by the brush 81, so that the non-exposed portion can be efficiently removed. In addition, the back plate portion 65 functions as a transport guide, and thus the flexographic printing plate precursor 70 can be more stably transported by the back plate portion 65.

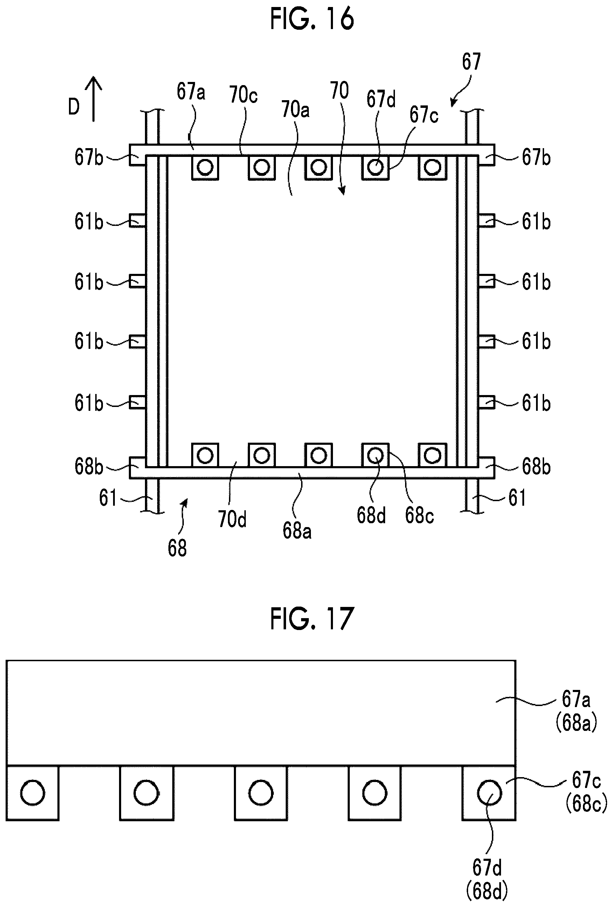

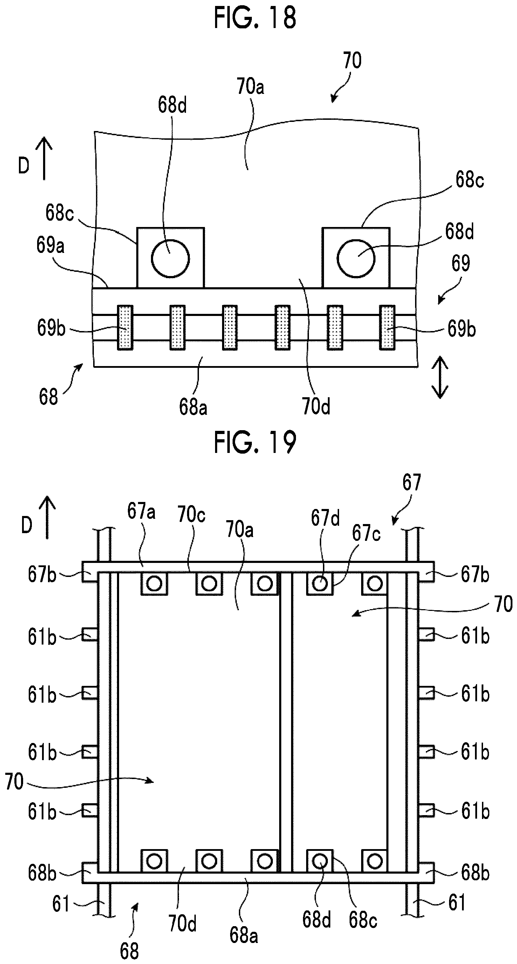

Herein, Fig. 16 is a schematic plan view showing a transporting form of the flexographic printing plate precursor according to the embodiment of the present invention, and Fig. 17 is a schematic view showing an example of the leading end leader used in transporting the flexographic printing plate precursor according to the embodiment of the present invention. Fig. 18 is a schematic view showing a leader mechanism portion used in transporting the flexographic printing plate precursor according to the embodiment of the present invention. In addition, Fig. 19 is a schematic plan view showing another example of the transporting form of the flexographic printing plate precursor according to the embodiment of the present invention.

The transporting unit 11 fixes the leader to the pair of transport chains 61 and transports the flexographic printing plate precursor 70.

The leaders are provided on a traveling direction side of the flexographic printing plate precursor 70, that is, on a leading end 70c (see Fig. 16) on a transport direction D side and a trailing end 70d (see Fig. 16) on an opposite side of the leading end 70c (see Fig. 16). The leaders include the leading end leader 67 and the trailing end leader 68 shown in Figs. 16 and 19.

As shown in Figs. 16 and 19, for example, a plurality of fixing units 61b are provided on the transport chain 61 at equal intervals along a longitudinal direction of the transport chain 61. The leading end leader 67 and the trailing end leader 68 are fixed to the fixing units 61b. The longitudinal direction of the transport chain 61 is the same direction as the transport direction D.

As shown in Fig. 16, the leading end leader 67 has a long base 67a and a bending portion 67b provided at each end of the base 67a in the longitudinal direction. As shown in Fig. 17, a plurality of attaching portions 67c are provided at the base 67a with gaps at equal intervals along a longitudinal direction of the base 67a. The pin 67d is provided for each of the attaching portions 67c. The pin 67d is passed through the flexographic printing plate precursor 70, and the flexographic printing plate precursor 70 is fixed to the leading end leader 67. In this case, in order to prevent the flexographic printing plate precursor 70 from moving during transporting, it is preferable that the base 67a and the leading end of the flexographic printing plate precursor 70 are aligned and fixed.

As shown in Fig. 16, the bending portion 67b of the leading end leader 67 is fixed to the fixing unit 61b of the transport chain 61, and the leading end leader 67 is fixed to the transport chain 61. A method of fixing the leading end leader 67 to the transport chain 61 is not particularly limited, and the leading end leader is fixed to the transport chain through at least one of fixing methods using hooking, screwing, sandwiching, or a magnetic force.

The hooking is, for example, a method of hooking the bending portion 67b to the fixing unit 61b.

The screwing is, for example, a method of fixing the bending portion 67b to the fixing unit 61b using a bolt and a nut. In addition thereto, a method of forming a female thread in the fixing unit 61b and fixing the bending portion 67b to the fixing unit 61b using a screw is also included in screwing.

The sandwiching is, for example, a method of collectively sandwiching and fixing the bending portion 67b and the fixing unit 61b to each other using a member such as a clip.

Fixing by a magnetic force is, for example, a method of forming the bending portion 67b and the fixing unit 61b by magnetic materials and fixing the bending portion 67b and the fixing unit 61b to each other using magnets.

The trailing end leader 68 has basically the same configuration as the leading end leader 67 described above. As shown in Fig. 17, the trailing end leader 68 has a long base 68a and a bending portion 68b provided at each end of the base 68a in a longitudinal direction. A plurality of attaching portions 68c are provided at the base 68a with gaps at equal intervals along the longitudinal direction. The pin 68d is provided for each of the attaching portions 68c. The pin 68d is passed through the flexographic printing plate precursor 70, and the flexographic printing plate precursor 70 is fixed to the trailing end leader 68. In this case, in order to prevent the flexographic printing plate precursor 70 from moving during transporting, it is preferable that the base 68a and the trailing end of the flexographic printing plate precursor 70 are aligned and fixed. As described above, the pins 67d and 68d are fixing members fixing the flexographic printing plate precursor.

The bending portion 68b of the trailing end leader 68 is fixed to the fixing unit 61b of the transport chain 61, and the trailing end leader 68 is fixed to the transport chain 61. A method of fixing the trailing end leader 68 to the transport chain 61 is not particularly limited, and the trailing end leader is fixed to the transport chain through at least one method of fixing methods using hooking, screwing, sandwiching, or a magnetic force, like the leading end leader 67.

Since the leading end leader 67 is on the traveling direction side, a force acts in a direction in which the fixing unit 61b presses the bending portion 67b of the leading end leader 67 even in a case of being hooked. In order to make a force act in the direction in which the bending portion 67b is pressed, it is necessary to hook the bending portion 68b of the trailing end leader 68 in an opposite direction to the leading end leader 67. For this reason, fixing methods using screwing, sandwiching, and a magnetic force, which allow fixing in states of Figs. 16 and 19, are preferable for the trailing end leader 68.

In addition, transporting tension fluctuates in some cases due to fluctuations of transporting during transporting. Transporting becomes unstable due to the fluctuations of the transporting tension. In addition, the flexographic printing plate precursor 70 expands and contracts in some cases due to the transporting tension during transporting. For this reason, it is preferable to prevent the fluctuations of the transporting tension and effects of expansion and contraction or the like of the flexographic printing plate precursor 70. Thus, it is preferable for the leader to have a leader mechanism portion 69 that expands and contracts with respect to the traveling direction of the flexographic printing plate precursor 70. The leader mechanism portion 69 can reduce the fluctuations of the transporting tension and the effects of expansion and contraction or the like of the flexographic printing plate precursor 70 by expanding and contracting with respect to the traveling direction of the flexographic printing plate precursor 70.

Since the leading end leader 67 is on the traveling direction side, transporting tension is unlikely to fluctuate, but the transporting tension of the trailing end leader 68 is likely to fluctuate. For this reason, it is preferable for the trailing end leader 68 to have the leader mechanism portion 69 (see Fig. 18).

For example, as shown in Fig. 18, the leader mechanism portion 69 is provided between the base 68a and the flexographic printing plate precursor 70. The leader mechanism portion 69 has a frame material 69a and an elastic member 69b such as a spring and rubber, and the frame material 69a and the base 68a are disposed in parallel with each other and are connected to each other by the elastic member 69b. In a case where the leader mechanism portion 69 is provided, the pin 68d is not provided at the base 68a, and the pin 68d (see Fig. 17) is provided at the frame material 69a. The frame material 69a is fixed to the flexographic printing plate precursor 70.

The leading end leader 67 may be configured to have the leader mechanism portion 69. In this case, the leader mechanism portion 69 is provided at the base 67a.

The plate-making apparatus 10c is not limited to a form in which the leading end leader 67 and the trailing end leader 68 are attached to the one flexographic printing plate precursor 70 as described above, and a plurality of flexographic printing plate precursors may be attached to the leaders. For example, as shown in Fig. 19, a form in which the leading end leader 67 and the trailing end leader 68 are attached to two flexographic printing plate precursors 70 may be adopted. An example in which the two flexographic printing plate precursors 70 are provided as shown in Fig. 19 is merely an example, the flexographic printing plate precursor 70 is not limited to two, a form in which three or more flexographic printing plate precursors 70 are attached may be adopted, and a form in which a plurality of flexographic printing plate precursors 70 are attached as described above can be adopted.

Although the leading end leader 67 and the trailing end leader 68 fix the flexographic printing plate precursor 70 using the pin 67d and the pin 68d respectively, the shapes, numbers, and disposition intervals of the pins 67d and 68d are not particularly limited. It is preferable that the attaching portion 67c provided with the pin 67d and the attaching portion 68c provided with the pin 68d are disposed with a gap from convenience of removing the flexographic printing plate precursor 70. In a case where the pins 67d and 68d fix the flexographic printing plate precursor 70, it is preferable that residues or the like are not generated in order not to contaminate an exposure surface of the flexographic printing plate precursor 70, that is, the front surface 70a or not to contaminate the developer Q in the developing tank 32.

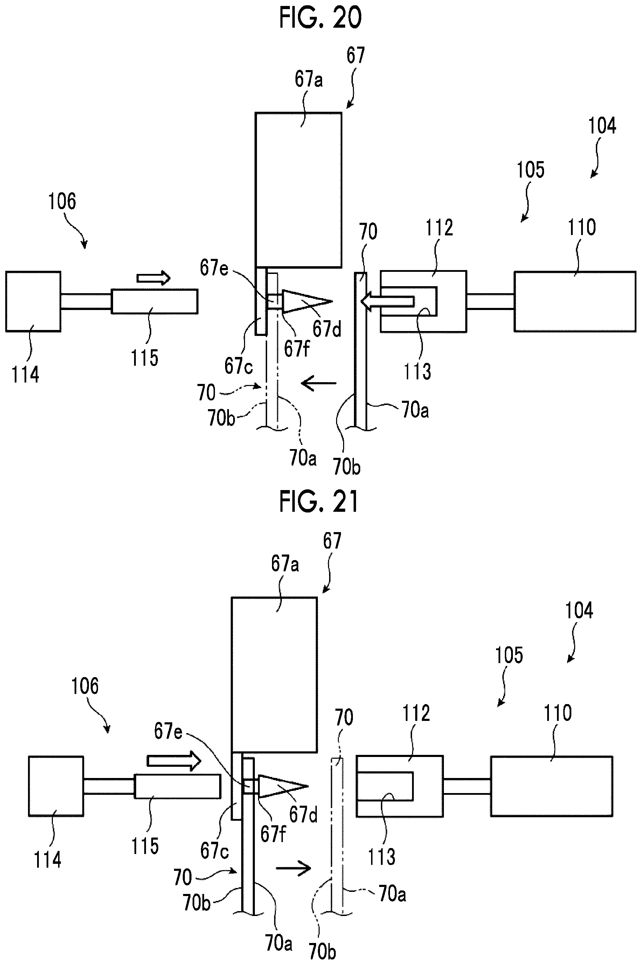

In addition, the pins 67d and 68d have, for example, barbs. Due to the barbs, the flexographic printing plate precursor 70 is unlikely to come off from the pin 67d, and the flexographic printing plate precursor 70 is reliably fixed. For this reason, it is preferable that the pins 67d and 68d have barbs. The barb is a portion in which the pin 67d (see Fig. 20) on a base 67e (see Fig. 20) side as will be described later protrudes from a base 67e. Although the flexographic printing plate precursor 70 is fixed by the base 67e, a barb 67f (see Fig. 20) protrudes from the base 67e, and the movement of the flexographic printing plate precursor 70 to a distal end side of the pin 67d is restricted. In this manner, the barb makes the flexographic printing plate precursor 70 unlikely to come off from the pin 67d.

In addition, it is preferable that surfaces of the pins 67d and 68d brought into contact with the at least flexographic printing plate precursor 70 have a resin layer, a plating layer, or a diamond-like carbon layer (DLC layer) or a plurality of uneven portions are formed on the surfaces brought into contact with the flexographic printing plate precursor 70.

A hard chrome plating layer is preferable as the plating layer. In addition thereto, surface treatment with titanium nitride (TiN) or the like may be performed on the surfaces of the pins 67d and 68d brought into contact with the flexographic printing plate precursor 70. Accordingly, friction between the pins 67d and 68d and the flexographic printing plate precursor 70 is reduced, and the pins 67d and 68d are likely to be passed through the flexographic printing plate precursor 70. Further, the durability of the pins 67d and 68d improves, the pins 67d and 68d can be repeatedly used, and the durability of the leading end leader 67 and the trailing end leader 68 also improves.

The plurality of uneven portions of the surfaces of the pins 67d and 68d brought into contact with the flexographic printing plate precursor 70 are formed through, for example, embossing.

In the plate-making apparatus 10c, the developing portion 12 and the rinsing unit 13 are provided along the transport path Dp for the flexographic printing plate precursor 70. For example, the developing portion 12 is provided in the developing tank 32, and the rinsing unit 13 is provided at an upper portion of the developing tank 32 where the flexographic printing plate precursor 70 that has gone through the developing portion 12 first comes out. The rinsing unit 13 is provided on a downstream side of the developing portion 12 in the traveling direction of the flexographic printing plate precursor 70. Herein, the downstream side is a side in a direction in which the leading end 70c (see Fig. 16) of the flexographic printing plate precursor 70 advances in a case of transporting the flexographic printing plate precursor 70. In addition, downstream is a destination where the leading end 70c (see Fig. 16) advances in the transport direction D of the flexographic printing plate precursor 70. An opposite side of the downstream side is an upstream side.

Further, the plate-making apparatus 10c has a processing unit 52 provided at the developing tank 32 via a connecting pipe 51. In the plate-making apparatus 10c, for example, the flexographic printing plate precursor 70 that has gone through the rinsing unit 13 is taken out. A position where the flexographic printing plate precursor 70 in the plate-making apparatus 10c is taken out is not particularly limited.

(Transporting Unit)

In the transporting unit 11, the gear 60 is rotated by the transport driving unit 62, and the flexographic printing plate precursor 70 fixed to the transport chain 61 using the leading end leader 67 and the trailing end leader 68 moves in the vicinity of the frame 50. The transport path Dp for the flexographic printing plate precursor 70 is a path for going around the vicinity of the frame 50 and has the curved transport passage Dpc and the linear transport passage Dps.

In the plate-making apparatus 10c, for example, after one time of development, processing by the rinsing unit 13 is performed and ended. The rinsing step is performed after the developing step of performing development. However, development is not limited to one time, and the flexographic printing plate precursor may go around the vicinity of the frame 50 a plurality of times in order to perform development a plurality of times.

Although there are various transport paths such as a one-direction transport path, a reciprocating transport path, and a go-around transport path as the transport path Dp for the flexographic printing plate precursor 70, it is preferable that the transport path Dp for the flexographic printing plate precursor 70 is the one-direction transport path or the go-around transport path since processing by the rinsing unit 13 is necessary after development.

(Attachment and Detachment Unit of Flexographic Printing Plate Precursor)

Fig. 20 is a schematic view showing an example of attachment of the flexographic printing plate precursor by a detachment and attachment unit of the third example of the plate-making apparatus according to the embodiment of the present invention, and Fig. 21 is a schematic view showing an example of removal of the flexographic printing plate precursor by the detachment and attachment unit of the third example of the plate-making apparatus according to the embodiment of the present invention. In Figs. 20 and 21, the same components as the plate-making apparatus 10c shown in Figs. 13 to 15 will be assigned with the same reference numerals, and detailed description thereof will be omitted.

The attachment and detachment unit 104 fixes the flexographic printing plate precursor 70 to the leading end leader 67 and the trailing end leader 68 and releases the fixing. The attachment and detachment unit 104 has the plate attachment portion 105 and the plate detachment portion 106 as described above. The plate attachment portion 105 is provided for each pin, and it is preferable that the leading end leader 67 and the trailing end leader 68 have the same number of pins. For this reason, in a case where there are a plurality of pins, a plurality of attachment and detachment units 104 are also provided according to the number of pins. In addition, the plate detachment portion 106 presses a region of the flexographic printing plate precursor 70, which is not fixed to the pin to remove the flexographic printing plate precursor 70, and is preferably provided between pins, that is, between the attaching portions. For this reason, a plurality of plate detachment portions 106 are provided according to the number of a space between the attaching portions.

Since the leading end leader 67 and the trailing end leader 68 basically have the same configuration as described above, the leading end leader 67 will be described as an example, and the same applies to the trailing end leader 68 as well.

The plate attachment portion 105 shown in Fig. 20 has a driving unit 110 and a pushing portion 112. The pushing portion 112 has a concave portion 113. Since the pin 67d is fitted to the concave portion 113, it is preferable that the inner diameter of the concave portion 113 is larger than the maximum outer diameter of the pin 67d. Accordingly, the pin 67d can be more reliably passed through the flexographic printing plate precursor 70.

Insofar as the driving unit 110 can move the pushing portion 112 from a first position toward the pin 67d and restore to the first position, a configuration thereof is not particularly limited, and for example, an air cylinder is used. The first position is a position where the pushing portion 112 is provided, and the first position is also referred to as an initial position.

Since the pushing portion 112 causes the pin 67d to pass through the flexographic printing plate precursor 70, it is preferable that the pushing portion has strength so as not to deform and is formed of, for example, a metal.

Martensite-based stainless steel that is resistant to abrasion in a case of forming a hole in the flexographic printing plate precursor 70 and has hardenability is preferable for the pushing portion 112 among various types of stainless steel which is unlikely to rust. Martensite-based stainless steel corresponds to original brand stainless steel developed for a cutting tool by a material manufacturer, stainless steel (SUS)410, SUS420J1, SUS420J2, and the like. In addition, carbon tool steel, alloy tool steel, high-speed tool steel, and super steel may be used as the pushing portion 112.

The flexographic printing plate precursor 70 is disposed with the back surface 70b facing the pin 67d of the leading end leader 67. The pushing portion 112 of the plate attachment portion 105 is disposed on the front surface 70a side of the flexographic printing plate precursor 70.

In a case where the position of the concave portion 113 of the pushing portion 112 and the position of the pin 67d of the leading end leader 67 are aligned and the driving unit 110 pushes out the pushing portion 112 at the first position toward the pin 67d, the flexographic printing plate precursor 70 is pressed toward the pin 67d, the pin 67d is passed through the flexographic printing plate precursor 70, and the flexographic printing plate precursor 70 is fixed to the leading end leader 67. In this case, the pin 67d is fitted into the concave portion 113. The driving unit 110 restores the pushing portion 112 to the first position.

The pin 67d has, for example, a conical shape, and on a conical bottom surface, the base 67e having a diameter smaller than the conical bottom surface is provided. The base 67e and the attaching portion 67c are connected to each other. For example, the length of the base 67e is approximately the same as the thickness of the flexographic printing plate precursor 70. The base 67e side of the pin 67d protrudes from the base 67e, and the pin has the barb 67f. The barb 67f is a portion where the base 67e side of the pin 67d protrudes from the base 67e. In a case where the pin 67d passes through the flexographic printing plate precursor 70 as described above, the flexographic printing plate precursor is unlikely to come off from the pin 67d and is reliably fixed due to the barb 67f.

The plate detachment portion 106 is provided in, for example, a space 50c between the two beam members 50b of the frame 50 shown in Fig. 15. The plate detachment portion 106 shown in Fig. 21 has a driving unit 114 and an extrusion portion 115. The extrusion portion 115 has a tubular member. The extrusion portion 115 is disposed in a region where there is no attaching portion 67c of the leading end leader 67 (see Fig. 17).

Insofar as the driving unit 114 can cause the extrusion portion 115 to protrude from the first position toward the back surface 70b of the flexographic printing plate precursor 70, press the flexographic printing plate precursor 70 to remove the pin 67d, and restore to the first position, a configuration thereof is not particularly limited, and for example, an air cylinder is used.

Since the extrusion portion 115 presses the flexographic printing plate precursor 70, it is preferable to have strength so as not to deform and is formed of, for example, austenitic stainless steel, such as SUS304 and SUS303, which easily performs cutting or martensite-based stainless steel that can obtain hardness of 50 or more in Rockwell Hardness C scale (HRC) by quenching.

Due to the driving unit 114, the extrusion portion 115 protrudes from the first position in a longitudinal direction of the pin 67d, the back surface 70b of the flexographic printing plate precursor 70 is pressed, and the flexographic printing plate precursor 70 is removed from the pin 67d.

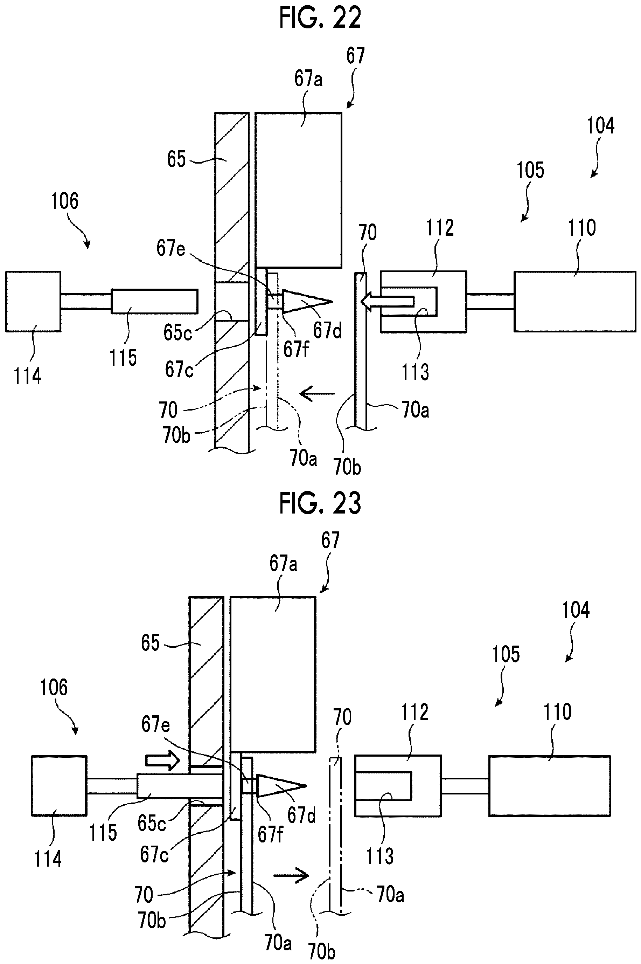

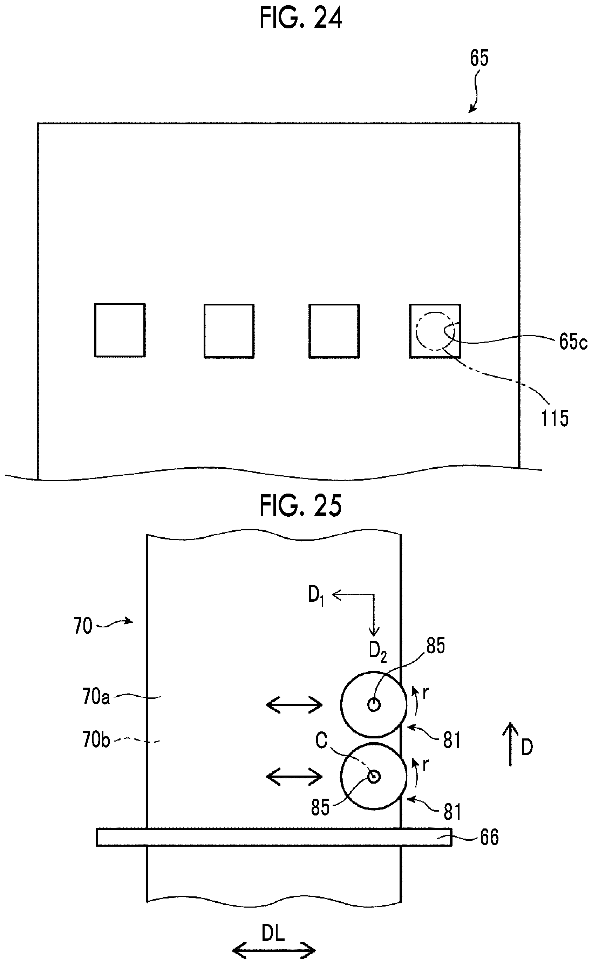

Fig. 22 is a schematic view showing another example of attachment of the flexographic printing plate precursor by the detachment and attachment unit of the third example of the plate-making apparatus according to the embodiment of the present invention, and Fig. 23 is a schematic view showing another example of removal of the flexographic printing plate precursor by the detachment and attachment unit of the third example of the plate-making apparatus according to the embodiment of the present invention. Fig. 24 is a schematic view showing an example of the back plate portion of the plate-making apparatus according to the embodiment of the present invention. In Figs. 22 to 24, the same components as the plate-making apparatus 10c shown in Figs. 13 to 15 will be assigned with the same reference numerals, and detailed description thereof will be omitted.

As shown in Fig. 22, the back plate portion 65 of the leading end leader 67 may be provided on a plate detachment portion 106 side. In a case where the back plate portion 65 pushes out the pushing portion 112 of the plate attachment portion 105 toward the pin 67d, the back plate portion 65 supports the attaching portion 67c of the leading end leader 67. Thus, in a case where the pin 67d is brought into contact with the flexographic printing plate precursor 70, the attaching portion 67c is stably prevented from being displaced, the pin 67d passes through the flexographic printing plate precursor 70, and the flexographic printing plate precursor 70 is more reliably fixed to the leading end leader 67.

In addition, in a case where the back plate portion 65 is provided as shown in Fig. 23, an opening portion 65c is provided in the back plate portion 65 corresponding to a region where there is no attaching portion 67c of the leading end leader 67 as shown in Fig. 24. The plate detachment portion 106 is disposed such that the extrusion portion 115 passes through the opening portion 65c.

(Developing Portion)

Insofar as the non-exposed portion (not shown) of the flexographic printing plate precursor 70 can be removed and developed, the configuration of the developing portion 12 is not particularly limited and is not limited to development using the brush 81 to be described later. The configuration of the brush is also not particularly limited, and a rotary brush and a brush having a rotation axis parallel to the nip roller 66 can also be used in addition to the configuration of the brush 81 to be described later. In this case, a roller-shaped brush in which bristles are bundled radially with respect to a rotation axis can be used. In the developing portion 12, the configuration of the brush, the number of brushes, and the like are not particularly limited.

For example, the developing portion 12 has a developing unit 80 that performs development on the flexographic printing plate precursor 70 which is in a state of being immersed in the developer Q in the developing tank 32 and is transported.

In the developing portion 12, a fatigued developer Qw is generated in the developing tank 32 due to development by the developing unit 80. The fatigued developer Qw is the developer Q containing solid substances generated by removing the non-exposed portion (not shown) of the flexographic printing plate precursor 70 due to development using the developer Q. The developing portion 12 performs development, for example, using the developer Q stored in the developing tank 32.

The flexographic printing plate precursor in a state where the non-exposed portion is removed due to development is called a developed flexographic printing plate precursor.

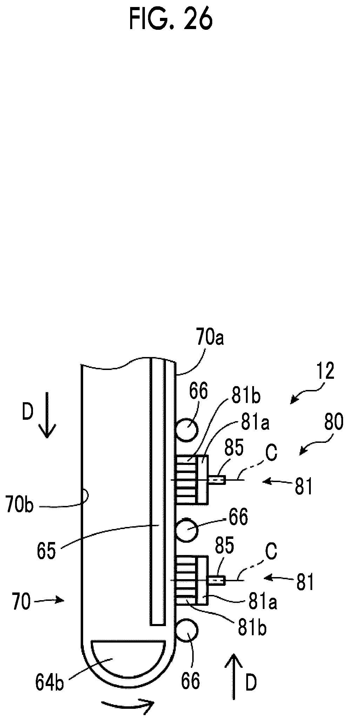

Herein, Fig. 25 is a schematic plan view showing an example of the developing portion of the plate-making apparatus according to the embodiment of the present invention, and Fig. 26 is a schematic side view showing the example of the developing portion of the plate-making apparatus according to the embodiment of the present invention. A part of the nip roller 66 is not shown in Fig. 25.

The developing unit 80 of the developing portion 12 has the brush 81 used in development and a driving unit 27 (see Fig. 13) that controls rotation about a rotation axis C (see Fig. 26) of the brush 81 and movement of the brush 81. In the configuration of the developing unit 80 shown in Fig. 25, there are two brushes 81.

In the developing unit 80, development can be simultaneously performed by the two brushes 81. Accordingly, an area rubbed by the brushes 81 can be increased, and a development speed can be increased in a state where the adhesion of development residues is prevented and development uniformity is maintained. In this case, the rotation speeds of the plurality of brushes 81 may be the same, or the rotation speed may be changed for each of the plurality of brushes 81. In addition, the sizes of the two brushes 81 may be the same or may be different from each other.

In a case where a plurality of brushes are provided, for example, at least two brushes may be simultaneously driven by one motor instead of rotating each brush. In a case of the two brushes 81, the at least two brushes 81 may be simultaneously driven by one motor instead of rotating each brush 81. Accordingly, the number of motors can be reduced, and thus the device can be miniaturized. In addition, in a case where the plurality of brushes are rotated by one motor, the rotation speed can be changed for each brush 81 by providing a transmission. Accordingly, the number of motors can be reduced, and thus the device can be miniaturized. In addition, in a case where the plurality of brushes are rotated by one motor, the rotation speed can be changed for each brush 81 by providing a transmission.

The rotation about the rotation axis C of the brush 81 described above is rotation of the brush 81 with the rotation axis C as a rotation center, and the brush 81 spins. The rotation axis C is a fixed axis passing through one point in the brush 81. A rotation shaft portion 85 is provided at the brush 81, and a central axis of the rotation shaft portion 85 is the rotation axis C. The rotation shaft portion 85 functions as a rotation drive shaft that is rotated as power is transmitted from the driving unit 27, and the brush 81 spins, for example, in a rotation direction r as the rotation shaft portion 85 is rotated.

The driving unit 27 rotates the brush 81 in a state where the rotation axis C of the brush 81 passes through the front surface 70a of the flexographic printing plate precursor 70 (see Fig. 26). The driving unit 27 moves the rotation axis C of the brush 81 in at least one direction intersecting the rotation axis C. The rotation of the brush 81 and the movement of the brush 81 are controlled by the driving unit 27 unless stated otherwise.

As shown in Fig. 25, the brush 81 is disposed on the front surface 70a side of the flexographic printing plate precursor 70, and for example, the direction DL orthogonal to the transport direction D is set as a first moving direction Di of the brush 81, which intersects the rotation axis C. The brush 81 is configured to move in the direction DL. In addition, the brush 81 may be configured to be moved in two directions with respect to the rotation axis C. In a case of being moved in two directions, the two directions are not particularly limited insofar as the brush is moved in two directions, may be two directions intersecting the rotation axis C, or may be two directions orthogonal to the rotation axis C. Specifically, for example, the first moving direction Di is the direction DL, and a second moving direction $D_2$ is the transport direction D. Insofar as the brush 81 can uniformly rub the entire front surface 70a of the flexographic printing plate precursor 70, the moving directions of the brush 81 are not particularly limited. Insofar as the brush 81 is configured to be moved in the two directions orthogonal to each other, the entire front surface 70a of the flexographic printing plate precursor 70 can be uniformly rubbed by the brush 81, and development uniformity improves. Further, the development speed also improves by moving the brush 81 in the two directions orthogonal to each other.

In addition, although a configuration where two brushes 81 are provided is adopted, without being limited thereto, there may be one brush 81. In this case, for example, with the first moving direction Di set as the direction DL and the second moving direction $D_2$ set as the transport direction D, the brush 81 is configured to be moved in two directions orthogonal to the rotation axis C. However, the brush may be configured to be moved only in the first moving direction Di, that is, the direction DL.

<Brush>

The brush 81 removes and develops the non-exposed portion (not shown) of the flexographic printing plate precursor 70. For example, the brush 81 is immersed in the developer Q and is disposed on the front surface 70a side of the flexographic printing plate precursor 70 in the transport direction D in the developing tank 32. In a state where the flexographic printing plate precursor 70 is transported, the front surface 70a of the flexographic printing plate precursor 70 is rubbed as the brush 81 is rotated in the rotation direction r (see Fig. 25) by the driving unit 27, and development is performed by removing the non-exposed portion (not shown) of the flexographic printing plate precursor 70. During the development, the fatigued developer Qw described above is generated.

Since the brush 81 is disposed by being immersed in the developer Q, the developer Q adhered to the brush 81 is not dried, and the non-exposed portion or the like removed by the brush 81 is prevented from being fixed to the brush 81 as development residues.

A brush described in paragraphs [0027] to [0040] of WO2020//158380A can be used as the brush 81.

The area of the brush 81, which is obtained by projecting the brush 81 onto the front surface 70a of the flexographic printing plate precursor 70, is smaller than the area of the front surface 70a of the flexographic printing plate precursor 70. For this reason, the brush 81 is partially applied with respect to the entire width of the flexographic printing plate precursor 70 and performs development. During development, since the brush 81 is small, the brush 81 moves, for example, in the transport direction D and the direction DL as described above in order for the brush 81 to uniformly rub the entire front surface 70a of the flexographic printing plate precursor 70, but may be configured to move only in the direction DL. The brush 81 is moved and performs development on the flexographic printing plate precursor 70, the pressure of the brush 81 can be made uniform, and development uniformity can be improved.

Further, since a brush area necessary for development can be reduced as the brush 81 performs development by moving in a plane direction while the flexographic printing plate precursor 70 is transported, the plate-making apparatus 10c can be simplified.

The size of the brush 81 is not particularly limited insofar as the brush is smaller than the flexographic printing plate precursor 70. In a case where the outer shape of a substrate 81a of the brush 81 is circular, the diameter thereof is preferably 30 mm to 500 mm, the diameter is more preferably 100 to 400 mm, and the diameter is most preferably 200 to 400 mm.

In a case where the shape of the substrate 81a of the brush 81 is a brush shape other than a circle, a diameter equivalent to the circle, that is, a diameter corresponding to the brush area is used as the diameter in a case where the outer shape of the substrate 81a described above is circular.

A moving path of the brush 81 is determined in advance according to the size of the brush 81, the size and the transportation speed of the flexographic printing plate precursor 70, or the like. Accordingly, the moving path of the brush 81 is programmed in the driving unit 27, and the driving unit 27 can move the brush 81 along the moving path to perform development based on the program.

As shown in Fig. 26, the brush 81 is obtained, for example, by bundling bristles 81b perpendicular to the substrate 81a. For example, a brush called a cup brush is used as the brush 81.

In addition, the brush 81 rotates and performs development, but the rotation speed of the brush 81 is preferably 10 revolutions per minute (rpm) to 2,000 rpm, more preferably 20 to 800 rpm, and even more preferably 30 to 200 rpm.

By increasing the number of rotations of the brush 81 and increasing the rotation speed, the development speed can be increased as described above, and development uniformity also improves.

During development, development residues are estimated to be adhered inside the brush 81. In a case where the rotation speed of the brush 81 is high, the developer Q in the brush 81 is likely to be discharged to the outside of the brush 81 due to rotation, and development residues in the brush 81 can be efficiently discharged to the outside of the brush 81.

In addition, the rotation speed of the brush 81 may be variable, in this case, for example, the rotation speed is determined in advance from the initial stage of development to the end of development, and development can be performed at the determined rotation speed.

In addition, the material for the bristles 81b of the brush 81 is not particularly limited. For example, natural fibers, such as coir, and any material that can be made into a fibrous form, such as a metal, polyamide, polyester, vinyl chloride, vinylidene chloride, polyimide, and polyacrylonitrile, are suitably used.

The length of each of the bristles may vary in one brush 81, and it is preferable that bristles in a central portion are long. In addition, the thickness of each of the bristles in one brush 81 may vary, or the density of the bristles in one brush 81 may vary.

As described above, the driving unit 27 (see Fig. 13) rotates the brush 81 in a state where the rotation axis C of the brush 81 passes through the front surface 70a of the flexographic printing plate precursor 70. It is most preferable that the rotation axis C of the brush 81 is perpendicular to the front surface 70a of the flexographic printing plate precursor 70. In this case, the brush 81 can be uniformly brought into contact with the front surface 70a of the flexographic printing plate precursor 70, and development can be performed even in a case where the pressure of the brush 81 is increased. For this reason, both of the development uniformity and the development speed can be increased.

The position of the brush 81 with respect to the front surface 70a of the flexographic printing plate precursor 70 may be fixed. In addition, a configuration where the brush approaches or is spaced apart from the front surface 70a of the flexographic printing plate precursor 70 may be adopted. As the brush 81 can approach or be spaced apart from the front surface 70a of the flexographic printing plate precursor 70, the pressure of the brush 81 can be adjusted with respect to the front surface 70a of the flexographic printing plate precursor 70. Accordingly, the pressure of the brush 81 can be increased, and the development speed can be improved.

In addition, as the brush 81 can be spaced apart from the front surface 70a of the flexographic printing plate precursor 70, the brush 81 can be lifted from the front surface 70a of the flexographic printing plate precursor 70. Accordingly, in a case where development residues of the brush 81 are adhered, the development residues can be removed from the brush 81.

As for the operation of the brush 81, the brush 81 may move constantly during development, or the brush 81 may rotate only in a case where the flexographic printing plate precursor 70 is transported to the developing tank 32. In this case, for example, a sensor (not shown) that detects the flexographic printing plate precursor 70 is provided above the developing tank 32, a time when the brush 81 is reached is identified using a transport timing and the transportation speed of the flexographic printing plate precursor 70, and development can be performed by rotating the brush 81.

In addition, for example, the outside of the flexographic printing plate precursor 70 and the upper side of the front surface 70a of the flexographic printing plate precursor 70 can be used as a retracting place for the brush 81. The driving unit 27 moves the brush 81 to the retracting place, and the driving unit 27 causes the brush 81 to retract from the flexographic printing plate precursor 70. By retracting the brush 81 from the flexographic printing plate precursor 70, development residues are prevented from adhering, which is preferable.

In a case where the retracting place is outside the flexographic printing plate precursor 70, the development residues are unlikely to adhere to the front surface 70a of the flexographic printing plate precursor 70 again, and the development residues can be further prevented from adhering compared to a case where the brush 81 is retracted by being simply lifted from the front surface 70a of the flexographic printing plate precursor 70.

In a case of removing the development residues, in addition to moving the brush 81 to the retracting place, retracting conditions such as a development time and a development treatment area are set, and in a case where the retracting conditions are satisfied, the brush 81 may be configured to be moved to the retracting place. In this case, for example, the sensor (not shown) that detects the flexographic printing plate precursor 70 is provided above the developing tank 32, the retracting conditions are set in the driving unit 27, the input amount of the flexographic printing plate precursor 70 is identified using the transport timing and the transportation speed of the flexographic printing plate precursor 70, and the retraction of the brush 81 can be controlled.

In addition, in order to efficiently discharge the development residues in the brush 81 to the outside of the brush 81, the developer may be supplied to the brush 81 at the retracting place for the brush 81, and the development residues may be discharged to the outside of the brush 81.

(Rinsing Unit)

The rinsing unit 13 removes residues, such as latex components and rubber components remaining on the front surface 70a of the developed flexographic printing plate precursor 70 taken out from the developing portion 12, using a rinsing liquid such as a developer. Removing residues, such as latex components and rubber components remaining on the front surface 70a of the flexographic printing plate precursor 70, using a rinsing liquid such as a developer, by the rinsing unit 13 is called a rinsing step.

The developed flexographic printing plate precursor 70 is transported from the developing portion 12, is transported to the outside of the developing tank 32, and is processed by the rinsing unit 13.

The rinsing unit 13 has, for example, a supply nozzle 44 that supplies the fatigued developer Qw processed by the processing unit 52 to the front surface 70a of the flexographic printing plate precursor 70. The fatigued developer Qw processed by the processing unit 52 is supplied to the supply nozzle 44 via a pipe 54. The supply nozzle 44 is a nozzle that is for at least supplying the developer Q to the front surface 70a of the flexographic printing plate precursor 70, from which the non-exposed portion of the flexographic printing plate precursor 70 is removed. The rinsing liquid may be water other than the developer and the fatigued developer Qw described above. The processed the fatigued developer Qw is a regenerated developer as will be described later.

It is preferable for the supply nozzle 44 to have a jetting type spray nozzle. The type of jetting type spray nozzle is not particularly limited and may be, for example, one-fluid type using only a liquid or may be two-fluid type using a liquid and air.

The rinsing unit 13 applies, as the developer Q from the supply nozzle 44, the fatigued developer Qw processed by the processing unit 52, for example, to the front surface 70a of the developed flexographic printing plate precursor 70, for example, in a spray-like manner, washing away the residues described above. The fatigued developer Qw supplied from the supply nozzle 44 and the residues, which are washed away and are described above, accumulate in the developing tank 32.

It is preferable that the rinsing unit 13 is provided such that the rinsing liquid is supplied to a liquid film generated by the developer remaining on the developed flexographic printing plate precursor 70 taken out from the developing portion 12.

For a reason that the liquid film generated by the developer is likely to flow into the developing tank 32 together with the rinsing liquid, a position to which the rinsing liquid is supplied is preferably 50 cm or lower, is more preferably 30 cm or lower, and is even more preferably 15 cm or lower from the liquid level Qs of the developer Q.

As the used rinsing liquid supplied from the rinsing unit 13 flows into the developing tank 32, a total waste liquid amount can be reduced. In particular, in a case where the transport path is in the up-down direction, an effect of reducing the waste liquid amount is large. For this reason, it is preferable that the used rinsing liquid flows into the developing tank 32 also in the rinsing step.

The rinsing liquid supply amount of the rinsing liquid supplied for each unit area of the flexographic printing plate precursor to which the rinsing liquid is supplied is preferably sprayed at 0.3 to 7 kg/m$^2$ and more preferably at 0.5 to 4 kg/m$^2$. As the rinsing liquid supply amount described above is set to 0.3 kg/m$^2$ or more, the residues described above, which remain on the front surface 70a of the developed flexographic printing plate precursor 70, can be stably washed away. On the other hand, as the rinsing liquid supply amount described above is set to 7 kg/m$^2$ or less, the inflow amount of rinsing liquid into the developing tank 32 is reduced, and the waste liquid amount can be reduced.

As the rinsing liquid, the developer Q to be supplied may be the developer Q newly prepared in another tank (not shown). In this case, as shown in Fig. 13, a supply pipe 40a is connected to the pipe 54, and a valve 40b is provided at the supply pipe 40a and is connected to the rinsing liquid supply unit 40. The rinsing liquid supply unit 40 stores the developer Q and supplies the developer Q to the supply nozzle 44 at a specific flow rate.

During the rinsing step, the rinsing liquid is supplied from the rinsing liquid supply unit 40 to the supply nozzle 44 via the valve 40b and the supply pipe 40a.

Since the rinsing unit 13 can supply the developer Q or water as the rinsing liquid as described above, the rinsing unit 13 can also be configured to be used as the supply unit 16. Accordingly, the device configuration can be simplified.

(Processing Unit)

The processing unit 52 removes solid substances 55 in the fatigued developer Qw containing the solid substances 55 generated by removing the non-exposed portion due to development using the developer Q. The fact that the fatigued developer Qw contains the solid substances 55 means a state where the solid substances 55 are dissolved or dispersed. The solid substances 55 contain the sensitizer components described above.

In addition, the processed fatigued developer Qw is the fatigued developer Qw from which the solid substances 55 contained in the fatigued developer Qw are removed.

The solid substances 55 removed by the processing unit 52 from the fatigued developer Qw are collected by a saucer 53 provided below the processing unit 52.

On the other hand, the fatigued developer Qw from which the solid substances 55 are removed, that is, the processed fatigued developer Qw described above is supplied to the supply nozzle 44 through the pipe 54 and is used in the rinsing unit 13. For example, a pump (not shown) is used to supply the processed fatigued developer Qw from the processing unit 52 to the supply nozzle 44.

Since the fatigued developer Qw can be reused by providing the processing unit 52, the developer Q can be effectively used, and the using efficiency of the developer Q can be increased.

The configuration of the processing unit 52 is not particularly limited insofar as the solid substances 55 can be removed from the fatigued developer Qw as described above, and the processing unit is composed of, for example, a centrifuge.

In addition, a separation membrane 56 that removes the solid substances 55 in the fatigued developer Qw may be provided in the pipe 54. The separation membrane 56 is not particularly limited insofar as the solid substances contained in the fatigued developer Qw can be separated out and is determined as appropriate according to the size of a solid substance to be separated out. For example, a ceramic filter is used. The filter 23 (see Fig. 1) described above can be used as the separation membrane 56. It is preferable that the separation membrane 56 can separate out, for example, a solid substance having a particle diameter of 1 μm or less.

The separation membrane 56 is not necessarily required, and a configuration where the separation membrane is not provided may be adopted. However, causing the fatigued developer Qw to pass through the separation membrane 56 can further decrease the concentration of solid substances of the fatigued developer Qw supplied to the rinsing unit 13 and is preferable since the rinsing unit 13 can use the fatigued developer Qw having a low concentration of solid substances. By passing the fatigued developer Qw through the separation membrane 56, a regenerated developer is obtained as described above.

In addition, the separation membrane 56 may be configured to be used as the processing unit 52. In this case, for example, only the separation membrane 56 is provided without providing the centrifuge described above.

The processing unit 52 is not necessarily required, and a configuration where there is no processing unit 52 may be adopted. In this case, for example, the rinsing unit 13 uses the developer Q.

Herein, the higher the concentration of solid substances contained in the fatigued developer Qw, the more development residues are fixed, which is more likely to contaminate the device. Therefore, the lower the concentration of solid substances in the fatigued developer Qw, the better maintainability, since the contamination of the device can be prevented. For this reason, it is preferable to provide the processing unit 52 that removes solid substances.

(Plate-Making Method)

Next, the plate-making method of the flexographic printing plate precursor 70, in which the plate-making apparatus 10c is used, will be described.

First, the front surface 70a of the flexographic printing plate precursor 70 is imagewise exposed, that is, exposed in a specific pattern by the exposure device (not shown).

In the plate-making apparatus 10c, for example, the leading end leader 67 is fixed by being hooked or the like to the fixing units 61b of the pair of transport chains 61 respectively. For example, the trailing end leader 68 is fixed to the fixing units 61b of the transport chains 61 using a magnet. Accordingly, the leading end leader 67 and the trailing end leader 68 are transported in the transport passage by the transporting unit 11.

Next, for example, an operator (not shown) disposes the imagewise exposed flexographic printing plate precursor 70 in the feeding device 100. In this case, the leading end leader 67 is disposed at the attachment and detachment station $E_m$, and the pin 67d of the leading end leader 67 and the pushing portion 112 of the plate attachment portion 105 face each other at the attachment and detachment station $E_m$. The position of the leading end leader 67 is detected by the sensor 103, and the position is adjusted by the transport driving unit 62.

The flexographic printing plate precursor 70 is fed from the feeding device 100 toward the leading end leader 67 via the guide 101.

Next, in the plate attachment portion 105, the driving unit 110 moves the pushing portion 112 toward the pin 67d, the pushing portion 112 is pushed from the front surface 70a side of the flexographic printing plate precursor 70 to the pin 67d, and the pin 67d is passed through the flexographic printing plate precursor 70. Accordingly, the flexographic printing plate precursor 70 is fixed to the leading end leader 67.

Next, after fixing the flexographic printing plate precursor 70 to the leading end leader 67, the turn bar 64a shown in Fig. 13 is lowered, the leading end leader 67 is moved by the transport driving unit 62, and the trailing end leader 68 is moved to a position where the pin 68d faces the pushing portion 112. In this case, the trailing end leader 68 is detected by the sensor 102.

In a state where the turn bar 64a is lowered, in the flexographic printing plate precursor 70, the transport path is shorter than the transport chain 61 in a portion where there is no turn bar 64a, and a so-called short pass state is caused. In this state, the tension of the flexographic printing plate precursor 70 is low, and the detachment and attachment of the flexographic printing plate precursor 70 with respect to the trailing end leader 68 can be easily performed.

Next, in the plate attachment portion 105, the driving unit 110 moves the pushing portion 112 toward the pin 68d, the pushing portion 112 is pushed from the front surface 70a side of the flexographic printing plate precursor 70 to the pin 68d, and the pin 68d is passed through the flexographic printing plate precursor 70. Accordingly, the flexographic printing plate precursor 70 is fixed to the trailing end leader 68. In this manner, the leading end of the flexographic printing plate precursor 70 is fixed to the leading end leader 67, and the trailing end is fixed to the trailing end leader 68. In a state where the flexographic printing plate precursor 70 is fixed to the leading end leader 67 and the trailing end leader 68, the turn bar 64a shown in Fig. 13 is raised from a lowered state, and tension is applied to the flexographic printing plate precursor 70. As described above, the flexographic printing plate precursor 70 is fixed to the leaders, and a force acts in the direction in which the length of the flexographic printing plate precursor 70 extends in a state where the flexographic printing plate precursor 70 is fixed to the leaders. After fixing the flexographic printing plate precursor 70, tension applied to the flexographic printing plate precursor 70 is made higher than tension applied to the flexographic printing plate precursor 70 in a case of fixing the flexographic printing plate precursor 70 to the leaders shown in Fig. 13.

Next, the flexographic printing plate precursor 70 is transported along the transport path Dp by the transporting unit 11. In a state where the flexographic printing plate precursor 70 is immersed in the developer Q and is transported, the brush 81 of the developing unit 80 removes and develops the non-exposed portion of the flexographic printing plate precursor 70 as described above. In a development step of performing the development, while transporting the flexographic printing plate precursor 70, for example, the brush 81 is rotated in a state where the rotation axes C of the two brushes 81 pass through the front surface 70a of the flexographic printing plate precursor 70, and the rotation axes C of the brushes 81 are moved in at least one direction intersecting the rotation axes C as described above. Since the operations of the brushes 81 are as described above, detailed description thereof will be omitted. In the developing step, the fatigued developer Qw is generated.

Then, the flexographic printing plate precursor 70 comes out of the developing tank 32. In a state where the flexographic printing plate precursor 70 is transported, the supply nozzle 44 applies, for example, the fatigued developer Qw processed by the processing unit 52 to the front surface 70a of the flexographic printing plate precursor 70, and residues on the front surface 70a are removed. In this manner, the rinsing step is performed. Then, the flexographic printing plate precursor 70 is transported until the flexographic printing plate precursor passes through the rinsing unit 13. In a case of performing development once, at this time point, the fixing of the leading end leader 67 and the trailing end leader 68 is released as will be described later, and the flexographic printing plate precursor 70 is removed from the leading end leader 67 and the trailing end leader 68. In a case of performing development a plurality of times, the flexographic printing plate precursor 70 is transported by going around and is transported to the developing portion 12 again to perform development. Until a predetermined number of times is reached, the developing step and the rinsing step are performed repeatedly.

For example, after the developing step and the rinsing step end, the trailing end leader 68 is moved to the attachment and detachment station $E_m$ for the flexographic printing plate precursor 70. At the plate detachment portion 106, due to the driving unit 114, the extrusion portion 115 disposed in the region where the attaching portion 68c is not provided protrudes from the first position in the longitudinal direction of the pin 68d, the back surface 70b of the flexographic printing plate precursor 70 is pressed, and the flexographic printing plate precursor 70 is removed from the pin 68d. Accordingly, the fixing is released, and the flexographic printing plate precursor 70 is removed from the trailing end leader 68.

Next, the turn bar 64a is lowered, and the tension of the flexographic printing plate precursor 70 is decreased. In this case, as described above, the flexographic printing plate precursor 70 is a so-called short pass. In this state, the tension of the flexographic printing plate precursor 70 is low.

Next, the flexographic printing plate precursor 70 is pressed by the extrusion portion 115 and is guided by the guide 101. Then, the extrusion portion 115 is restored to the first position.

Next, the transport driving unit 62 drives the transport chain 61 to move the leading end leader 67 in an opposite direction to the transport direction D, and the flexographic printing plate precursor 70 is carried to the conveyor belt 100c of the feeding device 100. Next, the drive roller 100a is rotated to rotationally move the conveyor belt 100c, and the flexographic printing plate precursor 70 is placed on the conveyor belt 100c. In a case where the leading end leader 67 is moved to the attachment and detachment station $E_m$ shown in Fig. 14, the driving of the transport chain 61 is stopped. The movement of the leading end leader 67 to the attachment and detachment station $E_m$ is detected by the sensor 103.

At the plate detachment portion 106, due to the driving unit 114, the extrusion portion 115 disposed in the region where the attaching portion 67c is not provided protrudes from the first position in the longitudinal direction of the pin 67d, the back surface 70b of the flexographic printing plate precursor 70 is pressed, and the flexographic printing plate precursor 70 is removed from the pin 67d. Accordingly, the fixing is released, the flexographic printing plate precursor 70 is removed from the leading end leader 67, the conveyor belt 100c of the feeding device 100 is moved rotationally, and the flexographic printing plate precursor 70 is placed on the conveyor belt 100c. For example, the operator (not shown) collects the development-treated flexographic printing plate precursor 70 on the conveyor belt 100c.

In the plate-making apparatus 10c, for example, after development, a determined number of flexographic printing plate precursors 70 in advance are sampled in the developer in the developing tank 32 after development treatment, the measuring unit 14 measures the conductivity of the developer Q, and then the conductivity of the developer is obtained. As described above, a relationship between the conductivity of the developer and the concentration of the developer is determined, for example, in advance as shown in Fig. 2.

Next, the calculation unit 15 determines whether or not the conductivity of the developer Q measured by the measuring unit 14 is within the range Rc of Fig. 2 described above. In a case where the conductivity is within the range Rc, the developer is continued to be used.

On the other hand, in a case where the measured conductivity of the developer is out of the range Rc, when the conductivity is lower than the range Rc, the amount of the development replenishing liquid is calculated by the calculation unit 15, and the amount of the development replenishing liquid is used as a replenishment amount. In this case, the amount of the development replenishing liquid corresponding to the replenishment amount is supplied from the development replenishing liquid storage tank 120 to the developer Q in the developing tank 32.

In addition, in a case where the measured conductivity of the developer is out of the range Rc, when the conductivity is higher than the range Rc, the amount of the water is calculated by the calculation unit 15, and the amount of the water is used as a replenishment amount. In this case, the amount of the water corresponding to the replenishment amount is supplied from the water storage tank 122 to the developer Q in the developing tank 32.

Regarding whether to replenish any one of a developer replenishing liquid or water also in the plate-making apparatus 10c, as described above, for example, replenishing the water or the development replenishing liquid may be set in the calculation unit 15, and the replenishment amount of the water or the replenishment amount of the development replenishing liquid may be acquired by the calculation unit 15 such that conductivity becomes a control target value.

In the plate-making apparatus 10c, at least one of the amount of the development replenishing liquid corresponding to the replenishment amount or the amount of the water corresponding to the replenishment amount can also be supplied to the developer Q in the developing tank 32 from other than the development replenishing liquid storage tank 120 or the water storage tank 122, for example, from the rinsing liquid supply unit 40 of the rinsing unit 13 as described above.

By setting the transport path Dp that goes around the vicinity of the frame 50 as in the plate-making apparatus 10c, a provision area can be decreased compared to a transport path through which the flexographic printing plate precursor 70 is transported in one direction.

By changing the sizes of the member 50a and the beam member 50b of the frame 50, it is possible to correspond to the size of the flexographic printing plate precursor 70. Even in a case where the flexographic printing plate precursor 70 is large, the configuration of the plate-making apparatus 10c does not become complicated.

Further, by making the frame 50 in an upright state as shown in Fig. 13 and configuring the flexographic printing plate precursor 70 to be transported perpendicularly to the liquid level of the developer Q in the developing tank 32, a grounding area can be decreased compared to a state where the frame 50 is rotated 90° from the state shown in Fig. 13, and the space can be saved. In addition, even in a case where the transport path Dp is long, without increasing the plate-making apparatus 10c in size, the grounding area can be decreased, and the space can be saved. In a state where the frame 50 is rotated 90° from the state shown in Fig. 13, in a case of development, it is necessary to increase a region immersed in the developer Q, and it is necessary to increase the developing tank 32 as well.

Further, a configuration of being removed from the pins 67d and 68d and not being buckled in a case of removing the flexographic printing plate precursor 70 from the leading end leader 67 and the trailing end leader 68 is adopted. In addition, since an adhesive layer is not used even in a case where the flexographic printing plate precursor 70 is immersed in the developer Q, processing such as development can be stably performed on the flexographic printing plate precursor without being detached.

In a state where the flexographic printing plate precursor 70 is fixed to the leading end leader 67 and the trailing end leader 68 and tension is applied by the tension applying unit, development is performed using the developer while transporting the flexographic printing plate precursor. For this reason, fluctuations in the tension of the flexographic printing plate precursor 70 are prevented, development treatment can be performed in a state where the tension is stable, and processing such as development can be stably performed on the flexographic printing plate precursor.

By providing the leader mechanism portion 69 that expands and contracts in the traveling direction of the flexographic printing plate precursor 70 shown in Fig. 18, development treatment can be performed in a state where tension is more stable. Accordingly, processing such as development can be more stably performed on the flexographic printing plate precursor.

In the plate-making apparatus 10c, the flexographic printing plate precursor 70 is transported using the transport chain 61, and maintainability is excellent without having a complicated device configuration.

In addition, by performing the developing step in a state where the flexographic printing plate precursor 70 is being transported, the brush can be miniaturized, and washing productivity can be improved. It was necessary for the method of the related art in which the printing plate is fixed and only the brush is movable to prepare a brush having a wide area corresponding to the size of the printing plate, to increase the number of brushes in a case of using a small brush, or to increase the operating range of the brush. In a case where the printing plate precursor is transported, even the small brush can obtain the same processing capacity. Further, it is possible to provide more brushes in the linear transport passage Dps in a treatment liquid (not shown) and the curved transport passage Dpc (turn portion), it is possible to increase the transportation speed of the printing plate precursor since a processing time is shortened by an increase in the number of brushes, and the productivity of the plate-making apparatus 10c increases.

In addition, by developing the flexographic printing plate precursor 70 in the developer Q, development residues are prevented from being fixed to the brush 81, and the frequency of maintenance can be decreased. Accordingly, a maintenance load can be decreased, and the plate-making apparatus 10c is excellent in maintainability.

Since the frequency of maintenance can be decreased, for example, monthly average or annual average development treatment can be increased, and the plate-making apparatus 10c has high productivity from this point as well.

(Fourth Example of Plate-Making Apparatus)

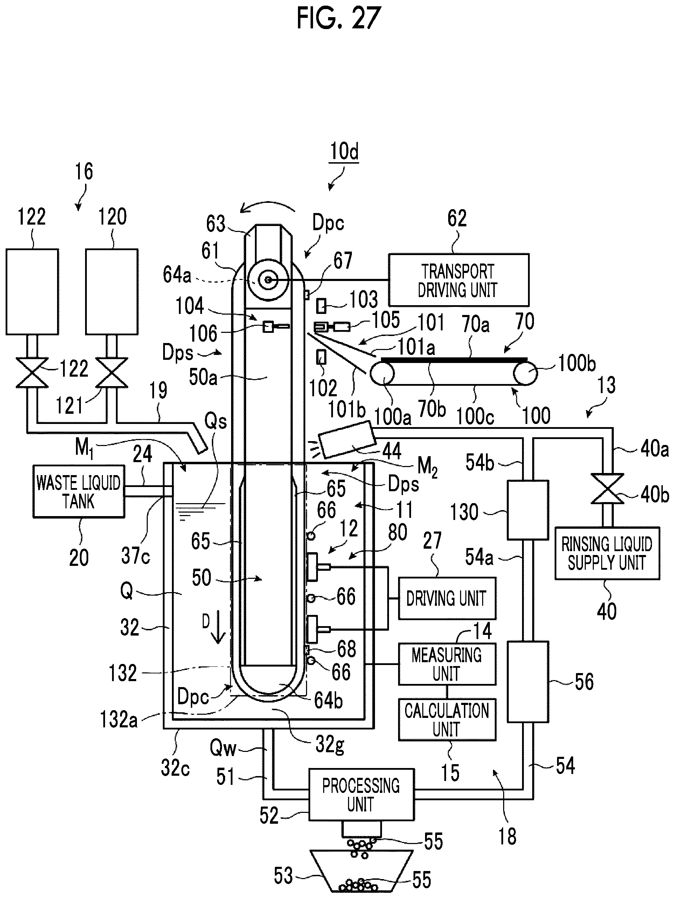

Fig. 27 is a schematic side view showing another example of the plate-making apparatus according to the embodiment of the present invention. In Fig. 27, the same components as the plate-making apparatus 10c shown in Fig. 13 will be assigned with the same reference numerals, and detailed description thereof will be omitted.

A plate-making apparatus 10d shown in Fig. 27 is different from the plate-making apparatus 10c shown in Fig. 13 in that the plate-making apparatus 10d has the heater 130 and a partition member 132, and the other configurations are the same as the configurations of the plate-making apparatus 10c shown in Fig. 13.

The heater 130 is connected to the pipe 54a and the pipe 54b. The heater 130 adjusts the temperature of the developer Q supplied into the developing tank 32 to a determined temperature, for example, in the range of 40°C to 50°C. The configuration of the heater 130 is not particularly limited, a known configuration is usable as appropriate, and the heater 130 shown in Fig. 12 and various types of heaters described above can be used.

The heater 130 can adjust the temperature of the fatigued developer Qw processed by the processing unit 52 to a constant temperature in the range of 40°C to 50°C and supply to the front surface 70a of the flexographic printing plate precursor 70.

The plate-making apparatus 10d is provided with the partition member 132 along the frame 50, in the developing tank 32. With the partition member 132, a space 32g between a bottom surface 32c of the developing tank 32 and an end part 132a of the partition member 132 is divided into a side where the flexographic printing plate precursor 70 enters the developer Q and a side where the flexographic printing plate precursor 70 is discharged from the developer Q. That is, the developing tank 32 is configured such that the first tank portion $M_1$ and a second tank portion $M_2$ communicate with each other in the space 32g due to the partition member 132. For this reason, in the developing tank 32, solid contents floating on the liquid level of the first tank portion $M_1$, which is the side where the flexographic printing plate precursor 70 enters the developer Q, are prevented from moving to the liquid level of the second tank portion $M_2$, which is the side where the flexographic printing plate precursor 70 is discharged from the developer Q. Accordingly, the second tank portion $M_2$ can maintain a state where the amount of solid contents is relatively small compared to the first tank portion $M_1$. The developer Q can pass through the space 32g of the developing tank 32 as described above.

A material for the partition member 132 is not particularly limited, and examples thereof include a vinyl chloride resin block, a polyethylene resin block, a polypropylene resin block, and a foamed molded body.

In addition, the fatigued developer Qw processed by the processing unit 52 is supplied to the second tank portion $M_2$ by the supply nozzle 44. In this case, the developer Q stored in the developing tank 32 passes through the space 32g of the developing tank 32, and the developer Q is pressed out to a first tank portion $M_1$ side where the flexographic printing plate precursor 70 enters. Consequently, for example, the developer Q overflows. In this case, in a case where the developer Q contains solid contents, the solid contents are discharged.

Since the plate-making apparatus 10a is provided with the partition member 132, the solid contents are more unlikely to adhere to the front surface 70a of the developed flexographic printing plate precursor 70.

Although a configuration of having the heater 130 and the partition member 132 is adopted, without being limited thereto, a configuration of having any one of the heater 130 or the partition member 132 may be adopted.

(Another Example of Rinsing Unit)

The configuration of the rinsing unit is not limited to the configuration shown in Fig. 13, and for example, the rinsing unit 13 having a configuration to be described below can be used.

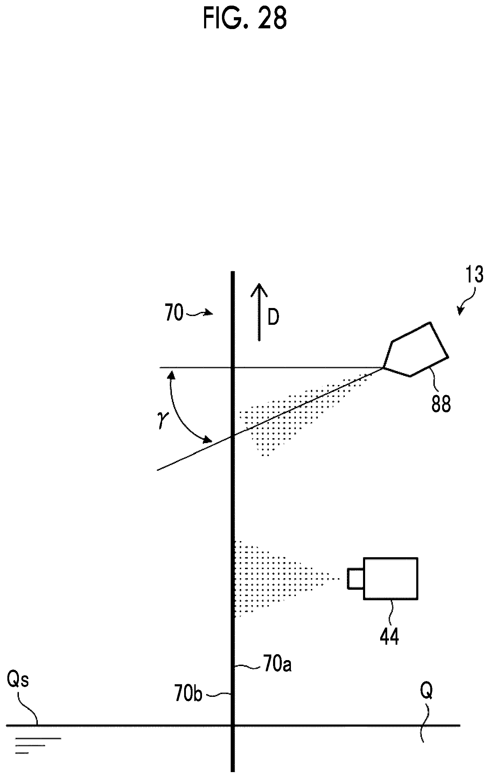

Figs. 28 to 30 are schematic views showing a first example to a third example of the rinsing unit of the third example of the plate-making apparatus according to the embodiment of the present invention. In Figs. 28 to 30, the same components as the plate-making apparatus 10c shown in Fig. 13 will be assigned with the same reference numerals, and detailed description thereof will be omitted. In Figs. 28 to 30, the showing of the processing unit 52, the pipe 54, the separation membrane 56, the rinsing liquid supply unit 40, the supply pipe 40a, and the valve 40b is partially omitted.

For example, as shown in Fig. 28, above the liquid level Qs of the developer Q, the rinsing unit 13 has the supply nozzle 44 disposed to face the front surface 70a of the flexographic printing plate precursor 70 and a liquid drain nozzle 88 provided on a downstream side from the supply nozzle 44 in the traveling direction of the flexographic printing plate precursor 70, that is, the downstream side in the transport direction D.

As described above, the supply nozzle 44 is a nozzle that is for supplying the at least developer Q to the front surface 70a of the flexographic printing plate precursor 70, from which the non-exposed portion of the flexographic printing plate precursor 70 is removed.

The liquid drain nozzle 88 removes the developer Q supplied to the flexographic printing plate precursor 70 by the supply nozzle 44 by jetting a gas or removes the washing solution by sucking a gas. Insofar as the jetting of a gas or the sucking of a gas can be performed, the configuration of the liquid drain nozzle 88 is not particularly limited, and various pumps can be used.

As shown in Fig. 28, by providing the supply nozzle 44 and the liquid drain nozzle 88, the liquid drain nozzle 88 entrains the developer Q from the supply nozzle 44, and the supply amount of the developer Q from the supply nozzle 44 spreads to the at least front surface 70a of the flexographic printing plate precursor 70. Thus, the non-exposed portion described above can be removed. Accordingly, the amount of the developer Q necessary for removing residues such as latex components and rubber components remaining on the front surface 70a of the developed flexographic printing plate precursor 70 can be decreased.

It is preferable to drive the supply nozzle 44 and the liquid drain nozzle 88 simultaneously. By driving the supply nozzle 44 and the liquid drain nozzle 88 simultaneously, the effect of entrainment of the developer Q described above is further obtained.

A nozzle angle $\gamma$ of the liquid drain nozzle 88 is preferably 0° to 85° and more preferably 0° to 45°.

In a case where a ventilation port for a gas of the liquid drain nozzle 88 is on a line (hereinafter, referred to as a reference line) of 90° with respect to the front surface 70a of the flexographic printing plate precursor 70, the nozzle angle $\gamma$ is set to 0°.

An angle formed by a line that is extended from the front surface 70a of the flexographic printing plate precursor 70 and passes through the ventilation port of the liquid drain nozzle 88 and the reference line is the nozzle angle $\gamma$.

In addition to the configured shown in Fig. 28, the rinsing unit 13 may be configured such that the supply nozzle 44 and the liquid drain nozzle 88 are provided to face the back surface 70b at symmetrical positions with the flexographic printing plate precursor 70 interposed. Accordingly, residues such as latex components and rubber components that have remained during development can be removed from both surfaces of the flexographic printing plate precursor 70.

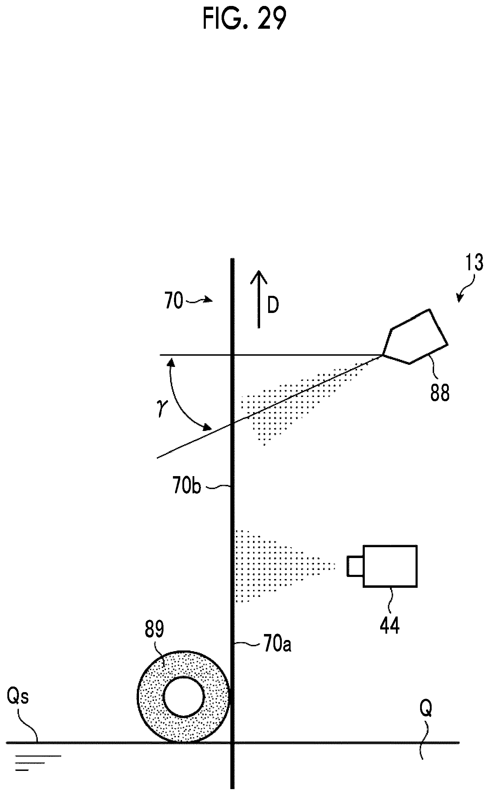

As shown in Fig. 29, the rinsing unit 13 may be configured to be provided with a brush 89 or a squeegee plate brought into contact with the back surface 70b of the flexographic printing plate precursor 70 in addition to the configuration shown in Fig. 28. For example, the brush 89 is a roller-shaped brush obtained by bundling bristles radially with respect to a shaft. Accordingly, in a case where the flexographic printing plate precursor 70 is transported, the brush 89 rotates in a state of being brought into contact with the back surface 70b, and residues such as latex components and rubber components remaining on the back surface 70b of the flexographic printing plate precursor 70 can be removed.

In addition to the configuration shown in Fig. 28, the rinsing unit 13 may have a configuration where the supply nozzle 44 and the liquid drain nozzle 88 are provided to face the back surface 70b at symmetrical positions with the flexographic printing plate precursor 70 interposed and the brush 89 is provided to be brought into contact with the back surface 70b of the flexographic printing plate precursor 70. Accordingly, in a case where the flexographic printing plate precursor 70 is transported, the brush 89 rotates in a state of being brought into contact with the back surface 70b, and residues such as latex components and rubber components remaining on the back surface 70b of the flexographic printing plate precursor 70 can be removed. Further, the residues that are not completely removed by the brush 89 can also be removed by the supply nozzle 44 and the liquid drain nozzle 88.

Although the brush 89 is disposed to be brought into contact with the liquid level Qs of the developer Q in Fig. 29, without being limited thereto, the brush 89 may be disposed in a state of being immersed in the developer Q.

(Prerinsing Unit)

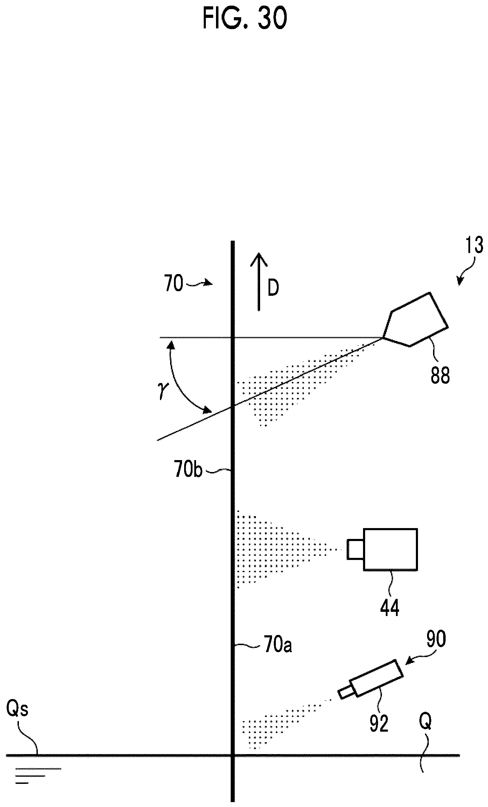

A configuration where a prerinsing unit 90 that supplies the developer Q to the developed flexographic printing plate precursor 70 is further included between the rinsing unit 13 and the developing portion 12 may be adopted. For example, the prerinsing unit 90 has a prerinsing nozzle 92. For example, as shown in Fig. 30, a configuration where the prerinsing nozzle 92 that is provided to face the front surface 70a of the flexographic printing plate precursor 70 is provided may be adopted in addition to the configuration shown in Fig. 28. The prerinsing nozzle 92 supplies the developer Q to the developed flexographic printing plate precursor 70 before the rinsing unit 13. Specifically, the prerinsing nozzle 92 sprays the developer Q in order to prevent foreign substances from adhering to the flexographic printing plate precursor 70 at the surface of the developer Q in the developing tank 32.

A step of supplying the developer Q to the developed flexographic printing plate precursor 70, between the developing step and the rinsing step is called a prerinsing step. The prerinsing step is performed using the prerinsing unit 90 described above.

It is preferable that the developer Q is supplied from the prerinsing nozzle 92 at a flow rate that disturbs the liquid level Qs of the developer Q in the developing tank 32.

In the developing tank 32, residues generated through development float on the liquid level Qs of the developer Q in the developing tank 32. In a case where the residues adhere to the front surface 70a and the back surface 70b of the flexographic printing plate precursor 70, a defect is caused. There are also residues which are too small to be removed by the supply nozzle 44, and a defect is caused in a case where the residues adhere. By providing the prerinsing nozzle 92, the small residues are prevented from adhering, and the cleanliness of the front surface 70a of the flexographic printing plate precursor 70 can be increased.

In addition, in addition to the configuration shown in Fig. 30, a configuration where the supply nozzles 44, the liquid drain nozzles 88, and the prerinsing nozzles 92 are provided at symmetrical positions with the flexographic printing plate precursor 70 interposed therebetween may be adopted. Accordingly, the small residues can be prevented from adhering to both surfaces of the flexographic printing plate precursor 70, and the cleanliness of both surfaces of the flexographic printing plate precursor 70 can be increased. The prerinsing nozzle 92 facing the back surface 70b of the flexographic printing plate precursor 70 may not be provided. The prerinsing step does not necessarily have to be performed.

As the used developer supplied from the prerinsing unit 90 flows into the developing tank 32, a total waste liquid amount can be reduced. In particular, in a case where the transport path is in the up-down direction, an effect of reducing the waste liquid amount is large. For this reason, it is preferable that the used developer flows into the developing tank 32 also in the prerinsing step.

In addition, a configuration where the brush 89 (see Fig. 29) brought into contact with the back surface 70b of the flexographic printing plate precursor 70 is provided may be adopted in addition to the configuration shown in Fig. 30. Accordingly, in a case where the flexographic printing plate precursor 70 is transported, the brush 89 rotates in a state of being brought into contact with the back surface 70b, and residues such as latex components and rubber components remaining on the back surface 70b of the flexographic printing plate precursor 70 can be removed. Further, the residues that are not completely removed by the brush 89 can also be removed by the supply nozzle 44 and the liquid drain nozzle 88.

In addition, a configuration where the brush 89 (see Fig. 29) brought into contact with the back surface 70b of the flexographic printing plate precursor 70 is provided and he supply nozzle 44 and the liquid drain nozzle 88 are provided to face the back surface 70b at symmetrical positions with the flexographic printing plate precursor 70 interposed may be adopted in addition to the configuration shown in Fig. 30. Accordingly, in a case where the flexographic printing plate precursor 70 is transported, the brush 89 rotates in a state of being brought into contact with the back surface 70b, and residues such as latex components and rubber components remaining on the back surface 70b of the flexographic printing plate precursor 70 can be removed. Further, the residues that are not completely removed by the brush 89 can also be removed by the supply nozzle 44 and the liquid drain nozzle 88.

The brush 89 described above is not limited to being disposed to be brought into contact with the liquid level Qs of the developer Q. Without being limited thereto, the brush 89 may be disposed in a state of being immersed in the developer Q.

In addition, the liquid drain nozzle 88 is inclined with respect to the transport direction D of the flexographic printing plate precursor 70, but in addition thereto, may be disposed to be inclined, for example, with respect to the direction DL (see Fig. 15). By making the liquid drain nozzle 88 inclined with respect to the direction DL, the developer Q can be collected on one side and be drained out. That is, the developer Q can be collectively removed on one side.

(Transporting Unit)

Although the transporting unit 11 described above, which adopts a winding transmission method in which the gear 60 and the transport chain 61 are used, is described as an example, the transporting unit 11 is not limited thereto. For example, the gear 60 may be changed to a pulley, and the transport chain 61 may be changed to a transport belt. The flexographic printing plate precursor is transported by using a pair of transport belts and fixing each transport belt to the leaders.

In a case of using the transport belts, the transport belts hang parallel to each other. The transport belts are also not particularly limited, and flat belts, V-belts, rib belts, round belts, and toothed belts can be used.

In addition to the above, the transporting unit 11 can use, for example, a winding method of winding a traction member provided at the leader.

In a case of the winding method described above, for example, the traction member (not shown) for transporting the flexographic printing plate precursor 70 is attached to the leader for the flexographic printing plate precursor 70, and the flexographic printing plate precursor 70 is transported along the transport path Dp described above by winding the traction member. The traction member may be a string or may be a strip-shaped member.

Hereinafter, the flexographic printing plate precursor will be described.

(Flexographic Printing Plate Precursor)

The flexographic printing plate precursor 70 forms a flexographic printing plate used in flexographic printing, and the configuration thereof is not particularly limited. The flexographic printing plate precursor 70 is as thin as several millimeters and has flexibility. Having flexibility means returning from a bent state caused by an acting force to the original state after unloading the force. The size of the flexographic printing plate precursor 70 is, for example, 800 mm × 1,200 mm, and 1,050 mm × 1,500 mm. Since development is performed by moving the brush 81 (see Fig. 13) in the plate-making apparatus 10c described above (see Fig. 13), it is also possible to respond to the large flexographic printing plate precursor 70.

It is preferable that the flexographic printing plate precursor 70 is a flexographic printing plate precursor that can be developed with an aqueous developer of which a main component is water and a flexographic printing plate precursor that is called a water-developing type flexographic printing plate precursor. In this case, the developer is the aqueous developer.

A known flexographic printing plate precursor that can be developed with the aqueous developer is usable as the flexographic printing plate precursor 70, and examples of the flexographic printing plate precursor 70 include a flexographic plate material for computer to plate (CTP) having a surface to which a black layer is applied. The black layer configures the black mask 74 shown in Fig. 4.

Hereinafter, the developer will be described.

<Developer>

The developer is preferably a water-based developer, may be a solution consisting of only water, and may be an aqueous solution which contains 50% by mass or more of water and to which a water soluble compound is added. Examples of the water soluble compound include surfactants, acids, and alkaline agents. The developer also contains chelating agents. The water-based developer described above corresponds to the aqueous developer.

Examples of the surfactant include anionic surfactants, nonionic surfactants, cationic surfactants, and amphoteric surfactants, and among the surfactants, anionic surfactants are preferable.

Specific examples of the anionic surfactant include aliphatic carboxylates such as sodium laurate and sodium oleate; higher alcohol sulfate ester salts such as sodium lauryl sulfate, sodium cetyl sulfate, and sodium oleyl sulfate; polyoxyethylene alkyl ether sulfates such as sodium polyoxyethylene lauryl ether sulfate; polyoxyethylene alkyl allyl ether sulfates such as sodium polyoxyethylene octylphenyl ether sulfate and sodium polyoxyethylene nonylphenyl ether sulfate; alkyl sulfonates such as alkyldiphenyl ether disulfonate, sodium dodecyl sulfonate, and sodium dialkyl sulfosuccinate; alkyl allyl sulfonates such as alkyl disulfonate, sodium dodecylbenzene sulfonate, sodium dibutylnaphthalene sulfonate, and sodium triisopropylnaphthalene sulfonate; higher alcohol phosphate ester salts such as lauryl phosphate monoester disodium and sodium lauryl phosphate diester; polyoxyethylene alkyl ether phosphoric acid ester salts such as polyoxyethylene lauryl ether phosphoric acid monoester disodium and polyoxyethylene lauryl ether phosphoric acid diester sodium. These may be used alone or may be used in combination of two or more types. Although a sodium salt is given as a specific example, it is not particularly limited to the sodium salt, and the same effect can be obtained with a calcium salt, an ammonia salt, or the like.

Specific examples of the nonionic surfactant include polyoxyethylene alkyl ethers such as polyoxyethylene oleyl ether and polyoxyethylene lauryl ether, polyoxyethylene polyoxypropylene glycols including polyoxyethylene alkyl phenyl ethers such as polyoxyethylene nonylphenyl ether and polyoxyethylene octylphenyl ether, mono and diesters of polyethylene glycol and fatty acids such as polyethylene glycol monostearate, polyethylene glycol monooleate, and polyethylene glycol dilaurate, fatty acids and sorbitan esters such as sorbitan monolaurate and sorbitan monooleate, esters of sorbitan polyoxyethylene adducts and fatty acids such as polyoxyethylene sorbitan monolaurate, polyoxyethylene sorbitan monostearate, and polyoxyethylene sorbitan trilaurate, esters fatty acids and sorbitol such as sorbitol monopalmitate and sorbitol dilaurate, esters of sorbitol polyoxyethylene adducts and fatty acids such as polyoxyethylene sorbitol monostearate and polyoxyethylene sorbitol diolate, esters of fatty acids and pentaerythritol such as pentaerythritol monostearate, esters of fatty acids and glycerin such as glycerin monolaurate, fatty acid alkanolamides such as lauric acid diethanolamide and lauric acid monoethanolamide, amine oxides such as lauryl dimethylamine oxide, fatty acid alkanolamines such as stearyl diethanolamine, polyoxyethylene alkylamines, triethanolamine fatty acid esters, alkaline salt compounds such as phosphates, carbonates, and silicates. These may be used alone or may be used in combination of two or more types.

Specific examples of the cationic surfactant include primary, secondary and tertiary amine salts such as monostearylammonium chloride, distearylammonium chloride, and tristearylammonium chloride, quaternary ammonium salts such as stearyltrimethylammoum chloride, distearyldimethylammonium chloride, and stearyldimethylbenzylammonium chloride, alkylpyridinium salts such as N-cetylpyridinium chloride and N-stearylpyridinium chloride, N, N dialkyl morpholinium salts, fatty acid amide salts of polyethylene polyamines, acetic acids of urea compounds of amides of aminoethylethanolamine and stearic acid, and 2-alkyl-1-hydroxyethylimidazolinium chloride. These may be used alone or may be used in combination of two or more types.

Specific examples of the amphoteric surfactant include amino acid types such as sodium laurylamine propionate, carboxybetaine types such as lauryldimethylbetaine and lauryldihydroxyethylbetaine, sulfobetaine types such as stearyldimethylsulfoethyleneammonium betaine, imidazolenium betaine types, and lecithin. These may be used alone or may be used in combination of two or more types.

Specific examples of the acid include inorganic acids or organic acids such as hydrochloric acid, sulfuric acid, nitric acid, phosphoric acid, formic acid, acetic acid, oxalic acid, succinic acid, citric acid, malic acid, maleic acid, and paratoluenesulfonic acid.

Specific examples of the alkaline agent include lithium hydroxide, sodium hydroxide, magnesium hydroxide, potassium hydroxide, calcium hydroxide, calcium oxide, sodium carbonate, sodium hydrogencarbonate, and calcium carbonate.

Specific examples of the chelating agent, that is, a metal blocking agent, include citric acid, ethylenediaminetetraacetic acid (EDTA), ethylenediamine-N, N'-disuccinic acid (EDDS), L-glutamic acid N,N-diacetic acid (GLDA), and alkali metal salt.

Hereinafter, the fatigued developer will be described in detail.

<Fatigued Developer>

The fatigued developer is not particularly limited insofar as the fatigued developer is a developer containing solid substances generated by removing the non-exposed portion of the flexographic printing plate precursor due to development using the developer described above, that is, a developer containing an uncured resin. However, a fatigued developer containing a known photosensitive resin composition of the related art for forming a general photosensitive resin layer may be included.

The uncured resin removed through development may be a photosensitive resin contained in the photosensitive resin composition.

In addition, since it is preferable to set a fatigued developer in a case of developing under a laser ablation masking (LAM) method as a processing target, it is preferable that the uncured resin removed through development is the photosensitive resin contained in the photosensitive resin composition.

In addition, since examples of such a photosensitive resin composition include a composition containing a polymerization initiator, a polymerizable compound, a polymerization inhibitor, and a plasticizer, in addition to the photosensitive resin, the fatigued developer may contain a polymerization initiator, a polymerizable compound, a polymerization inhibitor, a plasticizer, and the like, in addition to the uncured resin.

<Uncured Resin>

The uncured resin contained in the fatigued developer is solid substances generated by removing the non-exposed portion of the flexographic printing plate precursor. The solid substances are sensitizer components dispersed in the developer described above.

Examples of the uncured resin contained in the fatigued developer include water-dispersible latex, rubber components, polymer components, and uncrosslinked ethylenically unsaturated compounds (polymers).

Examples of the water-dispersible latex include water-dispersed latex polymers including water-dispersed latex such as polybutadiene latex, natural rubber latex, styrene-butadiene copolymer latex, acrylonitrile-butadiene copolymer latex, polychloroprene latex, polyisoprene latex, polyurethane latex, methyl methacrylate-butadiene copolymer latex, vinyl pyridine copolymer latex, butyl polymer latex, thiocol polymer latex, and acrylate polymer latex and polymers obtained by copolymerizing these polymers with other components such as acrylic acid or methacrylic acid.

Examples of the rubber component include butadiene rubber, isoprene rubber, styrene-butadiene rubber, acrylonitrile rubber, acrylonitrile butadiene rubber, chloroprene rubber, polyurethane rubber, silicon rubber, butyl rubber, ethylene-propylene rubber, and epichlorohydrin rubber.

The polymer component may be hydrophilic or may be hydrophobic, and specific examples thereof include a polyamide resin, an unsaturated polyester resin, an acrylic resin, a polyurethane resin, a polyester resin, and polyvinyl alcohol resin.

The solid substances having a specific gravity lower than the developer are, for example, photosensitive resins such as rubber components and latex.

The solid substances having a specific gravity higher than the developer are, for example, components of overcoat layers such as carbon.

Examples of the ethylenically unsaturated compound (polymer) include (meth) acrylic modified polymers having an ethylenically unsaturated bond in the molecule.

Examples of the (meth) acrylic modified polymer include (meth) acrylic modified butadiene rubber and (meth) acrylic modified nitrile rubber.

"(Meth) acrylic" is a notation representing acrylic or methacrylic, and "(meth) acrylate" to be described later is a notation representing acrylate or methacrylate.

The uncured resin contained in the fatigued developer is not particularly limited, but is preferably 70% by mass or less, and more preferably 35% by mass or less.

<Polymerization Initiator>

The polymerization initiator that may be contained in the fatigued developer is preferably a photopolymerization initiator.

Examples of the photopolymerization initiator described above include alkylphenones, acetophenones, benzoin ethers, benzophenones, thioxanthones, anthraquinones, benzyls, and biacetyls, and among them, alkylphenones are preferable.

Specific examples of the alkylphenones photopolymerization initiators include 2,2-dimethoxy-1,2-diphenylethane-1-on, 1-hydroxy-cyclohexyl-phenyl-ketone, and 2-hydroxy-2-methyl-1-phenyl-propane-1-on.

The concentration of the polymerization initiator that may be contained in the fatigued developer is not particularly limited, but is preferably 2.0% by mass or less, and more preferably 1.0% by mass or less.

<Polymerizable Compound>

Examples of the polymerizable compound that may be contained in the fatigued developer include ethylenically unsaturated compounds that correspond to so-called monomer components other than the ethylenically unsaturated compounds (polymers) described above.

The ethylenically unsaturated compound may be a compound having one ethylenically unsaturated bond or may be a compound having two or more ethylenically unsaturated bonds.

Specific examples of the compound having one ethylenically unsaturated bond include (meth) acrylate having a hydroxyl group such as 2-hydroxyethyl (meth) acrylate, 2-hydroxypropyl (meth) acrylate, 2-hydroxybutyl (meth) acrylate, 3-chloro-2-hydroxypropyl (meth) acrylate, and β-hydroxy-β'-(meth) acryloyloxyethyl phthalate; alkyl (meth) acrylates such as methyl (meth) acrylate, ethyl (meth) acrylate, propyl (meth) acrylate, butyl (meth) acrylate, isoamyl (meth) acrylate, 2-ethylhexyl (meth) acrylate, lauryl (meth) acrylate, and stearyl (meth) acrylate; cycloalkyl (meth) acrylates such as cyclohexyl (meth) acrylate; alkyl halogenated (meth) acrylates such as chloroethyl (meth) acrylate and chloropropyl (meth) acrylate; alkoxyalkyl (meth) acrylates such as methoxyethyl (meth) acrylate, ethoxyethyl (meth) acrylate, and butoxyethyl (meth) acrylate; phenoxyalkyl (meth) acrylates such as phenoxyethyl acrylate and nonylphenoxyethyl (meth) acrylate; alkoxyalkylene glycol (meth) acrylates such as ethoxydiethylene glycol (meth) acrylate, methoxytriethylene glycol (meth) acrylate, and methoxydipropylene glycol (meth) acrylate; 2,2-dimethylaminoethyl (meth) acrylate, 2,2-diethylaminoethyl (meth) acrylate, 2-hydroxyethyl (meth) acrylate, and 3-chloro-2-hydroxypropyl (meth) acrylate.

Specific examples of the ethylenically unsaturated compound having two or more ethylenically unsaturated bonds include alkyldiol di (meth) acrylates such as 1,9-nonane diol di (meth) acrylate; polyethylene glycol di (meth) acrylates such as diethylene glycol di (meth) acrylate; polypropylene glycol di (meth) acrylates such as dipropylene glycol di (meth) acrylate; polyvalent (meth) acrylates obtained by addition reaction of a compound having an ethylenically unsaturated bond, such as unsaturated carboxylic acid and unsaturated alcohol, and active hydrogen with trimethylolpropane tri (meth) acrylate, pentaerythritol tri (meth) acrylate, pentaerythritol tetra (meth) acrylate, glycerol tri (meth) acrylate, and ethylene glycol diglycidyl ether; polyvalent (meth) acrylates obtained by addition reaction of an unsaturated epoxy compound such as glycidyl (meth) acrylate with a compound having active hydrogen such as carboxylic acid and amine; polyvalent (meth) acrylamides such as methylenebis (meth) acrylamide; polyvalent vinyl compounds such as divinylbenzene.

The concentration of the polymerizable compound that may be contained in the fatigued developer is not particularly limited, but is preferably 30.0% by mass or less, and more preferably 15.0% by mass or less.

<Polymerization Inhibitor>

Specific examples of the polymerization inhibitor that may be contained in the fatigued developer include hydroquinone monomethyl ether, p-methoxyphenol, di-t-butyl-p-cresol, pyrogallol, t-butylcatechol, benzoquinone, 4,4'-thiobis (3-methyl-6-t-butylphenol), 2,2'-methylenebis (4-methyl-6-t-butylphenol), and N-nitrosophenylhydroxyamine first cerium salt.

The concentration of the polymerization inhibitor that may be contained in the fatigued developer is not particularly limited, but is preferably 0.3% by mass or less, and more preferably 0.15% by mass or less.

<Plasticizer>

Examples of the plasticizer that may be contained in the fatigued developer include liquid rubber, oil, polyester, and phosphoric acid-based compounds.

Specific examples of the liquid rubber include liquid polybutadiene, liquid polyisoprene, and those modified with maleic acid or an epoxy group.

Specific examples of the oil include paraffin oil, naphthenic oil, and aroma oil.

Specific examples of the polyester include adipic acid-based polyester.

Specific examples of the phosphoric acid-based compound include phosphoric acid ester.

The concentration of the plasticizer that may be contained in the fatigued developer is not particularly limited, but is preferably 30% by mass or less, and more preferably 15% by mass or less.

<Development Replenishing Liquid>

A development replenishing liquid adjusts the conductivity of a developer. The development replenishing liquid keeps the conductivity of the developer in the determined range Rc (see Fig. 2). That is, the concentration of the developer is kept in the management concentration range δc (see Fig. 2), for example, the concentration of a surfactant such as a detergent of a developer is kept constant.

The development replenishing liquid may have the same concentration of a surfactant such as the detergent as the developer described above, but the concentration is preferably high. The development replenishing liquid can decrease the amount of the development replenishing liquid in a case of adjusting the concentration of the developer by making the concentration of the surfactant such as the detergent higher than the concentration of the developer. In addition, by adding water, the concentration can be adjusted, and the conductivity can be easily brought close to a control target value.

In a case where the concentration of the surfactant in the developer has decreased, the development speed decreases. Thus, it is preferable to adjust the concentration of the development replenishing liquid such that the concentration of the surfactant such as the detergent in the development replenishing liquid is equal to the concentration of the surfactant such as the detergent of the developer in a case of being mixed with the developer.

The development replenishing liquid preferably contains alkaline agents. As the development replenishing liquid contains the alkaline agents, an effect of improving the development speed and an effect of assisting solid substance (residue) dispersion are obtained.

The alkaline agents are alkaline agents contained in the developer described above as water soluble compounds. The alkaline agent is, for example, inorganic salt, and specific examples thereof include lithium hydroxide, sodium hydroxide, magnesium hydroxide, potassium hydroxide, calcium hydroxide, calcium oxide, sodium carbonate, sodium hydrogencarbonate, calcium carbonate, potassium carbonate, potassium bicarbonate, lithium carbonate, and cesium carbonate.

For example, a new developer solution, a developer concentrated stock solution, or a regenerated developer is used as the development replenishing liquid.

The new developer solution is a developer that has been never used for development.

The developer concentrated stock solution has the concentration of the surfactant such as the detergent higher than the concentration of the developer.

The regenerated developer is a reused developer by removing the solid contents or the like of a developer after development, that is, the fatigued developer. The regenerated developer is the processed fatigued developer Qw described above. The regenerated developer is obtained, for example, by passing the fatigued developer through a filter.

The present invention is basically configured as described above. Although the developer management method, the plate-making method, the developer management device, and the plate-making apparatus according to the embodiment of the present invention have been described in detail hereinbefore, the present invention is not limited to the embodiment described above, and it is evident that various improvements or changes may be made without departing from the gist of the present invention.

Examples

Hereinafter, characteristics of the present invention will be described in further detail with reference to examples. Materials, reagents, substance amounts, operations, and the like shown in the examples below can be changed as appropriate without departing from the gist of the present invention. Therefore, the scope of the present invention is not limited to the following examples.

In the present example, Examples 1 and 2 and Comparative Examples 1 to 4 were evaluated in terms of on-plate residues, a floor area thickness, and a bus life.

Devices and chemicals used in Examples 1 and 2 and Comparative Examples 1 to 4 are as follows.

<Imaging Machine>

· CDI Spark 4835 Inline (manufactured by ESKO)

<Exposure Machine>

· Ultraviolet rays exposure machine Concept 302 ECDLF (product name) (manufactured by Glunz & Jensen)

<Flexographic Printing Plate Precursor>

· FLENEX FW-L2 (670 mm × 560 mm size plate, manufactured by Fujifilm Global Graphic Systems)

<Developer>

· Finish NF (manufactured by Lekit Benquiser, concentration of 0.50 wt%)

<Imagewise Exposure of Flexographic Printing Plate Precursor>

Back exposure was performed by exposing the flexographic printing plate precursor described above from the back surface of the flexographic printing plate precursor with energy of 80 W for 10 seconds using the ultraviolet rays exposure machine described above.

After then, main exposure was performed by capturing an image of 50% of the entire flat net surface of a flat net through a method of ablating a mask layer using an imaging machine described above and exposing from a front surface (a back surface of the back surface) with 80 W for 1,000 seconds. The flexographic printing plate precursor on which main exposure was performed was used as the imagewise exposed flexographic printing plate precursor.

Hereinafter, on-plate residues, a floor area thickness, and a bus life will be described.

[On-plate Residues]

The flexographic printing plate precursor after development treatment was dried and postexposed.

After the drying and the postexposure described above, removal was performed on the flexographic printing plate precursor using tape, and all those which could not be removed from the image area were defined as on-plate residues.

The presence or absence of residues that had a size of 100 $\mu$m or more and could not be removed using tape was checked.

As a result of a visual plate surface test of the processed flexographic printing plate precursor, a plate having no residues that had a size of 100 $\mu$m or more and could not be removed using tape was evaluated as "A", and a plate having even one was evaluated as "C".

On-plate residues were an indicator of a sensitizer concentration, and the fact that the on-plate residues were not generated indicated that the sensitizer concentration was not high.

In Example 1, the flexographic printing plate precursor was evaluated in terms of on-plate residues after being subjected to 1-plate processing, after being subjected to 10-plate processing, after being subjected to 100-plate processing, and after being subjected to 220-plate processing.

In Example 2, the flexographic printing plate precursor was evaluated after being subjected to 1-plate processing, after being subjected to 21-plate processing, after being subjected to 143-plate processing, and after being subjected to 460-plate processing.

In Comparative Example 1, the flexographic printing plate precursor was evaluated after being subjected to 1-plate processing, after being subjected to 10-plate processing, after being subjected to 23-plate processing, and after being subjected to 24-plate processing.

In Comparative Example 2, the flexographic printing plate precursor was evaluated after being subjected to 1-plate processing, after being subjected to 24-plate processing, after being subjected to 52-plate processing, and after being subjected to 120-plate processing.

In Comparative Example 3, the flexographic printing plate precursor was evaluated after being subjected to 1-plate processing, after being subjected to 20-plate processing, after being subjected to 45-plate processing, and after being subjected to 46-plate processing.

In Comparative Example 4, the flexographic printing plate precursor was evaluated after being subjected to 1-plate processing, after being subjected to 50-plate processing, after being subjected to 105-plate processing, and after being subjected to 241-plate processing.

[Floor Area Thickness]

The flexographic printing plate precursor after development treatment was dried and postexposed.

An average value of measurement values obtained by measuring eight points corresponding to a floor area thickness of the flexographic printing plate precursor was used.

The average value of the eight points described above which was within a standard value of 1,050 $\mu$m to 1,150 $\mu$m was evaluated as "A", and the average value which was out of the standard value of 1,050 $\mu$m to 1,150 $\mu$m was evaluated as "C".

The floor area thickness was an indicator of the development speed and indicated that development was performed at an appropriate development speed in a case where the floor area thickness was within the standard value.

A floor area thickness and an image area height were measured using Dial Thickness Gauge/7321 manufactured by Mitutoyo Corporation.

[Bus Life]

A value obtained by dividing a processing amount before one plate in which evaluation of any one of on-plate residues or a floor area thickness was "C" by a tank capacity was defined as a bus life. An increase in the numerical value of the bus life means that the replacement frequency of the developer was low.

Hereinafter, Examples 1 and 2 and Comparative Examples 1 to 4 will be described.

(Example 1)

In Example 1, development and rinsing were performed on the imagewise exposed flexographic printing plate precursor using a clamshell type developing machine (C-Touch 2530 Water Wash Plate Processor (manufactured by GS Trading)).

The tank capacity of the developing machine was 100 liters, the developer amount was 500 g/m$^2$, and the rinse amount was 5 liters/plate.

In Example 1, the conductivity of the developer was measured after being subjected to 1-plate processing, after being subjected to 10-plate processing, after being subjected to 100-plate processing, and after being subjected to 220-plate processing. The concentration of the developer and the sensitizer concentration were calculated using the obtained conductivity and the following equation.

$$\text{Concentration of developer (\%)} = 0.1128 \times \text{conductivity} - 0.1132$$

In a case where 5 cc was sampled from a development tank and water was evaporated in an oven at a temperature of 95°C, the concentration of solid contents was measured from a weight change before and after drying.

The sensitizer concentration was calculated by subtracting the concentration of the developer calculated from the conductivity from the concentration of solid contents.

$$\text{Sensitizer concentration} = \text{concentration of solid contents} - \text{developer concentration}$$

A center value of the conductivity was 5.4 mS/cm, a lower limit value was 4.0 mS/cm, and an upper limit value was 7.3 mS/cm. In a case where the conductivity fell short of the lower limit value, the development replenishing liquid was added such that the conductivity became 5.4 mS/cm. In a case where the conductivity exceeded the upper limit value, water was added such that the conductivity became 5.4 mS/cm.

The conductivity was measured using "portable multi-water quality meter MM-41DP" manufactured by DKK-TOA Corporation.

(Example 2)

Example 2 was different from Example 1 in that the transporting type plate-making apparatus shown in Fig. 13 was used, and other points were the same as in Example 1.

In the transporting type plate-making apparatus described above, the tank capacity of the developing machine was 680 liters, the developer amount was 500 g/m$^2$, and the rinse amount was 20.3 liters/plate.

(Comparative Example 1)

Comparative Example 1 was different from Example 1 in that no control was performed, and other points were the same as in Example 1.

(Comparative Example 2)

Comparative Example 2 was different from Example 1 in that pH was controlled instead of the conductivity, and other points were the same as in Example 1.

The measurement of pH was performed using "portable pH meter manufactured by DKK-TOA Corporation HM-30P".

In Comparative Example 2, the pH of the developer was measured after being subjected to 1-plate processing, after being subjected to 24-plate processing, after being subjected to 52-plate processing, and after being subjected to 120-plate processing.

The pH was controlled as follows such that the pH became in a range of 10.1 to 10.5. In a case where the pH was less than 10.1, control was performed such that the developer was added and the pH became in a range of 10.1 to 10.5 as the development replenishing liquid. On the other hand, in a case where the pH exceeded 10.5, control was performed such that water was added and the pH became in the range of 10.1 to 10.5.

(Comparative Example 3)

Comparative Example 3 was different from Comparative Example 1 in that the transporting type plate-making apparatus shown in Fig. 13 was used, and other points were the same as in Comparative Example 1.

(Comparative Example 4)

Comparative Example 4 was different from Comparative Example 2 in that the transporting type plate-making apparatus shown in Fig. 13 was used, and other points were the same as in Comparative Example 2.

[Table 1]

| | Replenishing method | | Processing amount (plate number) | Developer concentration (% by mass) | Sensitizer concentration (% by mass) | Evaluation | | Bus life |
| | | | | | | On-plate residues | Floor area thickness | |
|---|---|---|---|---|---|---|---|---|
| Example 1 | Conductivity | | 1 | 0.50 | 0.2 | A | A | 1.11 m²/L or more |
| | | | 10 | 0.50 | 1.4 | A | A | |
| | | | 100 | 0.50 | 3.8 | A | A | |
| | | | 220 | 0.50 | 3.9 | A | A | |
| Comparative Example 1 | - | | 1 | 0.50 | 0.24 | A | A | 0.11 m²/L |
| | | | 10 | 0.44 | 2.27 | A | A | |
| | | | 23 | 0.39 | 4.84 | A | A | |
| | | | 24 | 0.38 | 5.02 | C | A | |
| Comparative Example 2 | pH | 10.1 | 1 | 0.50 | 0.23 | A | A | 0.58 m²/L |
| | | 10.34 | 24 | 0.54 | 2.7 | A | A | |
| | | 10.39 | 52 | 0.59 | 3.3 | A | A | |
| | | 10.2 | 120 | 0.72 | 3.4 | A | C | |
| Example 2 | Conductivity | | 1 | 0.50 | 0.12 | A | A | 1.11 m²/L or more |
| | | | 21 | 0.50 | 1.9 | A | A | |
| | | | 143 | 0.50 | 3.9 | A | A | |
| | | | 460 | 0.50 | 4.0 | A | A | |
| Comparative Example 3 | - | | 1 | 0.50 | 0.24 | A | A | 0.11 m²/L |
| | | | 20 | 0.47 | 2.27 | A | A | |
| | | | 45 | 0.42 | 4.84 | A | A | |
| | | | 46 | 0.42 | 5.02 | C | A | |
| Comparative Example 4 | pH | 10.1 | 1 | 0.50 | 0.12 | A | A | 0.58 m²/L |
| | | 10.34 | 50 | 0.54 | 2.7 | A | A | |
| | | 10.39 | 105 | 0.59 | 3.3 | A | A | |
| | | 10.2 | 241 | 0.72 | 3.4 | A | C | |

As shown in Table 1, Example 1 was superior to Comparative Examples 1 and 2 in terms of the evaluation of on-plate residues, a floor area thickness, and a bus life, development residues could be prevented from being adhered, and the replacement frequency of the developer could be decreased.

Example 2 was superior to Comparative Examples 3 and 4 in terms of the evaluation of on-plate residues, a floor area thickness, and a bus life, development residues could be prevented from being adhered, and the replacement frequency of the developer could be decreased.

In Comparative Examples 1 and 3, no control was performed, on-plate residues were generated, the evaluation of the bus life was poor, the sensitizer concentration of the developer was high, and the replacement frequency of the developer was high.

In Comparative Examples 2 and 4, the pH was controlled, but the floor area thickness was out of specifications, the evaluation of the bus life was poor, the development speed was not appropriate, and the replacement frequency of the developer was high.

As described above, in Comparative Examples 1 to 4, development residues could be prevented from being adhered, appropriate development was performed, and the replacement frequency of developer could not be decreased.

Explanation of References

10, 10a, 10b, 10c, 10d: plate-making apparatus
11: transporting unit
12: developing portion
13: rinsing unit
14: measuring unit
15: calculation unit
16: supply unit
17: connecting pipe
18: management device
19: supply pipe
20: waste liquid tank
21: switching valve
22: pump
23: filter
24, 25: pipe
26: control unit
27: driving unit
32: developing tank
32b: back surface
33: lid
33b: back surface
34, 81, 89: brush
34a, 81a: substrate
34b, 81b: bristle
34c: fixing unit
35: heater
36: motor
37a: drain hole
37b: water supply hole
37c: overflow hole
38: crank
39: fixing member
40: rinsing liquid supply unit
40a: supply pipe
40b: valve
41: rinse nozzle
44: supply nozzle
50: frame
50a: member

50b: beam member
50c: space
51: connecting pipe
52: processing unit
53: saucer
54: pipe
55: solid substance
56: separation membrane
60: gear
60a: shaft
61: transport chain
61b: fixing unit
62: transport driving unit
63: tension adjusting unit
64a, 64b: turn bar
65: back plate portion
65c: opening portion
66: nip roller 66
67: leading end leader
67a, 67e, 68a: base
67b, 68b: bending portion
67c, 68c: attaching portion
67d, 68d: pin
68: trailing end leader
69: leader mechanism portion
69a: frame material
69b: elastic member
70: flexographic printing plate precursor
70a, 72d: front surface
70b, 72c: back surface
70c: leading end
70d: trailing end
71: support plate
72: hardened portion
72a: image area
72b: image area
72e: non-image area
72f: excessively removed portion
72g: front surface
73: unhardened portion
73a: part
74: black mask
80: developing unit
85: rotation shaft portion
88: liquid drain nozzle
90: prerinsing unit
92: prerinsing nozzle
100: feeding device
100a: drive roller
100b: driven roller
100c: conveyor belt
101: guide
101a, 101b: guide plate
102, 103: sensor
104: attachment and detachment unit
105: plate attachment portion
106: plate attachment portion
110, 114: driving unit

112: pushing portion
113: concave portion
115: extrusion portion
120: development replenishing liquid storage tank
121, 123: valve
122: water storage tank
130: heater
132: partition member
132a: end part
140: pipe
140a: linear part
140b: bending part
142: block
143: heating heater
C: rotation axis
D: transport direction
$D_1$: first moving direction
$D_2$: second moving direction
DL: direction
Dp: transport path
Dpc: transport passage
Dps: transport passage
$E_m$: attachment and detachment station
hd: image area height
hf: floor area thickness
Q: developer
QL: rinsing liquid
Qs: liquid level
Qw: fatigued developer
Rc: range
r: rotation direction
$\gamma$: nozzle angle
$\delta c$: management concentration range

**Claims**

1. A developer management method comprising:

   a measuring step of measuring a conductivity of a developer used in removing a non-exposed portion of an imagewise exposed flexographic printing plate precursor; and
   a replenishing step of replenishing at least one liquid of a development replenishing liquid or water to the developer based on the conductivity measured in the measuring step such that the conductivity becomes a conductivity in a determined range.

2. The developer management method according to claim 1, further comprising:
   a calculating step of calculating a replenishment amount of the at least one liquid to be replenished to the developer in the replenishing step.

3. The developer management method according to claim 1 or 2,
   wherein the development replenishing liquid is a new developer solution, a developer concentrated stock solution, or a regenerated developer.

4. The developer management method according to any one of claims 1 to 3,
   wherein the developer and the development replenishing liquid contain an alkaline agent.

5. A plate-making method comprising:

a developing step of removing and developing a non-exposed portion of an imagewise exposed flexographic printing plate precursor using a developer;
a step of measuring a conductivity of the developer used in removing the non-exposed portion of the imagewise exposed flexographic printing plate precursor; and
a replenishing step of replenishing at least one liquid of a development replenishing liquid or water to the developer based on the conductivity measured in the measuring step such that the conductivity becomes a conductivity in a determined range.

6. The plate-making method according to claim 5, further comprising:
a calculating step of calculating a replenishment amount of the at least one liquid to be replenished to the developer in the replenishing step.

7. The plate-making method according to claim 5 or 6,
wherein the development replenishing liquid is a new developer solution, a developer concentrated stock solution, or a regenerated developer.

8. The plate-making method according to any one of claims 5 to 7,
wherein the developer and the development replenishing liquid contain an alkaline agent.

9. A developer management device comprising:

a measuring unit that measures a conductivity of a developer used in removing a non-exposed portion of an imagewise exposed flexographic printing plate precursor;
a calculation unit that calculates, from the conductivity of the developer measured by the measuring unit, a replenishment amount of at least one liquid of a development replenishing liquid or water such that the conductivity of the developer becomes a conductivity in a determined range; and
a supply unit that supplies at least one liquid of the development replenishing liquid or the water to the developer such that the conductivity of the developer becomes a conductivity in the determined range.

10. The developer management device according to claim 9,

wherein the supply unit has at least one of a development replenishing liquid storage tank that stores the development replenishing liquid or a water storage tank that stores the water, and
the supply unit supplies the liquid from at least one of the development replenishing liquid storage tank or the water storage tank to the developer.

11. The developer management device according to claim 9 or 10,
wherein the development replenishing liquid is a new developer solution, a developer concentrated stock solution, or a regenerated developer.

12. The developer management device according to any one of claims 9 to 11,
wherein the developer and the development replenishing liquid contain an alkaline agent.

13. A plate-making apparatus that develops an imagewise exposed flexographic printing plate precursor using a developer, the plate-making apparatus comprising:

a developing portion that removes and develops a non-exposed portion of the imagewise exposed flexographic printing plate precursor using the developer;
a measuring unit that measures a conductivity of the developer used in removing the non-exposed portion of the imagewise exposed flexographic printing plate precursor;
a calculation unit that calculates, from the conductivity of the developer measured by the measuring unit, a replenishment amount of at least one liquid of a development replenishing liquid or water such that the conductivity of the developer becomes a conductivity in a determined range; and
a supply unit that supplies at least one liquid of the development replenishing liquid or the water such that the conductivity of the developer becomes a conductivity in the determined range.

14. The plate-making apparatus according to claim 13,

wherein the supply unit has at least one of a development replenishing liquid storage tank that stores the development replenishing liquid or a water storage tank that stores the water, and

the supply unit supplies the liquid from at least one of the development replenishing liquid storage tank or the water storage tank to the developer.

15. The plate-making apparatus according to claim 13 or 14,
wherein the development replenishing liquid is a new developer solution, a developer concentrated stock solution, or a regenerated developer.

16. The plate-making apparatus according to any one of claims 13 to 15,
wherein the developer and the development replenishing liquid contain an alkaline agent.

## FIG. 1

# FIG. 2

# FIG. 3

```
              ( START )
                  │
                  ▼ ◄──────────────────────────┐
    ┌──────────────────────────────────┐       │
    │ MEASURE CONDUCTIVITY OF DEVELOPER │ ─S10  │
    └──────────────────────────────────┘       │
                  │                             │
                  ▼                             │
    ┌──────────────────────────────────┐       │
    │      CALCULATE CONDUCTIVITY       │ ─S12  │
    └──────────────────────────────────┘       │
                  │           S14               │
                  ▼                             │
              ╱────────╲                        │
            ╱            ╲   DOES NOT EXCEED     │
          ╱   VALUE        ╲ ───────────────────┘
          ╲ OF CONDUCTIVITY ╱
            ╲            ╱
              ╲────────╱
                  │
               EXCEED
                  ▼
    ┌──────────────────────────────────┐
    │   DETERMINE REPLENISHMENT AMOUNT  │ ─S16
    └──────────────────────────────────┘
                  │
                  ▼
    ┌──────────────────────────────────┐
    │        SUPPLY TO DEVELOPER        │ ─S18
    └──────────────────────────────────┘
                  │
                  ▼
               ( END )
```

## FIG. 4

## FIG. 5

FIG. 6

FIG. 7

# FIG. 8

EP 4 206 821 A1

FIG. 9

10a

13 RINSING LIQUID SUPPLY UNIT 40

18
16 SUPPLY UNIT 19
14 MEASURING UNIT
15 CALCULATION UNIT
17

32  32b
33b 38 71
33
36 MOTOR
39
38
70 70a Qs Q
34c 35 HEATER 12
34 34a 34b
24 WASTE LIQUID TANK 20
37c 34c 37b 37a 25 25 25
22 P 23

FIG. 10

EP 4 206 821 A1

# FIG. 11

EP 4 206 821 A1

# FIG. 12

# FIG. 13

# FIG. 14

# FIG. 15

EP 4 206 821 A1

## FIG. 16

## FIG. 17

## FIG. 18

## FIG. 19

## FIG. 20

## FIG. 21

## FIG. 22

## FIG. 23

## FIG. 24

## FIG. 25

# FIG. 26

# FIG. 27

# FIG. 28

# FIG. 29

# FIG. 30

## INTERNATIONAL SEARCH REPORT

| International application No. |
| --- |
| **PCT/JP2021/026000** |

| A. | CLASSIFICATION OF SUBJECT MATTER |
| --- | --- |

*G03F 7/00*(2006.01)i; *G03F 7/30*(2006.01)i
FI:    G03F7/30; G03F7/00 502; G03F7/30 501

According to International Patent Classification (IPC) or to both national classification and IPC

| B. | FIELDS SEARCHED |
| --- | --- |

Minimum documentation searched (classification system followed by classification symbols)

G03F7/00; G03F7/30

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2009-086338 A (FUJIFILM CORP.) 23 April 2009 (2009-04-23) paragraphs [0207], [0240] | 1-16 |
| A | JP 2003-066601 A (FUJI PHOTO FILM CO., LTD.) 05 March 2003 (2003-03-05) entire text | 1-16 |
| A | JP 2011-128455 A (NAGASE & CO., LTD.) 30 June 2011 (2011-06-30) entire text, all drawings | 1-16 |
| A | JP 2006-133560 A (TOPPAN PRINTING CO., LTD.) 25 May 2006 (2006-05-25) entire text, all drawings | 1-16 |
| A | JP 61-061164 A (KONICA CORP.) 28 March 1986 (1986-03-28) entire text, all drawings | 1-16 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 September 2021** | **28 September 2021** |

| Name and mailing address of the ISA/JP | Authorized officer |
| --- | --- |
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (January 2015)

**INTERNATIONAL SEARCH REPORT**
Information on patent family members

International application No.

**PCT/JP2021/026000**

| Patent document cited in search report | | | Publication date (day/month/year) | Patent family member(s) | | | Publication date (day/month/year) |
|---|---|---|---|---|---|---|---|
| JP | 2009-086338 | A | 23 April 2009 | (Family: none) | | | |
| JP | 2003-066601 | A | 05 March 2003 | US | 2003/0190554 | A1 | |
| | | | | entire text | | | |
| | | | | EP | 1288720 | A1 | |
| | | | | AT | 544095 | T | |
| JP | 2011-128455 | A | 30 June 2011 | (Family: none) | | | |
| JP | 2006-133560 | A | 25 May 2006 | (Family: none) | | | |
| JP | 61-061164 | A | 28 March 1986 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019537063 A

- WO 2020158380 A